# EUROPEAN PATENT APPLICATION

(11) **EP 4 851 647 A1**
(43) Date of publication of application: **09.12.2026**
(21) Application number: 25748674.6
(22) Date of filing: 29.01.2025
(51) Int. Cl.: G01R 31/387, G01R 31/367, G01R 31/3828, G01R 31/392, H01M 10/48, H02J 7/00

(54) **DEVICE, SYSTEM, METHOD, AND PROGRAM FOR PREDICTING EVALUATION RESULT, ETC. OF STORAGE BATTERY**

(30) Priority: 31.01.2024 JP 2024013251; 31.01.2024 JP 2024013517; 03.10.2024 JP 2024174436
(71) Applicant: ASAHI KASEI KABUSHIKI KAISHA, Tokyo 100-0006 (JP)
(72) Inventor: NAKAMURA, Fumiya, Tokyo 100-0006 (JP); MAKINO, Takashi, Tokyo 100-0006 (JP); KURAHASHI, Wataru, Tokyo 100-0006 (JP); TAKADA, Kazuaki, Tokyo 100-0006 (JP); MURATA, Naohiro, Tokyo 100-0006 (JP)
(74) Representative: dompatent
(86) International application number: PCT/JP2025/002807
(87) International publication number: WO 2025/164671

(57) **Abstract**

The evaluation result prediction device, system, method, and program according to the present disclosure are configured to: extract a plurality of explanatory variables from data items pertaining to a lifespan evaluation test, which are test condition data items and charge/discharge data items, or from charge/discharge data items including an energy density and a power density; input the plurality of explanatory variables to a trained model; and thereby be able to predict a prediction evaluation result measured by a predetermined lifespan evaluation test or an energy density and a power density measured by a predetermined charge/discharge protocol. An operable factor prediction device, system, method, and program according to the present disclosure calculate a plurality of deterioration levels corresponding to lifespan determination events and a plurality of deterioration events of a storage battery from the prediction evaluation result, and thereby can predict, as operable factors, one or a plurality of operable factor candidates having a causal relationship with the lifespan determination events, from an association model that associates in advance the lifespan determination events and the plurality of deterioration events with the plurality of operable factor candidates to identify causal relationships therebetween.

## Description

### TECHNICAL FIELD

The present disclosure relates to a device, a system, a method, and a program for predicting an evaluation result of a storage battery, and a method, a device, a system, and a program for predicting a manipulable factor that influences life of the storage battery.

### BACKGROUND ART

In recent years, development of storage batteries typified by lithium-ion secondary batteries has been actively performed. Storage batteries are widely used in storage systems in a vehicle field, a communication field, an industrial field, a renewable energy field, an electrical/electronic appliance field, and the like. Performance of storage batteries is evaluated by various business units that develop and/or use storage batteries, for example, material makers of storage batteries, storage battery makers, primary users (such as product makers) of storage batteries, secondary users (such as product users), recycling entities, and the like in various scenes according to a development stage and a product life cycle.

While a development speed of storage batteries has been accelerated these days, it is rational for developers/users of storage batteries to outsource performance evaluation and analysis of storage batteries to a battery evaluation entrusted entity without possessing assets such as evaluation facilities in his/her own company. The battery evaluation entrusted entity (hereinafter also simply referred to as an "entity") is required to perform performance evaluation and analysis of storage batteries entrusted from each business unit (hereinafter also simply referred to as a "customer"), and quickly feed accurate information back.

Some performance evaluation tests of storage batteries end in a short period of time, and some performance evaluation tests of storage batteries, such as a life evaluation test, require a considerable period since the storage batteries need to be stored for a fixed period on a predetermined condition or a charge-discharge cycle on a predetermined condition needs to be repeated. For example, in a storage test of a storage battery defined by IEC62660-1 (performance test) standardized by the International Electrotechnical Commission (IEC), measurement of a voltage retention rate after the storage battery is stored for 28 days at 45°C and measurement of a capacity maintenance rate after the storage battery is stored for 42 days at 45°C are required to be performed three times. Further, a cycle test defined by the IEC62660-1 is required to be performed until any of conditions that (i) repetition of a predetermined charge-discharge cycle for 28 days at 45°C is completed six times (evaluation for 168 days is completed), (ii) a capacity maintenance rate falls below 80%, and (iii) a temperature of a storage battery reaches an upper limit temperature is satisfied.

Further, some performance evaluation tests of storage batteries require a considerable period since multistage charge-discharge steps and test conditions need to be adjusted. For example, in a test for measuring energy density and power density that are initial performance of a battery by a method defined by the IEC62660-1 (performance test) standardized by the International Electrotechnical Commission (IEC), a predetermined charge-discharge protocol including measuring energy density by discharging a storage battery at a predetermined temperature and a current value (C rate) and measuring power density on conditions of a plurality of temperatures and state of charges (SOC) needs to be performed. Each step requires several hours to adjust a storage battery to a predetermined temperature and an SOC, and it takes about 3 days in total to end the entire charge-discharge protocol.

On the other hand, a technique for determining performance and a deterioration state of a storage battery, based on charge-discharge data on the storage battery, has been known. For example,

PTL 1 describes a deterioration determination system, a deterioration determination method, and a deterioration determination program for specifying a state of health (SOH) of a storage battery, based on acquired data on the storage battery, performing linear regression on time-series data on deterioration of the storage battery, and performing determination of presence or absence of sudden deterioration and the like. PTL 2 describes a method for specifying an SOH of a storage battery by using a characteristic charge-discharge protocol.

Based on the background art described above, in recent years, the inventors of the present application have succeeded in developing a technique capable of predicting an evaluation result of a life evaluation test of a storage battery, and shortening time for the life evaluation test of the storage battery. According to this technique, predicted deterioration information after deterioration of a storage battery can be acquired even from limited data by connecting, by data science, charge-discharge data, electrochemical analysis data, and material analysis data on the storage battery in which a deterioration event of the storage battery is reflected, and both prediction accuracy and interpretability can be achieved. The predicted deterioration information after deterioration may include a degree of deterioration of a member of the storage battery, for example, a positive electrode, a negative electrode, a separator, an electrolyte, and the like, and thus there are advantages, such that a user can recognize a cause of deterioration of the storage battery, and perform consideration of a deterioration mechanism, formulation of a deterioration measure, and the like. However, when the predicted deterioration information after deterioration is only acquired, it is unclear as to which specific design of the storage battery needs to be manipulated and in what manner to be able to efficiently improve battery life.

### CITATION LIST

### PATENT LITERATURE

[PTL 1] International Patent Publication No. WO2023/026743
[PTL 2] International Patent Publication No. WO2023/084010

### SUMMARY OF INVENTION

### TECHNICAL PROBLEM

In one embodiment, the present disclosure has one objective to provide evaluation result prediction device, system, method, and program that can predict an evaluation result of a life evaluation test of a storage battery, and can shorten time for the life evaluation test of the storage battery.

In one embodiment, the present disclosure has one objective to provide evaluation result prediction device, system, method, and program that can predict an evaluation result of energy density and power density of a storage battery, and can shorten time for a performance evaluation test of the energy density and the power density of the storage battery.

In one embodiment, the present disclosure has one objective to provide method, device, system, and program that can predict a manipulable factor that influences life of a storage battery, and thus contribute to an efficient improvement in the life of the storage battery.

### SOLUTION TO PROBLEM

Examples of a first embodiment of the present disclosure are listed in items [1] to [24] below.
[1] An evaluation result prediction device that predicts at least one evaluation result selected from a voltage retention rate after a test of a storage battery, a capacity maintenance rate after the test, time to reach the end of life, or a cycle number to reach the end of life being measured by a predetermined life evaluation test, the evaluation result prediction device including:
   an acquisition unit that acquires at least one piece of test condition data selected from a temperature, a current value, a voltage, or a charge-discharge pause time of the storage battery, and charge-discharge data on the storage battery based on an evaluation charge-discharge protocol including performing measurement of energy density and power density during the life evaluation test;
   an explanatory variable extraction unit that extracts a plurality of explanatory variables including one or a plurality of test condition parameters selected from the test condition data, and an electrochemical parameter that is computed from the charge-discharge data and includes the energy density and the power density;
   a storage unit that stores a learned model being learned in such a way as to output a predicted evaluation result including the evaluation result measured by the life evaluation test when the plurality of explanatory variables are input;
   an evaluation prediction unit that acquires the predicted evaluation result by inputting the plurality of explanatory variables to the learned model, and computes prediction accuracy of the predicted evaluation result; and
   an output unit that outputs information including the predicted evaluation result and the prediction accuracy.
[2] The evaluation result prediction device according to item 1, wherein
   the predetermined life evaluation test includes
   a deterioration step of storing a storage battery at a predetermined temperature for a fixed period (X), or repeating a fixed number (Y) of charge-discharge cycles at a predetermined temperature, and
   an evaluation step including (i) measuring a voltage retention rate and/or a capacity maintenance rate of the storage battery after an end of the deterioration step, or (ii) measuring time to reach the end of life or a cycle number to reach the end of life until a voltage retention rate or a capacity maintenance rate of the storage battery falls below a preset reference value, or the storage battery reaches a preset upper limit temperature.
[3] The evaluation result prediction device according to item 2, wherein
   the evaluation charge-discharge protocol includes performing measurement of the energy density and the power density by a single charge-discharge process, and
   the single charge-discharge process includes
      measuring energy density by discharging the storage battery at the predetermined temperature and a predetermined current value, and
      measuring power density at a target charge rate by causing a maximum current value Iₘₐₓ to be temporarily output when a charge rate reaches the target charge rate in a process of the discharging, and subsequently returning the current value to the predetermined current value again, which are performed each time the one or the plurality of target charge rates are reached, thereby performing measurement of the energy density and the power density by a single discharge process.
[4] The evaluation result prediction device according to item 2 or 3, wherein
   the evaluation charge-discharge protocol includes a plurality of single charge-discharge processes of performing measurement of the energy density and the power density by a single charge-discharge process for each fixed period shorter than the X or each fixed number of the charge-discharge cycles smaller than the Y during the life evaluation test,
   the evaluation result prediction device is configured to acquire the predicted evaluation result, based on the test condition data and charge-discharge data of the single charge-discharge process, and compute the prediction accuracy, and
   the evaluation result prediction device further includes a control unit, and the control unit controls the evaluation result prediction device in such a way that the evaluation result prediction device
      (i) ends the life evaluation test when the prediction accuracy is equal to or more than a predetermined threshold value, and
      (ii) continues the life evaluation test and executes a next single charge-discharge process of the evaluation charge-discharge protocol when the prediction accuracy is less than the threshold value, acquires further charge-discharge data, and performs acquisition of the predicted evaluation result and computation of the prediction accuracy, based on the test condition data and accumulated charge-discharge data, which are repeated until the prediction accuracy is equal to or more than the threshold value.
[5] The evaluation result prediction device according to any one of items 1 to 4, wherein
   the electrochemical parameter further includes a capacity maintenance rate of the storage battery.
[6] The evaluation result prediction device according to any one of items 1 to 5, wherein
   the acquisition unit is configured to further acquire at least one piece of material analysis data selected from an X-ray diffraction (XRD) spectrum, a nuclear magnetic resonance (NMR) spectrum, an electron spin resonance (ESR) spectrum, a scanning electron microscope (SEM) image, or an ion chromatography (IC) spectrum of a material constituting the storage battery, and
   the plurality of explanatory variables further include one or a plurality of material analysis parameters acquired by mathematically processing the material analysis data in addition to the test condition parameter and the electrochemical parameter.
[7] The evaluation result prediction device according to any one of items 1 to 6, wherein
   the plurality of explanatory variables further include one or a plurality of mathematical parameters acquired by mathematically processing a shape of a discharge curve in the single charge-discharge process in addition to the test condition parameter and the electrochemical parameter.
[8] The evaluation result prediction device according to any one of items 1 to 7, wherein
   the plurality of explanatory variables are explanatory variables preselected by eliminating one or a plurality of parameters having multicollinearity with another parameter in such a way as to improve the prediction accuracy of the learned model or improve interpretability for the predicted evaluation result.
[9] The evaluation result prediction device according to item 7, wherein
   the mathematical parameter is an explanatory variable preselected from among C coefficients in a matrix W by imposing a mathematical constraint, and then factorizing, into X ≈ W × H (in an equation, the matrix W is a coefficient matrix with 1 row and C columns, and a matrix H is a basis matrix with C rows and B columns), a matrix X with 1 row and B columns acquired by arranging, as elements, values of a voltage (V) corresponding to values of B (B ≥ 2) different charge rates (SOCs) in a column direction for discharge curve data in the single charge-discharge process.
[10] The evaluation result prediction device according to item 6, wherein
   the predicted evaluation result further includes predicted deterioration information on a storage battery when the end of life is reached.
[11] The evaluation result prediction device according to any one of items 1 to 10, wherein
   the output unit is configured to output information including the predicted evaluation result and the prediction accuracy to a virtual environment accessible from a user terminal.
[12] The evaluation result prediction device according to item 11, wherein
   the evaluation result prediction device is further configured to end the evaluation charge-discharge protocol when the evaluation result prediction device receives a command for ending the evaluation charge-discharge protocol from the virtual environment.
[13] An evaluation result prediction system for predicting at least one evaluation result selected from a voltage retention rate after a test of a storage battery, a capacity maintenance rate after the test, time to reach the end of life, or a cycle number to reach the end of life being measured by a predetermined life evaluation test, the evaluation result prediction system including:
   an acquisition device that acquires at least one piece of test condition data selected from a temperature, a current value, a voltage, or a charge-discharge pause time of the storage battery, and charge-discharge data on the storage battery based on an evaluation charge-discharge protocol including performing measurement of energy density and power density during the life evaluation test;
   an explanatory variable extraction device that extracts a plurality of explanatory variables including one or a plurality of test condition parameters selected from the test condition data, and an electrochemical parameter that is computed from the charge-discharge data and includes the energy density and the power density;
   a storage device that stores a learned model being learned in such a way as to output a predicted evaluation result including the evaluation result measured by the life evaluation test when the plurality of explanatory variables are input;
   an evaluation prediction device that acquires the predicted evaluation result by inputting the plurality of explanatory variables to the learned model, and computes prediction accuracy of the predicted evaluation result; and
   an output device that outputs information including the predicted evaluation result and the prediction accuracy.
[14] The evaluation result prediction system according to item 13, wherein
   the predetermined life evaluation test includes
   a deterioration step of storing a storage battery at a predetermined temperature for a fixed period (X), or repeating a fixed number (Y) of charge-discharge cycles at a predetermined temperature, and
   an evaluation step including (i) measuring a voltage retention rate and/or a capacity maintenance rate of the storage battery after an end of the deterioration step, or (ii) measuring time to reach the end of life or a cycle number to reach the end of life until a voltage retention rate or a capacity maintenance rate of the storage battery falls below a preset reference value, or the storage battery reaches a preset upper limit temperature.
[15] The evaluation result prediction system according to item 14, wherein
   the evaluation charge-discharge protocol includes performing measurement of the energy density and the power density by a single charge-discharge process, and
   the single charge-discharge process includes
      measuring energy density by discharging the storage battery at the predetermined temperature and a predetermined current value, and
      measuring power density at a target charge rate by causing a maximum current value Iₘₐₓ to be temporarily output when a charge rate reaches the target charge rate in a process of the discharging, and subsequently returning the current value to the predetermined current value again, which are performed each time the one or the plurality of target charge rates are reached, thereby performing measurement of the energy density and the power density by a single discharge process.
[16] The evaluation result prediction system according to item 14 or 15, wherein
   the evaluation charge-discharge protocol includes a plurality of single charge-discharge processes of performing measurement of the energy density and the power density by a single charge-discharge process for each fixed period shorter than the X or each fixed number of the charge-discharge cycles smaller than the Y during the life evaluation test,
   the evaluation result prediction system is configured to acquire the predicted evaluation result, based on the test condition data and charge-discharge data of the single charge-discharge process, and compute the prediction accuracy, and
   the evaluation result prediction system further includes a control device, and the control device controls the evaluation result prediction system in such a way that the evaluation result prediction system
      (i) ends the life evaluation test when the prediction accuracy is equal to or more than a predetermined threshold value, and
      (ii) continues the life evaluation test and executes a next single charge-discharge process of the evaluation charge-discharge protocol when the prediction accuracy is less than the threshold value, acquires further charge-discharge data, and performs acquisition of the predicted evaluation result and computation of the prediction accuracy, based on the test condition data and accumulated charge-discharge data, which are repeated until the prediction accuracy is equal to or more than the threshold value.
[17] An evaluation result prediction method for predicting at least one evaluation result selected from a voltage retention rate after a test of a storage battery, a capacity maintenance rate after the test, time to reach the end of life, or a cycle number to reach the end of life being measured by a predetermined life evaluation test, the evaluation result prediction method including:
   acquiring at least one piece of test condition data selected from a temperature, a current value, a voltage, or a charge-discharge pause time of the storage battery, and charge-discharge data on the storage battery based on an evaluation charge-discharge protocol including performing measurement of energy density and power density during the life evaluation test;
   extracting a plurality of explanatory variables including one or a plurality of test condition parameters selected from the test condition data, and an electrochemical parameter that is computed from the charge-discharge data and includes the energy density and the power density;
   acquiring a predicted evaluation result including the evaluation result measured by the life evaluation test by inputting the plurality of explanatory variables to a learned model being learned in such a way as to output the predicted evaluation result when the plurality of explanatory variables are input;
   computing prediction accuracy of the predicted evaluation result; and
   then outputting information including the predicted evaluation result and the prediction accuracy.
[18] The evaluation result prediction method according to item 17, wherein
   the predetermined life evaluation test includes
   a deterioration step of storing a storage battery at a predetermined temperature for a fixed period (X), or repeating a fixed number (Y) of charge-discharge cycles at a predetermined temperature, and
   an evaluation step including (i) measuring a voltage retention rate and/or a capacity maintenance rate of the storage battery after an end of the deterioration step, or (ii) measuring time to reach the end of life or a cycle number to reach the end of life until a voltage retention rate or a capacity maintenance rate of the storage battery falls below a preset reference value, or the storage battery reaches a preset upper limit temperature.
[19] The evaluation result prediction method according to item 18, wherein
   the evaluation charge-discharge protocol includes performing measurement of the energy density and the power density by a single charge-discharge process, and
   the single charge-discharge process includes
      measuring energy density by discharging the storage battery at the predetermined temperature and a predetermined current value, and
      measuring power density at a target charge rate by causing a maximum current value Iₘₐₓ to be temporarily output when a charge rate reaches the target charge rate in a process of the discharging, and subsequently returning the current value to the predetermined current value again, which are performed each time the one or the plurality of target charge rates are reached, thereby performing measurement of the energy density and the power density by a single discharge process.
[20] The evaluation result prediction method according to item 18 or 19, wherein
   the evaluation charge-discharge protocol includes a plurality of single charge-discharge processes of performing measurement of the energy density and the power density by a single charge-discharge process for each fixed period shorter than the X or each fixed number of the charge-discharge cycles smaller than the Y during the life evaluation test,
   the evaluation result prediction method further includes acquiring the predicted evaluation result, based on the test condition data and charge-discharge data of the single charge-discharge process, and computing the prediction accuracy, and
      (i) ending the life evaluation test when the prediction accuracy is equal to or more than a predetermined threshold value, and
      (ii) continuing the life evaluation test and executing a next single charge-discharge process of the evaluation charge-discharge protocol when the prediction accuracy is less than the threshold value, acquiring further charge-discharge data, and performing acquisition of the predicted evaluation result and computation of the prediction accuracy, based on the test condition data and accumulated charge-discharge data, which are repeated until the prediction accuracy is equal to or more than the threshold value.
[21] An evaluation result prediction program that predicts at least one evaluation result selected from a voltage retention rate after a test of a storage battery, a capacity maintenance rate after the test, time to reach the end of life, or a cycle number to reach the end of life being measured by a predetermined life evaluation test, the evaluation result prediction program causing a computer to execute:
   acquiring at least one piece of test condition data selected from a temperature, a current value, a voltage, or a charge-discharge pause time of the storage battery, and charge-discharge data on the storage battery based on an evaluation charge-discharge protocol including performing measurement of energy density and power density during the life evaluation test;
   extracting a plurality of explanatory variables including one or a plurality of test condition parameters selected from the test condition data, and an electrochemical parameter that is computed from the charge-discharge data and includes the energy density and the power density;
   acquiring a predicted evaluation result including the evaluation result measured by the life evaluation test by inputting the plurality of explanatory variables to a learned model being learned in such a way as to output the predicted evaluation result when the plurality of explanatory variables are input;
   computing prediction accuracy of the predicted evaluation result; and
   then outputting information including the predicted evaluation result and the prediction accuracy.
[22] The evaluation result prediction program according to item 21, wherein
   the predetermined life evaluation test includes
   a deterioration step of storing a storage battery at a predetermined temperature for a fixed period (X), or repeating a fixed number (Y) of charge-discharge cycles at a predetermined temperature, and
   an evaluation step including (i) measuring a voltage retention rate and/or a capacity maintenance rate of the storage battery after an end of the deterioration step, or (ii) measuring time to reach the end of life or a cycle number to reach the end of life until a voltage retention rate or a capacity maintenance rate of the storage battery falls below a preset reference value, or the storage battery reaches a preset upper limit temperature.
[23] The evaluation result prediction program according to item 22, wherein
   the evaluation charge-discharge protocol includes performing measurement of the energy density and the power density by a single charge-discharge process, and
   the single charge-discharge process includes
      measuring energy density by discharging the storage battery at the predetermined temperature and a predetermined current value, and
      measuring power density at the target charge rate by causing a maximum current value Iₘₐₓ to be temporarily output when a charge rate reaches the target charge rate in a process of the discharging, and subsequently returning the current value to the predetermined current value again, which are performed each time the one or the plurality of target charge rates are reached, thereby performing measurement of the energy density and the power density by a single discharge process.
[24] The evaluation result prediction program according to item 22 or 23, wherein
   the evaluation charge-discharge protocol includes a plurality of single charge-discharge processes of performing measurement of the energy density and the power density by a single charge-discharge process for each fixed period shorter than the X or each fixed number of the charge-discharge cycles smaller than the Y during the life evaluation test,
   the evaluation result prediction program further causes a computer to execute acquiring the predicted evaluation result, based on the test condition data and charge-discharge data of the single charge-discharge process, and computing the prediction accuracy, and
      (i) ending the life evaluation test when the prediction accuracy is equal to or more than a predetermined threshold value, and
      (ii) continuing the life evaluation test and executing a next single charge-discharge process of the evaluation charge-discharge protocol when the prediction accuracy is less than the threshold value, acquiring further charge-discharge data, and performing acquisition of the predicted evaluation result and computation of the prediction accuracy, based on the test condition data and accumulated charge-discharge data, which are repeated until the prediction accuracy is equal to or more than the threshold value.

Examples of a second embodiment of the present disclosure are listed in items [1] to [21] below.
[1] An evaluation result prediction device that predicts energy density and power density of a storage battery being successively measured by a predetermined charge-discharge protocol, the evaluation result prediction device including:
   an acquisition unit that acquires charge-discharge data on a storage battery based on an evaluation charge-discharge protocol including performing measurement of energy density and power density by a single charge-discharge process;
   an explanatory variable extraction unit that extracts, from the charge-discharge data, a plurality of explanatory variables including an electrochemical parameter including the energy density and the power density;
   a storage unit that stores a learned model being learned in such a way as to output a predicted evaluation result including energy density and power density being measured by the predetermined charge-discharge protocol when the plurality of explanatory variables are input;
   an evaluation prediction unit that acquires the predicted evaluation result by inputting the plurality of explanatory variables to the learned model, and computes prediction accuracy of the predicted evaluation result; and
   an output unit that outputs information including the predicted evaluation result and the prediction accuracy.
[2] The evaluation result prediction device according to item 1, wherein
   the predetermined charge-discharge protocol successively includes
   an energy density measurement step of measuring energy density by discharging a storage battery at a first temperature and a first current value, and
   one or a plurality of power density measurement steps of adjusting the storage battery to a target charge rate by a charge or discharge process different in temperature, different in charging or discharging, different in current value, or different in two or more of these from the energy density measurement step, and measuring power density at the target charge rate by causing a maximum current value Iₘₐₓ to be output.
[3] The evaluation result prediction device according to item 2, wherein
   the single charge-discharge process includes
   measuring energy density by discharging the storage battery at the first temperature and a second current value greater than the first current value, and
   measuring power density at the target charge rate by causing the maximum current value Iₘₐₓ to be temporarily output when a charge rate reaches the target charge rate in a process of the discharging, and subsequently returning the current value to the second current value again, which are performed each time the one or the plurality of target charge rates are reached, thereby performing measurement of the energy density and the power density by a single discharge process.
[4] The evaluation result prediction device according to any one of items 1 to 3, wherein
   the evaluation charge-discharge protocol includes first to n-th single charge-discharge processes (n is an integer of 2 or more) of performing measurement of energy density and power density by a single charge-discharge process at first to n-th different temperatures, respectively, and the first to n-th single charge-discharge processes are constituted in an order in which the prediction accuracy further increases or temperature adjustment ends in a shorter time,
   the evaluation result prediction device is configured to acquire the predicted evaluation result, based on charge-discharge data of the first single charge-discharge process, and compute the prediction accuracy, and
   the evaluation result prediction device further includes a control unit, and the control unit controls the evaluation result prediction device in such a way that the evaluation result prediction device
      (i) ends the evaluation charge-discharge protocol when the prediction accuracy is equal to or more than a predetermined threshold value, and
      (ii) executes a next single charge-discharge process of the evaluation charge-discharge protocol when the prediction accuracy is less than the threshold value, acquires further charge-discharge data, and performs acquisition of the predicted evaluation result and computation of the prediction accuracy, based on accumulated charge-discharge data, which are repeated until the prediction accuracy is equal to or more than the threshold value or the n-th single charge-discharge process ends.
[5] The evaluation result prediction device according to any one of items 1 to 4, wherein
   the plurality of explanatory variables further include one or a plurality of mathematical parameters acquired by mathematically processing a shape of a discharge curve in the single charge-discharge process in addition to the electrochemical parameter.
[6] The evaluation result prediction device according to item 5, wherein
   the plurality of explanatory variables are explanatory variables preselected by eliminating one or a plurality of parameters having multicollinearity with another parameter in such a way as to improve the prediction accuracy of the learned model or improve interpretability for the predicted evaluation result.
[7] The evaluation result prediction device according to item 6, wherein
   the mathematical parameter is an explanatory variable preselected from among C coefficients in a matrix W acquired by imposing a mathematical constraint, and then factorizing, into X ≈ W × H (in an equation, the matrix W is a coefficient matrix with 1 row and C columns, and a matrix H is a basis matrix with C rows and B columns), a matrix X with 1 row and B columns acquired by arranging, as elements, values of a voltage (V) corresponding to values of B (B ≥ 2) different charge rates (SOCs) in a column direction for discharge curve data in the single charge-discharge process.
[8] The evaluation result prediction device according to any one of items 1 to 7, wherein
   the output unit is configured to output information including the predicted evaluation result and the prediction accuracy to a virtual environment accessible from a user terminal.
[9] The evaluation result prediction device according to item 8, wherein
   the evaluation result prediction device is further configured to end the evaluation charge-discharge protocol when the evaluation result prediction device receives a command for ending the evaluation charge-discharge protocol from the virtual environment.
[10] An evaluation result prediction system for predicting energy density and power density of a storage battery being successively measured by a predetermined charge-discharge protocol, the evaluation result prediction system including:
   an acquisition device that acquires charge-discharge data on a storage battery based on an evaluation charge-discharge protocol including performing measurement of energy density and power density by a single charge-discharge process;
   an explanatory variable extraction device that extracts, from the charge-discharge data, a plurality of explanatory variables including an electrochemical parameter including the energy density and the power density;
   a storage device that stores a learned model being learned in such a way as to output a predicted evaluation result including energy density and power density being measured by the predetermined charge-discharge protocol when the plurality of explanatory variables are input;
   an evaluation prediction device that acquires the predicted evaluation result by inputting the plurality of explanatory variables to the learned model, and computes prediction accuracy of the predicted evaluation result; and
   an output device that outputs information including the predicted evaluation result and the prediction accuracy.
[11] The evaluation result prediction system according to item 10, wherein
   the predetermined charge-discharge protocol successively includes
   an energy density measurement step of measuring energy density by discharging a storage battery at a first temperature and a first current value, and
   one or a plurality of power density measurement steps of adjusting the storage battery to a target charge rate by a charge or discharge process different in temperature, different in charging or discharging, different in current value, or different in two or more of these from the energy density measurement step, and measuring power density at the target charge rate by causing a maximum current value Iₘₐₓ to be output.
[12] The evaluation result prediction system according to item 11, wherein
   the single charge-discharge process includes
   measuring energy density by discharging the storage battery at the first temperature and a second current value greater than the first current value, and
   measuring power density at the target charge rate by causing the maximum current value Iₘₐₓ to be temporarily output when a charge rate reaches the target charge rate in a process of the discharging, and subsequently returning the current value to the second current value again, which are performed each time the one or the plurality of target charge rates are reached, thereby performing measurement of the energy density and the power density by a single discharge process.
[13] The evaluation result prediction system according to any one of items 10 to 12, wherein
   the evaluation charge-discharge protocol includes first to n-th single charge-discharge processes (n is an integer of 2 or more) of performing measurement of energy density and power density by a single charge-discharge process at first to n-th different temperatures, respectively, and the first to n-th single charge-discharge processes are constituted in an order in which the prediction accuracy further increases or temperature adjustment ends in a shorter time,
   the evaluation result prediction system is configured to acquire the predicted evaluation result, based on charge-discharge data of the first single charge-discharge process, and compute the prediction accuracy, and
   the evaluation result prediction system further includes a control device, and the control device controls the evaluation result prediction system in such a way that the evaluation result prediction system
      (i) ends the evaluation charge-discharge protocol when the prediction accuracy is equal to or more than a predetermined threshold value, and
      (ii) executes a next single charge-discharge process of the evaluation charge-discharge protocol when the prediction accuracy is less than the threshold value, acquires further charge-discharge data, and performs acquisition of the predicted evaluation result and computation of the prediction accuracy, based on accumulated charge-discharge data, which are repeated until the prediction accuracy is equal to or more than the threshold value or the n-th single charge-discharge process ends.
[14] An evaluation result prediction method for predicting energy density and power density of a storage battery being successively measured by a predetermined charge-discharge protocol, the evaluation result prediction method including:
   acquiring charge-discharge data on a storage battery based on an evaluation charge-discharge protocol including performing measurement of energy density and power density by a single charge-discharge process;
   extracting, from the charge-discharge data, a plurality of explanatory variables including an electrochemical parameter including the energy density and the power density;
   by inputting the plurality of explanatory variables to a learned model being learned in such a way as to output a predicted evaluation result including energy density and power density being measured by the predetermined charge-discharge protocol when the plurality of explanatory variables are input, acquiring the predicted evaluation result;
   computing prediction accuracy of the predicted evaluation result; and
   then outputting information including the predicted evaluation result and the prediction accuracy.
[15] The evaluation result prediction method according to item 14, wherein
   the predetermined charge-discharge protocol successively includes
   an energy density measurement step of measuring energy density by discharging a storage battery at a first temperature and a first current value, and
   one or a plurality of power density measurement steps of adjusting the storage battery to a target charge rate by a charge or discharge process different in temperature, different in charging or discharging, different in current value, or different in two or more of these from the energy density measurement step, and measuring power density at the target charge rate by causing a maximum current value Iₘₐₓ to be output.
[16] The evaluation result prediction method according to item 15, wherein
   the single charge-discharge process includes
   measuring energy density by discharging the storage battery at the first temperature and a second current value greater than the first current value, and
   measuring power density at the target charge rate by causing the maximum current value Iₘₐₓ to be temporarily output when a charge rate reaches the target charge rate in a process of the discharging, and subsequently returning the current value to the second current value again, which are performed each time the one or the plurality of target charge rates are reached, thereby performing measurement of the energy density and the power density by a single discharge process.
[17] The evaluation result prediction method according to any one of items 14 to 16, wherein
   the evaluation charge-discharge protocol includes first to n-th single charge-discharge processes (n is an integer of 2 or more) of performing measurement of energy density and power density by a single charge-discharge process at first to n-th different temperatures, respectively, and the first to n-th single charge-discharge processes are constituted in an order in which the prediction accuracy further increases or temperature adjustment ends in a shorter time,
   the evaluation result prediction method further includes acquiring the predicted evaluation result, based on charge-discharge data of the first single charge-discharge process, and computing the prediction accuracy, and
      (i) ending the evaluation charge-discharge protocol when the prediction accuracy is equal to or more than a predetermined threshold value, and
      (ii) executing a next single charge-discharge process of the evaluation charge-discharge protocol when the prediction accuracy is less than the threshold value, acquiring further charge-discharge data, and performing acquisition of the predicted evaluation result and computation of the prediction accuracy, based on accumulated charge-discharge data, which are repeated until the prediction accuracy is equal to or more than the threshold value or the n-th single charge-discharge process ends.
[18] An evaluation result prediction program that predicts energy density and power density of a storage battery being successively measured by a predetermined charge-discharge protocol, the evaluation result prediction program causing a computer to execute:
   acquiring charge-discharge data on a storage battery based on an evaluation charge-discharge protocol including performing measurement of energy density and power density by a single charge-discharge process;
   extracting, from the charge-discharge data, a plurality of explanatory variables including an electrochemical parameter including the energy density and the power density;
   by inputting the plurality of explanatory variables to a learned model being learned in such a way as to output a predicted evaluation result including energy density and power density being measured by the predetermined charge-discharge protocol when the plurality of explanatory variables are input, acquiring the predicted evaluation result;
   computing prediction accuracy of the predicted evaluation result; and
   then outputting information including the predicted evaluation result and the prediction accuracy.
[19] The evaluation result prediction program according to item 18, wherein
   the predetermined charge-discharge protocol successively includes
   an energy density measurement step of measuring energy density by discharging a storage battery at a first temperature and a first current value, and
   one or a plurality of power density measurement steps of adjusting the storage battery to a target charge rate by a charge or discharge process different in temperature, different in charging or discharging, different in current value, or different in two or more of these from the energy density measurement step, and measuring power density at the target charge rate by causing a maximum current value Iₘₐₓ to be output.
[20] The evaluation result prediction program according to item 19, wherein
   the single charge-discharge process includes
   measuring energy density by discharging the storage battery at the first temperature and a second current value greater than the first current value, and
   measuring power density at the target charge rate by causing the maximum current value Iₘₐₓ to be temporarily output when a charge rate reaches the target charge rate in a process of the discharging, and subsequently returning the current value to the second current value again, which are performed each time the one or the plurality of target charge rates are reached, thereby performing measurement of the energy density and the power density by a single discharge process.
[21] The evaluation result prediction program according to any one of items 18 to 20, wherein
   the evaluation charge-discharge protocol includes first to n-th single charge-discharge processes (n is an integer of 2 or more) of performing measurement of energy density and power density by a single charge-discharge process at first to n-th different temperatures, respectively, and the first to n-th single charge-discharge processes are constituted in an order in which the prediction accuracy further increases or temperature adjustment ends in a shorter time,
   the evaluation result prediction program further causes a computer to execute acquiring the predicted evaluation result, based on charge-discharge data of the first single charge-discharge process, and computing the prediction accuracy, and
      (i) ending the evaluation charge-discharge protocol when the prediction accuracy is equal to or more than a predetermined threshold value, and
      (ii) executing a next single charge-discharge process of the evaluation charge-discharge protocol when the prediction accuracy is less than the threshold value, acquiring further charge-discharge data, and performing acquisition of the predicted evaluation result and computation of the prediction accuracy, based on accumulated charge-discharge data, which are repeated until the prediction accuracy is equal to or more than the threshold value or the n-th single charge-discharge process ends.

Examples of a third embodiment of the present disclosure are listed in items [1] to [12] below.
[1] A manipulable factor prediction method for predicting a manipulable factor that influences life of a storage battery, the method including:
   a step of computing, from at least one piece of predicted deterioration information selected from a group consisting of a predicted charge-discharge characteristic, predicted electrochemical analysis data, and predicted material analysis data after deterioration of the storage battery, a plurality of degrees of deterioration representing an extent of deterioration and each corresponding to a life determination event being a reference for life determination of the storage battery, and a plurality of deterioration events directly or indirectly having a causal relationship with the life determination event;
   a step of simplifying an association model in which a causal relationship among the life determination event, the plurality of deterioration events, and a plurality of manipulable factor candidates is associated in advance by eliminating the one or the plurality of deterioration events having the degree of deterioration lower than a threshold value from the association model, and, as a result, when there are the deterioration event and the manipulable factor candidate losing a causal relationship with the life determination event, also eliminating the deterioration event and the manipulable factor candidate; and
   a step of outputting, as a manipulable factor that influences life of the storage battery, the one or the plurality of manipulable factor candidates directly or indirectly having a causal relationship with the life determination event in the simplified association model.
[2] The manipulable factor prediction method according to item 1, further including:
   acquiring a degree of influence corresponding to each of one or more of the plurality of deterioration events by inputting a degree of deterioration of the life determination event and degrees of deterioration of the plurality of deterioration events to a learned model being learned in such a way as to output the degree of influence representing an improvement effect with respect to the degree of deterioration of the life determination event when one or more of the plurality of deterioration events are each improved in a case where the degree of deterioration of the life determination event and the degrees of deterioration of the plurality of deterioration events are input; and
   then outputting, as a manipulable factor that influences life of the storage battery, the one or the plurality of manipulable factor candidates directly or indirectly having a causal relationship with the one or the plurality of deterioration events having the degree of influence equal to or more than a threshold value in the simplified association model.
[3] The manipulable factor prediction method according to item 2, further including
   associating the manipulable factor with an input and/or output of the learned model by using a theoretical calculation equation representing a relationship between the manipulable factor and degrees of deterioration and/or degrees of influence of the plurality of deterioration events in the simplified association model, then predicting a change in life of the storage battery when each output manipulable factor is changed by performing forward analysis and/or inverse analysis on the learned model from a specific manipulable factor, and outputting a prediction result.
[4] The manipulable factor prediction method according to item 2, further including
   constructing a simulation model that simulates a change in life of the storage battery when each output manipulable factor is changed by using a theoretical calculation equation representing a relationship among the output manipulable factor, degrees of deterioration of the plurality of deterioration events, and a degree of deterioration of a life determination event and using the learned model in the simplified association model, then simulating a change in life of the storage battery when each output manipulable factor is changed by the simulation model, and outputting a simulation result.
[5] The manipulable factor prediction method according to any one of items 2 to 4, wherein
   the life determination event is capacity deterioration of the storage battery.
[6] The manipulable factor prediction method according to any one of items 2 to 5, wherein
   the association model is an association model of a tree shape based on fault tree analysis (FTA) in which the life determination event is set as a top event, and is configured in such a way that the plurality of deterioration events are an upper layer and the plurality of manipulable factor candidates are a lower layer.
[7] The manipulable factor prediction method according to item 6, wherein
   the plurality of deterioration events include one or a plurality of charge-discharge characteristic deterioration events, a plurality of electrochemical analytical deterioration events, and a plurality of material analytical deterioration events in an order from the upper layer, and the plurality of manipulable factor candidates are positioned in the lower layer than each of the plurality of material analytical deterioration events.
[8] The manipulable factor prediction method according to any one of items 1 to 7, wherein
   the predicted deterioration information includes a predicted charge-discharge characteristic, predicted electrochemical analysis data, and predicted material analysis data when the end of life of the storage battery is reached,
   the predicted charge-discharge characteristic includes at least one selected from a group consisting of energy density, power density, a capacity, and charge-discharge efficiency of the storage battery when the end of life is reached,
   the predicted electrochemical analysis data include at least one selected from a group consisting of charge curve analysis (CCA), discharge curve analysis, a galvanostatic intermittent titration technique (GITT), and electrochemical impedance spectroscopy (EIS) of the storage battery when the end of life is reached, and
   the predicted material analysis data include at least one selected from a group consisting of nuclear magnetic resonance (NMR) data, ion chromatography (IC) data, scanning electron microscope (SEM) observation data, X-ray diffraction (XRD) data, electron spin resonance (ESR) data, X-ray CT image data, and air permeability measurement data of a material constituting the storage battery when the end of life is reached.
[9] The manipulable factor prediction method according to any one of items 1 to 8, wherein
   the manipulable factor candidate is at least one selected from a group consisting of density, a thickness, volume resistance, interface resistance, peel strength, porosity, and a basis weight of a negative electrode active material layer, a negative electrode active material type, a particle structure, a particle diameter, a specific surface area, a crystalline structure, crystallinity, the amount of impurities, and content of a negative electrode active material, negative electrode binder type and content, content of silicon oxide (SiOx),
   density, a thickness, volume resistance, interface resistance, peel strength, porosity, and a basis weight of a positive electrode active material layer, a positive electrode active material type, a particle structure, a particle diameter, a specific surface area, a crystalline structure, crystallinity, the amount of impurities, and content of a positive electrode active material, positive electrode binder type and content, material type and content of a conductive auxiliary, electrolyte salt type and content in an electrolyte solution, solvent type and content in an electrolyte solution, additive type and content in an electrolyte solution, a thickness, a hole diameter, a porosity rate, tortuosity, and strength of a separator, a thickness of a coating layer of a separator, a filler type of a coating layer, particle diameter and content of a filler of a coating layer, binder type and content of a coating layer, and a coating position of a coating layer (single-sided coating on a positive electrode side, single-sided coating on a negative electrode side, or double-sided coating).
[10] A manipulable factor prediction device that predicts a manipulable factor that influences life of a storage battery, the device including:
   an acquisition unit that acquires at least one piece of predicted deterioration information selected from a group consisting of a predicted charge-discharge characteristic, predicted electrochemical analysis data, and predicted material analysis data after deterioration of the storage battery;
   a deterioration degree computation unit that computes a plurality of degrees of deterioration representing an extent of deterioration and each corresponding to a life determination event being a reference for life determination of the storage battery, and a plurality of deterioration events directly or indirectly having a causal relationship with the life determination event;
   a storage unit that stores an association model in which a causal relationship among the life determination event, the plurality of deterioration events, and a plurality of manipulable factor candidates is associated in advance
   a simplified association model generation unit that simplifies the association model by eliminating the one or the plurality of deterioration events having the degree of deterioration lower than a threshold value from the association model, and, as a result, when there are the deterioration event and the manipulable factor candidate losing a causal relationship with the life determination event, also eliminating the deterioration event and the manipulable factor candidate; and
   an output unit that outputs, as a manipulable factor that influences life of the storage battery, the one or the plurality of manipulable factor candidates directly or indirectly having a causal relationship with the life determination event in the simplified association model.
[11] A manipulable factor prediction system for predicting a manipulable factor that influences life of a storage battery, the system including:
   an acquisition device that acquires at least one piece of predicted deterioration information selected from a group consisting of a predicted charge-discharge characteristic, predicted electrochemical analysis data, and predicted material analysis data after deterioration of the storage battery;
   a deterioration degree computation device that computes a plurality of degrees of deterioration representing an extent of deterioration and each corresponding to a life determination event being a reference for life determination of the storage battery, and a plurality of deterioration events directly or indirectly having a causal relationship with the life determination event;
   a storage device that stores an association model in which a causal relationship among the life determination event, the plurality of deterioration events, and a plurality of manipulable factor candidates is associated in advance;
   a simplified association model generation device that simplifies the association model by eliminating the one or the plurality of deterioration events having the degree of deterioration lower than a threshold value from the association model, and, as a result, when there are the deterioration event and the manipulable factor candidate losing a causal relationship with the life determination event, also eliminating the deterioration event and the manipulable factor candidate; and
   an output device that outputs, as a manipulable factor that influences life of the storage battery, the one or the plurality of manipulable factor candidates directly or indirectly having a causal relationship with the life determination event in the simplified association model.
[12] A manipulable factor prediction program that predicts a manipulable factor that influences life of a storage battery, the program causing a computer to execute:
   computing, from at least one piece of predicted deterioration information selected from a group consisting of a predicted charge-discharge characteristic, predicted electrochemical analysis data, and predicted material analysis data after deterioration of the storage battery, a plurality of degrees of deterioration representing an extent of deterioration and each corresponding to a life determination event being a reference for life determination of the storage battery, and a plurality of deterioration events directly or indirectly having a causal relationship with the life determination event;
   simplifying an association model in which a causal relationship among the life determination event, the plurality of deterioration events, and a plurality of manipulable factor candidates is associated in advance by eliminating the one or the plurality of deterioration events having the degree of deterioration lower than a threshold value from the association model, and, as a result, when there are the deterioration event and the manipulable factor candidate losing a causal relationship with the life determination event, also eliminating the deterioration event and the manipulable factor candidate; and
   outputting, as a manipulable factor that influences life of the storage battery, the one or the plurality of manipulable factor candidates directly or indirectly having a causal relationship with the life determination event in the simplified association model.

### ADVANTAGEOUS EFFECTS OF INVENTION

In one embodiment, according to the present disclosure, the evaluation result prediction device, system, method, and program that can predict an evaluation result of a life evaluation test of a storage battery, and can shorten time for the life evaluation test of the storage battery are provided.

In one embodiment, according to the present disclosure, the evaluation result prediction device, system, method, and program that can predict an evaluation result of energy density and power density of a storage battery, and can shorten time for a performance evaluation test of the energy density and the power density of the storage battery are provided.

In one embodiment, according to the present disclosure, method, device, system, and program that can predict a manipulable factor that influences life of a storage battery, and thus contribute to an efficient improvement in the life of the storage battery are provided.

### BRIEF DESCRIPTION OF DRAWINGS

[Fig. 1] FIG. 1 is a diagram illustrating a schematic configuration of an evaluation result prediction system 1 according to an embodiment of the present disclosure.
[Fig. 2] FIG. 2A is a diagram illustrating an example of a single discharge process in an evaluation charge-discharge protocol. FIG. 2B is a diagram illustrating an example of the evaluation charge-discharge protocol including performing the single discharge process for each fixed number of charge-discharge cycles.
[Fig. 3] FIG. 3 is a diagram illustrating an example of the evaluation result prediction system 1 according to the embodiment of the present disclosure in FIG. 1.
[Fig. 4] FIG. 4 is a diagram illustrating an example of computation of mathematical parameters as explanatory variables.
[Fig. 5] FIG. 5 is a flowchart illustrating an example of a motion of learning processing of a learned model.
[Fig. 6] FIG. 6 is a flowchart illustrating an example of a motion of the learning processing of the learned model.
[Fig. 7] FIG. 7 is a flowchart illustrating an example of a motion of evaluation prediction processing (evaluation result prediction method) using the learned model by the learning processing in FIG. 5.
[Fig. 8] FIG. 8 is a flowchart illustrating an example of a motion of the evaluation prediction processing (evaluation result prediction method) using the learned model by the learning processing in FIG. 6.
[Fig. 9] FIG. 9 is a diagram illustrating an example of the evaluation result prediction system 1 according to the embodiment of the present disclosure in FIG. 1.
[Fig. 10] FIG. 10 is a diagram illustrating a schematic configuration of the evaluation result prediction system 1 according to the embodiment of the present disclosure.
[Fig. 11] FIG. 11 is a diagram illustrating an example of the evaluation result prediction system 1 according to the embodiment of the present disclosure in FIG. 10.
[Fig. 12] FIG. 12 is a flowchart illustrating an example of a motion of the learning processing of the learned model.
[Fig. 13] FIG. 13 is a flowchart illustrating an example of a motion of the evaluation prediction processing (evaluation result prediction method).
[Fig. 14] FIG. 14 is a flowchart illustrating an example of manipulable factor prediction processing of the present disclosure.
[Fig. 15] FIG. 15 is a flowchart illustrating a modification example of the manipulable factor prediction processing of the present disclosure.
[Fig. 16] FIG. 16 is an example of an association model of a tree shape based on fault tree analysis (FTA) in which a life determination event is set as a top event.
[Fig. 17] FIG. 17 illustrates an example of computing, from predicted deterioration information, a degree of deterioration corresponding to each of a life determination event and a plurality of deterioration events.
[Fig. 18] FIG. 18 illustrates an example of computing, from predicted deterioration information, a degree of deterioration corresponding to each of a life determination event and a plurality of deterioration events.
[Fig. 19] FIG. 19 illustrates an example of a step of simplifying an association model, based on a degree of deterioration.
[Fig. 20] FIG. 20 illustrates an example of a step of acquiring a degree of influence.
[Fig. 21] FIG. 21 illustrates an example of simplifying an association model, based on a degree of deterioration and a degree of influence, and outputting a manipulable factor.
[Fig. 22] FIG. 22 is a diagram illustrating a schematic configuration of a manipulable factor prediction device of the present disclosure.
[Fig. 23] FIG. 23 is a diagram illustrating a schematic configuration of the manipulable factor prediction device of the present disclosure.
[Fig. 24] FIG. 24 is a diagram illustrating a schematic configuration of an evaluation result and manipulable factor prediction system of the present disclosure.

### DESCRIPTION OF EMBODIMENTS

While embodiments of the present disclosure will be described below in detail, a technical scope of the present invention is not limited to the embodiments below and extends to the inventions described in the claims and equivalents thereof. Any numerical value range can be constituted by freely combining an upper limit value and a lower limit value in each numerical value range of the embodiments below.

### <<Evaluation Result Prediction System and Evaluation Result Prediction Device>>

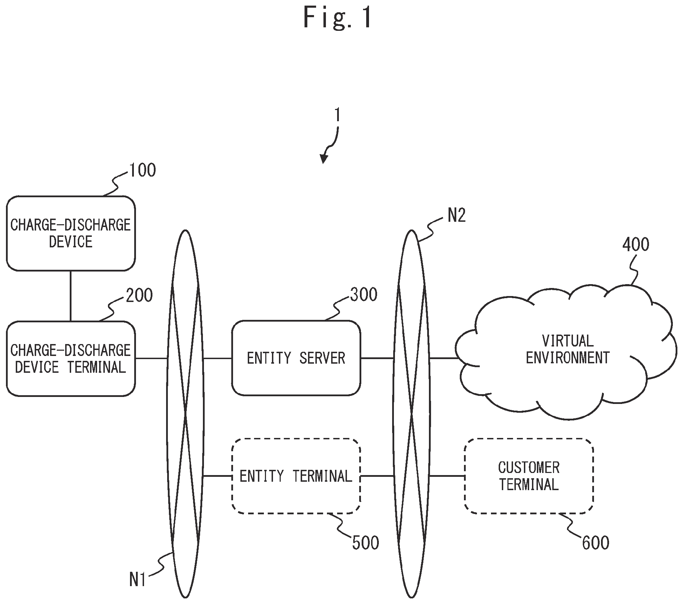

FIG. 1 is a diagram illustrating a schematic configuration of an evaluation result prediction system 1 according to the embodiment of the present disclosure. The evaluation result prediction system 1 includes a charge-discharge device 100, a charge-discharge device terminal 200 communicably connected to the charge-discharge device 100, an entity server 300 communicably connected to the charge-discharge device terminal 200 via a private network N1 of an entity, and a virtual environment 400 constructed on a network N2 and communicably connected to the entity server 300. The evaluation result prediction system 1 can be accessed from a terminal device such as an entity terminal 500 and a customer terminal 600 indicated by a broken line. The entity terminal 500 is communicably connected to the charge-discharge device terminal 200 and the entity server 300 via the private network N1 of the entity, and is also communicably connected to the virtual environment 400 and the customer terminal 600 via the network N2. The customer terminal 600 is communicably connected to the virtual environment 400 and the entity terminal 500 via the network N2. The evaluation result prediction system 1 can predict an evaluation result that may be acquired if a predetermined life evaluation test is performed on a storage battery being an evaluation target, and deterioration information on the storage battery when the end of life is reached, based on test condition data in the life evaluation test, and charge-discharge data acquired by executing charging and discharging based on an evaluation charge-discharge protocol on the storage battery being the evaluation target during the life evaluation test. The evaluation result prediction system 1 can predict an evaluation result that may be acquired if a predetermined charge-discharge protocol is performed on a storage battery being an evaluation target, based on charge-discharge data acquired by executing charging and discharging based on an evaluation charge-discharge protocol on the storage battery being the evaluation target, instead of or in addition to prediction of an evaluation result of the predetermined life evaluation test.

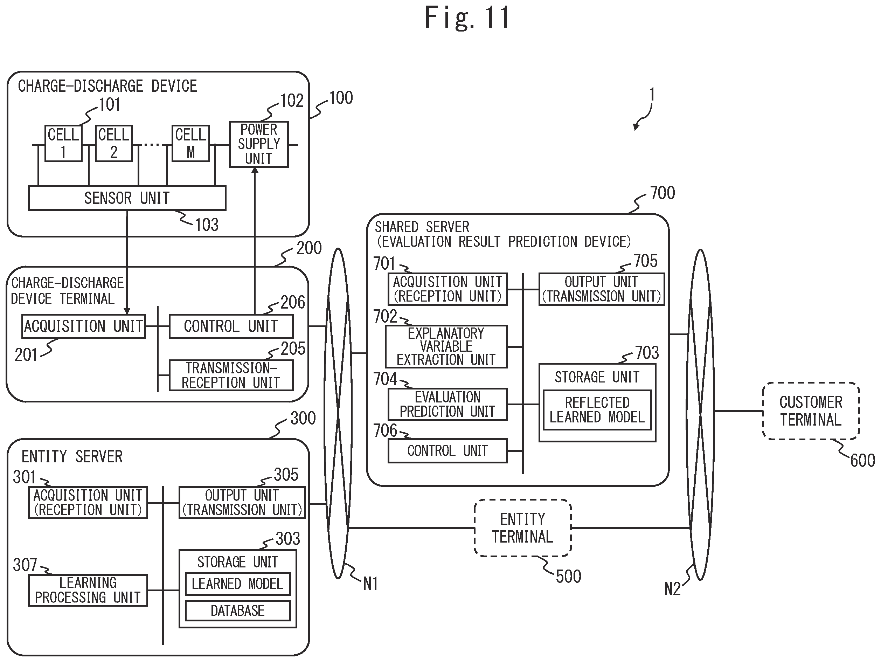

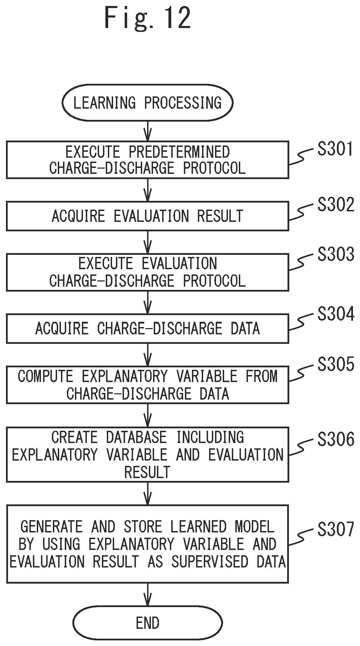

The evaluation result prediction system 1 may be configured to be able to predict a manipulable factor being a factor in terms of design of a storage battery that influences life of the storage battery, in addition to prediction of an evaluation result of the predetermined life evaluation test, preferably, in addition to prediction of an evaluation result of the predetermined life evaluation test and prediction of an evaluation result by the predetermined charge-discharge protocol. In this case, as exemplified in FIGS. 11 and 12, the evaluation result prediction system 1 may include a manipulable factor prediction device 800 (not illustrated). For example, at least one information processing device selected from a group consisting of the charge-discharge device terminal 200, the entity server 300, and a shared server 700 (in a case of being present) in the evaluation result prediction system 1 may further include a configuration serving as the manipulable factor prediction device 800. Alternatively, in the evaluation result prediction system 1, a different information processing device communicably connected to one or a plurality of components via the network N1 and/or N2 may further include a configuration serving as the manipulable factor prediction device 800. Alternatively, configurations of a manipulable factor prediction system may be included in a distributed manner in such a way that the charge-discharge device terminal 200, the entity server 300, the shared server 700 (in a case of being present), and the different information processing device described above (in a case of being present) function as the manipulable factor prediction system as a whole.

### <Predetermined Life Evaluation Test>

The life evaluation test is a test including deterioration of a storage battery for a long period on a predetermined condition. The predetermined life evaluation test includes measuring at least one evaluation result selected from a voltage retention rate after a test of a storage battery, a capacity maintenance rate after the test, time to reach the end of life, a cycle number to reach the end of life, or a deterioration state when the end of life is reached, which is a target for prediction by the evaluation result prediction system and an evaluation result prediction device of the present disclosure.

The predetermined life evaluation test includes, for example a deterioration step of storing a storage battery for a fixed period (X) at a predetermined temperature or repeating a fixed number (Y) of charge-discharge cycles at a predetermined temperature, and an evaluation step of measuring an evaluation result. The evaluation step includes, for example, measuring a voltage retention rate, a capacity maintenance rate, or both of these of the storage battery after an end of (i) the deterioration step described above. In this way, the voltage retention rate after the test of the storage battery, the capacity maintenance rate after the test, or both of these can be acquired as an evaluation result. Instead of or in addition to (i), the evaluation step includes (ii) measuring time to reach the end of life or a cycle number to reach the end of life until a voltage retention rate or a capacity maintenance rate of the storage battery falls below a preset reference value, or the storage battery reaches a preset upper limit temperature. In this way, the time to reach the end of life, the cycle number to reach the end of life, or both of these of the storage battery can be acquired as an evaluation result.

More specifically, examples of the predetermined life evaluation test include a storage test and a cycle test of a storage battery defined by the IEC62660-1 (performance test) standardized by the International Electrotechnical Commission (IEC). The storage test of a storage battery in the IEC62660-1 includes a test for measuring a voltage retention rate, and a test for measuring a capacity maintenance rate. The test for measuring a voltage retention rate includes a deterioration step of adjusting a storage battery to 50% of a state of charge (SOC) on a predetermined condition, and storing the storage battery for 28 days (X = 28 days) at 45°C, and an evaluation step of measuring a voltage retention rate after the deterioration step described above. The test for measuring a capacity maintenance rate includes repetition three times in total (X = 126 days) of a deterioration step of adjusting a storage battery to 100% or 50% of a state of charge (SOC) on a predetermined condition, and storing the storage battery for 42 days at 45°C, and an evaluation step of measuring a capacity maintenance rate and the like of the storage battery after the deterioration step described above. Further, the cycle test of a storage battery in the IEC62660-1 includes a deterioration step of repeating a predetermined charge-discharge cycle for 28 days at 45°C, and an evaluation step of measuring a temperature and a capacity maintenance rate of the storage battery after the deterioration step described above. The number (Y) of the charge-discharge cycles repeated for 28 days is determined by a charge-discharge condition of the predetermined charge-discharge cycle. For example, when charging and discharging are performed at a current value of 1 C, and a charge-discharge pause time is 1 hour, 1 cycle requires 3 hours, and thus 224 cycles (Y = 224) are performed for 28 days. Repetition (X = 28 to 168 days, Y = 224 to 1344) of the deterioration step and the evaluation step described above until any one or more conditions that (i) the deterioration step is completed six times in total, (ii) a capacity maintenance rate of a storage battery is reached to 80%, or (iii) a temperature of the storage battery reaches a preset upper limit temperature are satisfied is included.

### <Predetermined Charge-discharge Protocol>

The predetermined charge-discharge protocol is a charge-discharge protocol for measuring energy density and/or power density being a target for prediction by the evaluation result prediction system and the evaluation result prediction device of the present disclosure, and includes successively measuring energy density and/or power density. The predetermined charge-discharge protocol is formed of a plurality of measurement steps different in temperature, different in a charge process or a discharge process, different in current value (C rate), or different in two or more of these.

The predetermined charge-discharge protocol may successively include, for example, an energy density measurement step of measuring energy density by discharging a storage battery at a first temperature and a first current value (C rate), and one or a plurality of power density measurement steps of adjusting the storage battery to a target charge rate by a charge or discharge process different from the energy density measurement step, and measuring power density at the target charge rate by causing a maximum current value Iₘₐₓ to be output. The energy density measurement step and the one or the plurality of power density measurement steps are performed in different charge-discharge steps being different in temperature, different in a charge process or a discharge process, different in current value (C rate), or different in two or more of these. The power density measurement step may include, for example, a plurality of power density measurement steps of measuring power density at first to n-th different temperatures (n is an integer of 2 or more) and at one or a plurality of target charge rates.

More specifically, examples of the predetermined charge-discharge protocol include a test for measuring energy density and power density being defined by the IEC62660-1 (performance test) standardized by the International Electrotechnical Commission (IEC). When energy density and power density of a battery are measured based on a method defined by the IEC62660-1, for example, the following steps need to be performed. The following steps are successively included, which are (1) a step of adjusting a storage battery to an SOC of 100% on a predetermined condition, and measuring energy density by discharging the storage battery from the SOC of 100% to 0% at 25°C (first temperature) and a current value of 1/3 C (first current value), (2) a step of charging the storage battery to the SOC of 20% at 25°C (first temperature), and measuring power density at 25°C and the SOC of 20% by causing the maximum current value Iₘₐₓ to be output for 10 seconds, (3) a step of charging the storage battery to the SOC of 50% at 25°C (first temperature), and measuring power density at 25°C and the SOC of 50% by causing the maximum current value Iₘₐₓ to be output for 10 seconds, (4) a step of charging the storage battery to the SOC of 80% at 25°C (first temperature), and measuring power density at 25°C and the SOC of 80% by causing the maximum current value Iₘₐₓ to be output for 10 seconds, (5) a step of discharging the storage battery to the SOC of 50% at -20°C (second temperature), and measuring power density at -20°C and the SOC of 50% by causing the maximum current value Iₘₐₓ to be output for 10 seconds, (6) a step of adjusting the storage battery to the SOC of 50% at 0°C (third temperature), and measuring power density at 0°C and the SOC of 50% by causing the maximum current value Iₘₐₓ to be output for 10 seconds, and (7) a step of adjusting the storage battery to the SOC of 50% at 45°C (fourth temperature), and measuring power density at 45°C and the SOC of 50% by causing the maximum current value Iₘₐₓ to be output for 10 seconds. An example of the charge-discharge protocol conforming to the IEC62660-1 described above is shown in Table 1 below.

**[Table 1]**

| STEP | CHARGE-DISCHARGE CONDITION | | | | EVALUATION RESULT |
|---|---|---|---|---|---|
| | SOC | TEMPERATURE | CURRENT | TIME | |
| (1) | 100%-0% | 25°C | 1/3 C | 3h | E DENSITY AT 25°C |
| (2) | 20% | 25°C | Imax | 10s | P DENSITY AT 25°C (SOC 20%) |
| (3) | 50% | 25°C | Imax | 10s | P DENSITY AT 25°C (SOC 50%) |
| (4) | 80% | 25°C | Imax | 10s | P DENSITY AT 25°C (SOC 80%) |
| (5) | 50% | -20°C | Imax | 10s | P DENSITY AT -20°C (SOC 50%) |
| (6) | 50% | 0°C | Imax | 10s | P DENSITY AT 0°C (SOC 50%) |
| (7) | 50% | 45°C | Imax | 10s | P DENSITY AT 45°C (SOC 50%) |

In step (1), since the current value is 1/3 C, time for discharging is about 3 hours, and time for discharging in steps (2) to (7) is each 10 seconds. However, several hours are required to adjust a storage battery to a predetermined temperature and an SOC before each step is performed, and it takes about 3 days in total to end the entire charge-discharge protocol.

### <Evaluation Charge-discharge Protocol>

The evaluation charge-discharge protocol is a protocol for charging and discharging a storage battery being an evaluation target for prediction processing by the evaluation result prediction system and the evaluation result prediction device, and includes a charge-discharge process of performing measurement of energy density and power density. The evaluation result prediction system and the evaluation result prediction device acquire not only test condition data of a life evaluation test but also charge-discharge data on a storage battery during the life evaluation test, use an explanatory variable extracted from the test condition data and the charge-discharge data for evaluation prediction processing, and can thus quickly and accurately predict an evaluation result in the middle of the life evaluation test. Thus, time for the life evaluation test of the storage battery can be shortened. The evaluation charge-discharge protocol may successively perform measurement of energy density and power density, or may perform the measurement by a single charge-discharge process. The measurement of energy density and power density is preferably performed by the single charge-discharge process from viewpoints of reducing an influence on the life evaluation test of a storage battery and shortening time for the life evaluation test.

For the single charge-discharge process, power density is measured when, for example, a target charge rate is reached in a process of the discharge process for measuring energy density, and thus the measurement can be performed by the single discharge process. More specifically, the single charge-discharge process may include, for example, measuring energy density by discharging a storage battery at a predetermined temperature and a predetermined current value (C rate). When prediction of an evaluation result including energy density and/or power density by the predetermined charge-discharge protocol is performed, the single charge-discharge process may include, for example, measuring the energy density by discharging a storage battery at a first temperature same as the first temperature of the predetermined charge-discharge protocol and a second current value (C rate) greater than the first current value (C rate) of the predetermined charge-discharge protocol. When the second current value (C rate) is greater than the first current value (C rate), time for discharging is shortened, and thus time for a performance evaluation test of the storage battery can be further shortened. Then, steps of measuring the power density at a target charge rate by causing the maximum current value Iₘₐₓ to be temporarily output when a charge rate reaches the target charge rate in a process of the discharging, then returning the current value to the predetermined current value again, and continuing the discharging may be included. The evaluation charge-discharge protocol may include a plurality of target charge rates, and can perform measurement of the power density described above each time each of the target charge rates is reached. In this way, measurement of the energy density and the one or the plurality of power densities can be performed by the single discharge process. The predetermined temperature may be the same temperature as a temperature in the predetermined life evaluation test being a target for prediction. When the predetermined current value (C rate) is great, time for discharging is shortened, and thus time for the evaluation prediction processing of a storage battery can be further shortened. A lower limit value of the predetermined current value (C rate) can be set to, for example, 1/3 C or more, 1/2 C or more, or 1 C or more, and an upper limit value can be set to, for example, 2 C or less, or 1.5 C or less. When prediction of an evaluation result including energy density and/or power density by the predetermined charge-discharge protocol is performed, in the single charge-discharge process, for example, a lower limit value of the second current value (C rate) can be set to, for example, 1.5 times or more, 2.0 times or more, 2.5 times or more, 3.0 times or more, or 3.5 times or more the first current value (C rate), and an upper limit value can be set to, for example, 5.0 times or less, 4.5 times or less, or 4.0 times or less the first current value (C rate). A lower limit value of the maximum current value Iₘₐₓ can be set to, for example, 1 C or more, 2 C or more, or 3 C or more, and an upper limit value can be set to, for example, 5 C or less, 4 C or less, or 3 C or less.

The evaluation charge-discharge protocol preferably includes first to m-th (m is an integer of 2 or more) evaluation charge-discharge protocols including performing measurement of energy density and power density by one or a plurality of single charge-discharge processes for each fixed period X' shorter than the period X in which a storage battery is stored in the predetermined life evaluation test during the life evaluation test or for each fixed number Y' of charge-discharge cycles smaller than the charge-discharge cycle number Y performed in the predetermined life evaluation test. When the evaluation charge-discharge protocol includes such a plurality of evaluation charge-discharge protocols, the evaluation result prediction system and the evaluation result prediction device may be configured to acquire a predicted evaluation result each time the evaluation charge-discharge protocol is performed, and compute prediction accuracy. A frequency with which the evaluation charge-discharge protocol is performed can be appropriately set from a viewpoint of shortening time for the evaluation prediction processing, a viewpoint of acquiring high prediction accuracy, a viewpoint of not having a great influence on the life evaluation test, and the like. The frequency (period) X' with which the evaluation charge-discharge protocol is performed may be set to 1/2 or less, 1/3 or less, 1/4 or less, 1/5 or less, 1/10 or less, 1/15 or less, or 1/20 or less of the period X in which a storage battery is stored in the predetermined life evaluation test. The frequency (cycle number) Y' with which the evaluation charge-discharge protocol is performed may be set to 1/2 or less, 1/3 or less, 1/4 or less, 1/5 or less, 1/10 or less, 1/15 or less, or 1/20 or less of the cycle number Y in the predetermined life evaluation test. The number of times the evaluation charge-discharge protocol is performed is preferably a greater number of times the evaluation charge-discharge protocol is performed (i.e., the life evaluation test continues longer) from a viewpoint of acquiring higher prediction accuracy. However, from a viewpoint of shortening time for the evaluation prediction processing, as described below, the evaluation charge-discharge protocol preferably ends (i.e., the life evaluation test ends) at a point in time at which prediction accuracy desired by a user is acquired.

When the predetermined charge-discharge protocol includes measuring energy density and/or power density at first to n-th different temperatures (n is an integer of 2 or more), the evaluation charge-discharge protocols may each include first to n-th single charge-discharge processes (n is an integer of 2 or more) of performing the single charge-discharge process at the corresponding first to n-th different temperatures, respectively. An order in which the first to n-th single charge-discharge processes are performed may correspond to a measurement order in the predetermined charge-discharge protocol, or may be any order that does not correspond to the measurement order. For example, the order in which the first to n-th single charge-discharge processes are performed can be constituted in an order in which prediction accuracy by a learned model further increases or temperature adjustment ends in a shorter time. When the evaluation charge-discharge protocol includes the first to n-th single charge-discharge processes, all of the first to n-th single charge-discharge processes are preferably performed from a viewpoint of acquiring higher prediction accuracy. However, from a viewpoint of shortening time for the evaluation prediction processing, all of the single charge-discharge processes do not need to be performed, and the evaluation charge-discharge protocol preferably ends at a point in time at which prediction accuracy desired by a user is acquired.

When prediction of an evaluation result by the predetermined charge-discharge protocol is performed in prediction of the predetermined life evaluation test, the first to m-th evaluation charge-discharge protocols described above may be performed for each period or each fixed number of charge-discharge cycles, and the evaluation charge-discharge protocols may each include the first to n-th single charge-discharge processes described above.

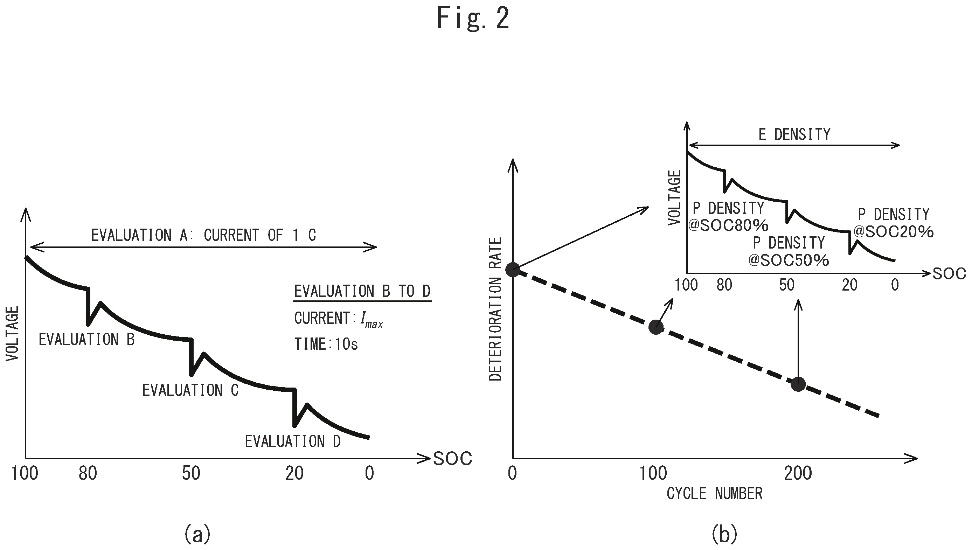

FIG. 2A is a diagram illustrating an example of the single discharge process in the evaluation charge-discharge protocol. The single discharge process in FIG. 2A includes measuring energy density of a storage battery being an evaluation target having an SOC adjusted to 100% by discharging the storage battery at a current value of 1 C until the SOC reaches 0% from 100% (evaluation A). Further, the single discharge process includes: measuring power density at the SOC of 80% by causing the maximum current value Iₘₐₓ being a current value of 2 C or more to be output for 10 seconds when the SOC of the storage battery reaches 80% in a process of performing Evaluation A; causing discharging to pause for one minute; and then continuing discharging at the current value of 1 C again (Evaluation B). The single discharge process includes performing a similar operation when the SOC of the storage battery reaches 50% and reaches 20%, and measuring power density at the SOC of 50% and 20% (evaluation C and evaluation D).

The evaluation charge-discharge protocol may include, first, performing the single discharge process illustrated in FIG. 2A on a storage battery in a brand-new state when the life evaluation test starts, and then performing the single discharge process for each fixed period (X') shorter than a period (X) in which the storage battery is stored in the predetermined life evaluation test or for each fixed number (Y') of charge-discharge cycles smaller than a charge-discharge cycle number (Y) performed in the predetermined life evaluation test. By performing the single discharge process when the life evaluation test starts, charge-discharge data on the storage battery in the brand-new state can be acquired, and an electrochemical parameter such as, for example, energy density, power density, and discharge capacity in the brand-new state can be computed from the acquired charge-discharge data. For example, when an evaluation result of a storage test (X = 28 days or 42 days) of a storage battery in the IEC62660-1 is set as a prediction target, the evaluation charge-discharge protocol may include performing the single discharge process illustrated in FIG. 2A at 45°C and, for example, every 14 days, every 7 days, every 4 days, every 2 days, or every day. When an evaluation result of a cycle test of a storage battery in the IEC62660-1 is set as a prediction target, the evaluation charge-discharge protocol may include performing the single discharge process illustrated in FIG. 2A at 45°C and, for example, every 100 cycles, every 50 cycles, every 25 cycles, every 20 cycles, or every 10 cycles. In this way, a predicted evaluation result and prediction accuracy can be acquired for each fixed period or each fixed number of charge-discharge cycles, and the evaluation charge-discharge protocol can end (i.e., the life evaluation test can end) at a point in time at which prediction accuracy desired by a user is acquired, and thus a subsequent life evaluation test does not need to be performed. Thus, time for the life evaluation test can be significantly shortened. For example, FIG. 2B is a diagram illustrating an example of the evaluation charge-discharge protocol including performing the single discharge process for each fixed number of charge-discharge cycles. FIG. 2B illustrates that the single discharge process in FIG. 2A described above is first performed on a storage battery in a brand-new state when the life evaluation test starts, and the single discharge process is then performed for each charge-discharge cycle number (for example, Y' = 100) smaller than a charge-discharge cycle number performed in the cycle test of the storage battery in the IEC62660-1.

The evaluation charge-discharge protocol may include first to n-th single charge-discharge processes (n is an integer of 2 or more) of performing the single discharge process illustrated in FIG. 2A at first to n-th different temperatures. For example, when an evaluation result of the IEC62660-1 as the predetermined charge-discharge protocol is set as a prediction target, the evaluation charge-discharge protocol includes four single charge-discharge processes of performing the single discharge process illustrated in FIG. 2A at each of 25°C (first temperature), -20°C (second temperature), 0°C (third temperature), and 45°C (fourth temperature). When an order of the charge-discharge processes is constituted in an ascending order of prediction accuracy by a learned model, the order may be constituted in an order of, for example, a first single charge-discharge process at 25°C (first temperature), a second single charge-discharge process at -20°C (second temperature), a third single charge-discharge process at 45°C (fourth temperature), and a fourth single charge-discharge process at 0°C (third temperature). An example of electrochemical parameters acquired by the first to fourth single charge-discharge processes, and accumulated prediction accuracy is shown in Table 2.

**[Table 2]**

| CHARGE-DISCHARGE PROCESS | CHARGE-DISCHARGE CONDITION | | | | ACQUIRED ELECTROCHEMICAL PARAMETER | ACCUMULATED PREDICTION ACCURACY |
|---|---|---|---|---|---|---|
| | SOC | TEMPERATURE | "EVALUATION A" CURRENT | TIME | | |
| FIRST | 100%-0% | 25°C | 1 C | 1h | E DENSITY, P DENSITY (SOC 80%, 50%, 20%), AND VOLTAGE RELAXATION AT 25°C | 30%-40% |
| SECOND | 100%-0% | -20°C | 1 C | 1h | E DENSITY, P DENSITY (SOC 80%, 50%, 20%), AND VOLTAGE RELAXATION AT -20°C | 60%-70% |
| THIRD | 100%-0% | 45°C | 1 C | 1h | E DENSITY, P DENSITY (SOC 80%, 50%, 20%), AND VOLTAGE RELAXATION AT 45°C | 75%-85% |
| FOURTH | 100%-0% | 0°C | 1 C | 1h | E DENSITY, P DENSITY (SOC 80%, 50%, 20%), AND VOLTAGE RELAXATION AT 0°C | 80%-90% |

When the evaluation charge-discharge protocol including the first to fourth single charge-discharge processes described above is compared with a test of the IEC62660-1 as the predetermined charge-discharge protocol, a current value of 1 C in Evaluation A is three times a current value of 1/3 C in the energy density step in the IEC62660-1, and thus a discharge time can be shortened to 1/3 (1 hour). Further, since the evaluation charge-discharge protocol performs Evaluations B to D of power density in a process of performing Evaluation A of energy density, time for the power density measurement step in the IEC62660-1 can be greatly shortened. Furthermore, for the evaluation charge-discharge protocol, the evaluation charge-discharge protocol is controlled to end at a point in time at which prediction accuracy desired by a user is acquired. For example, when prediction accuracy desired by a user is 80%, and the prediction accuracy exceeds 80% at a point in time at which the third single charge-discharge process ends, the evaluation charge-discharge protocol ends at the point in time, and thus time for performing the fourth single charge-discharge process can be omitted. It should be noted that, even when all of the first to fourth single charge-discharge processes described above are performed, time for the evaluation charge-discharge protocol is less than 1 day (including an adjustment time of the storage battery between the plurality of single charge-discharge processes).

### <Charge-discharge Device>

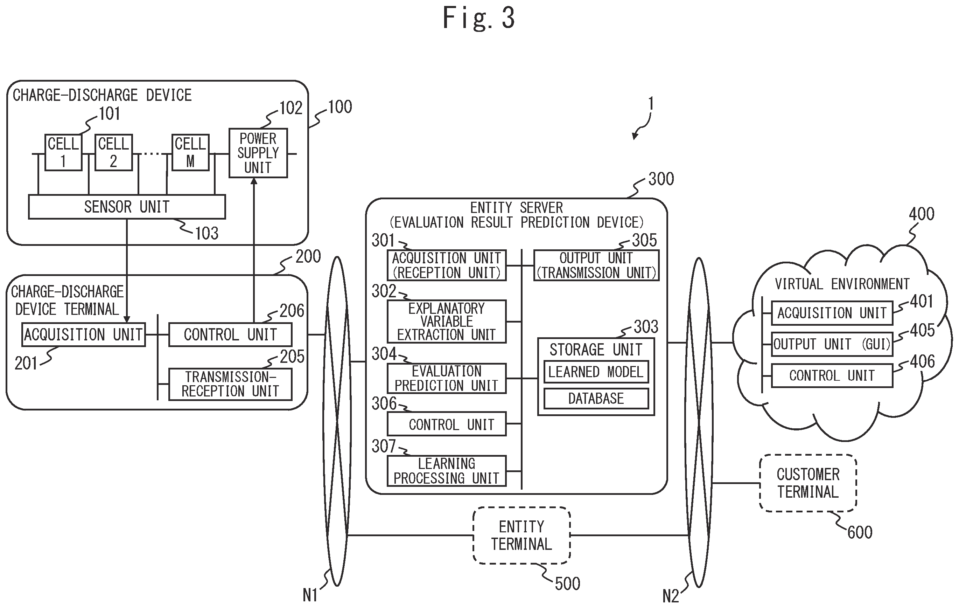

FIG. 3 is a diagram illustrating an example of the evaluation result prediction system 1 according to the embodiment of the present disclosure in FIG. 1. In FIG. 3, the charge-discharge device 100 includes one or a plurality of storage batteries 101 (cell 1 to cell M) connected in series or parallel, a power supply unit 102 electrically connected to the storage battery, and a sensor unit 103 that measures test condition data and charge-discharge data on each of the storage batteries. The charge-discharge device 100 further includes a temperature adjustment device (not illustrated), and can adjust a temperature of a surrounding environment of the storage battery that is charged and discharged to any temperature.

The storage battery 101 is a secondary battery that can repeatedly perform charging and discharging, such as a lithium-ion secondary battery (LiB), a lead storage battery, and a nickel-hydrogen secondary battery, for example, and is preferably an LiB. When the charge-discharge device 100 includes the plurality of storage batteries, each of the storage batteries can be individually controlled. For example, control can be performed in such a way as to determine whether to continue a test for each of the storage batteries by, for example, stopping the charge-discharge protocol for only a part of the storage batteries and continuing the charge-discharge protocol of the other storage batteries according to a content of the acquired charge-discharge data and the like. The storage battery 101 may perform disassembly analysis and apparatus analysis after an evaluation ends, and thus acquire material analysis data at the point in time. When the material analysis data are not acquired, the storage battery 101 may be returned to the user, or may be used for acquiring additional charge-discharge data and/or material analysis data by further continuing the life evaluation test and performing the evaluation charge-discharge protocol and/or material analysis, or may be used for acquiring new supervised data (evaluation result) by further performing the predetermined charge-discharge protocol. The power supply unit 102 can execute the evaluation charge-discharge protocol on the storage battery. When the supervised data in creation of a database described below are acquired, the power supply unit 102 can also perform the predetermined life evaluation test or the predetermined charge-discharge protocol on the storage battery.

The sensor unit 103 is, for example, a voltage sensor, an ammeter, a temperature sensor, and the like. Examples of the test condition data measured by the sensor unit 103 include a temperature, a current value, a voltage (for example, an upper limit voltage and a lower limit voltage), and a charge-discharge pause time of a storage battery, a time change in these, data acquired by mathematically processing these, and the like. Examples of the charge-discharge data measured by the sensor unit 103 include, for example, a voltage, a current, and a temperature of a storage battery, a time change in these, data acquired by mathematically processing these, and the like. Measurement of the test condition data and the charge-discharge data in the sensor unit 103 may be performed by any method. For example, when a voltage value is measured, the voltage value can be measured by attaching a terminal of a voltage sensor to a positive electrode terminal and a negative electrode terminal of a storage battery being a target. When a current value is measured, the current value can be measured by attaching an ammeter to a wiring line being a target. Further, when a temperature is measured, the temperature can be measured by attaching a temperature sensor to a storage battery being a target. The test condition data and the charge-discharge data acquired by the sensor unit 103 are transmitted to the charge-discharge device terminal 200.

### <Charge-discharge Device Terminal>

In FIG. 3, the charge-discharge device terminal 200 includes an acquisition unit 201 that acquires the charge-discharge data on each storage battery measured by the sensor unit 103 of the charge-discharge device 100, a transmission-reception unit 205 that transmits and receives the charge-discharge data, a charge-discharge control instruction, and the like to and from the entity server 300 and the entity terminal 500 via the network N1, and a control unit 206 that controls the power supply unit 102 of the charge-discharge device 100, based on the charge-discharge control instruction. Functional units such as the acquisition unit, the transmission-reception unit, and the control unit are mutually connected via a bus, an interface unit, and/or the like. As the charge-discharge device terminal 200, for example, the charge-discharge device terminal 200 may be an information processing device such as a personal computer, a note PC, or a tablet PC connected to the charge-discharge device 100 in a one-to-one manner. Although FIGS. 1 and 3 illustrate a pair of the charge-discharge device 100 and the charge-discharge device terminal 200, the evaluation result prediction system 1 may include a plurality of pairs of the charge-discharge devices 100 and the charge-discharge device terminals 200.

The acquisition unit 201 of the charge-discharge device terminal 200 acquires the charge-discharge data from the charge-discharge device of the storage battery. The acquisition unit directly acquires (receives) the charge-discharge data from the charge-discharge device via wired connection or wireless connection. Alternatively, the acquisition unit may acquire (receive) the charge-discharge data via the network N1. The acquired charge-discharge data may be stored in a storage unit (not illustrated) of the charge-discharge device terminal 200.

The transmission-reception unit 205 of the charge-discharge device terminal 200 transmits the charge-discharge data to the acquisition unit (reception unit) 301 of the entity server 300 via the network N1. Alternatively, the transmission-reception unit may transmit the charge-discharge data to the acquisition unit (reception unit) 301 of the entity server 300 via wired connection or wireless connection. Further, the transmission-reception unit receives a command for controlling the charge-discharge device 100 from the entity server 300 via the network N1 or via wired connection or wireless connection.

The control unit 206 of the charge-discharge device terminal 200 can control the charge-discharge device 100 in such a way as to cause the power supply unit of the charge-discharge device to execute the charge-discharge cycle in the predetermined life evaluation test, the predetermined charge-discharge protocol, or the evaluation charge-discharge protocol of the storage battery. Further, the control unit 206 can control the power supply unit of the charge-discharge device in such a way that the evaluation charge-discharge protocol ends or continues, based on a command received from the entity server 300. Control of the power supply unit is performed based on a computer program (charge-discharge control software) stored in the storage unit (not illustrated) of the charge-discharge device terminal 200.

### <Entity Server>

The entity server 300 in FIG. 3 has functions as the "evaluation result prediction device" that predicts an evaluation result of the predetermined life evaluation test and/or predicts energy density and power density of the storage battery being successively measured by the predetermined charge-discharge protocol, and as a server. The entity server 300 may further have a function as a manipulable factor prediction device that predicts a manipulable factor being a factor in terms of design of the storage battery that influences life of the storage battery. The entity server 300 includes an acquisition unit (reception unit) 301 that acquires the test condition data, the charge-discharge data, the material analysis data, and the like on a storage battery, an explanatory variable extraction unit 302 that extracts a plurality of explanatory variables from the test condition data, the charge-discharge data, and the material analysis data, a storage unit 303 that stores a learned model (also referred to as a "learned model I" in the present disclosure) being learned in such a way as to output a predicted evaluation result when the plurality of explanatory variables are input, a database, and the like, an evaluation prediction unit 304 that acquires the predicted evaluation result by inputting the plurality of explanatory variables to the learned model, and computes prediction accuracy of the predicted evaluation result, and an output unit (transmission unit) 305 that outputs information including the predicted evaluation result and the prediction accuracy. The entity server 300 in FIG. 3 further includes a control unit 306 that outputs commands for (i) ending the evaluation charge-discharge protocol when the prediction accuracy is equal to or more than a predetermined threshold value, and (ii) continuing the evaluation charge-discharge protocol when the prediction accuracy is less than the predetermined threshold value. The entity server 300 in FIG. 3 further includes a learning processing unit 307 that can perform generation and relearning of the learned model.

Functional units such as the acquisition unit (reception unit), the explanatory variable extraction unit, the storage unit, the evaluation prediction unit, the output unit (transmission unit), the control unit, and the learning processing unit are mutually connected via a bus, an interface unit, and/or the like. The explanatory variable extraction unit, the evaluation prediction unit, the control unit, and the learning processing unit are implemented by one or a plurality of processing units, for example, a central processing unit (CPU), that performs a motion, based on a program stored in advance in the storage unit. As the processing unit, a digital signal processor (DSP), a large scale integration (LSI), an application specific integrated circuit (ASIC), a field-programmable gate array (FPGA), and the like may be used. The processing unit is connected to the acquisition unit (reception unit), the storage unit, the output unit (transmission unit), and the like, and controls each of the functional units.

The entity server may be formed of a single server, or may be formed of a plurality of servers that are mutually communicably connected. When the entity server is formed of a plurality of servers, each of the functional units may be implemented by each different server.

### Acquisition Unit (Reception Unit):

The acquisition unit (reception unit) 301 of the entity server 300 includes a wired communication interface circuit conforming to a communication protocol such as a transmission control protocol/Internet protocol (TCP/IP), and communicates with and is connected to the networks N1 and N2 according to communication standards such as Ethernet (registered trademark). It should be noted that the acquisition unit (reception unit) may include an antenna that transmits and receives a wireless signal, and a wireless communication interface circuit conforming to a communication protocol such as wireless LAN, and may communicate with and be connected to the networks N1 and N2 according to communication standards such as wireless LAN.

The acquisition unit (reception unit) acquires (receives) the test condition data and the charge-discharge data from the charge-discharge device terminal via the network N1. Alternatively, the acquisition unit (reception unit) may acquire (receive) the test condition data and the charge-discharge data from the charge-discharge device terminal via wired connection or wireless connection. The test condition data are specific test conditions of the life evaluation test, and include, for example, a temperature, a current value, a voltage (for example, an upper limit voltage and a lower limit voltage), a charge-discharge pause time, and the like of the storage battery. The test condition data may be test condition data as an actual measurement value being measured from the storage battery during execution of the life evaluation test, or may be test condition data as a set value. The test condition data as an actual measurement value are preferably acquired from a viewpoint of increasing prediction accuracy. When the test condition data as a set value are acquired, the acquisition unit (reception unit) may acquire (receive) the test condition data as the set value from the entity terminal 500 via the network N1 or from the customer terminal 600 via a virtual environment and the network N2. Alternatively, the acquisition unit (reception unit) may acquire the test condition data as the set value stored in advance in the storage unit (not illustrated) of the charge-discharge device terminal 200 or the storage unit 303 of the entity server 300. The charge-discharge data are charge-discharge data measured by executing the predetermined charge-discharge protocol on the storage battery, and examples of the charge-discharge data include, for example, a voltage, a current, and a temperature of the storage battery, a time change in these, data acquired by mathematically processing these, and the like. Furthermore, the acquisition unit (reception unit) acquires (receives) the material analysis data on the storage battery from the entity terminal 500 and the like via the network N1. The material analysis data are data acquired by analyzing a member (such as a positive electrode, a negative electrode, a separator, and an electrolyte solution) of the storage battery being a target, and a material constituting the member (such as a positive electrode active material, a negative electrode active material, a material of a separator, and a material of an electrolyte solution). The material analysis data may be in any form, and examples of the material analysis data include, for example, an X-ray diffraction (XRD) spectrum, a nuclear magnetic resonance (NMR) spectrum, an electron spin resonance (ESR) spectrum, a scanning electron microscope (SEM) image, an ion chromatography (IC) spectrum, or the like of a material constituting the storage battery. The acquired (received) test condition data, charge-discharge data, and material analysis data are stored in the storage unit 303 of the entity server.

### Explanatory Variable Extraction Unit:

The explanatory variable extraction unit 302 of the entity server 300 extracts a plurality of explanatory variables used as an input of the learned model from the test condition data, the charge-discharge data, and the material analysis data stored in the storage unit. When an evaluation result of the predetermined life evaluation test is predicted, the plurality of explanatory variables include one or a plurality of test condition parameters selected from the test condition data, and an electrochemical parameter acquired by electrochemically analyzing the charge-discharge data. The plurality of explanatory variables freely further include one or a plurality of mathematical parameters acquired by mathematically processing a shape of a discharge curve in a charge-discharge process. The plurality of explanatory variables freely further include one or a plurality of material analysis parameters acquired by mathematically processing the material analysis data on the storage battery. When an evaluation result of the predetermined charge-discharge protocol is predicted, the plurality of explanatory variables include an electrochemical parameter acquired by electrochemically analyzing the charge-discharge data, and freely further include one or a plurality of mathematical parameters acquired by mathematically processing a shape of a discharge curve in a charge-discharge process.

As the test condition parameter, the test condition data can be used as they are as the test condition parameter without processing. In other words, the test condition parameter can be selected from a temperature, a current value, a voltage (for example, an upper limit voltage and a lower limit voltage), and a charge-discharge pause time of the storage battery in the life evaluation test. However, a parameter acquired by mathematically processing the test condition data may be freely used as the test condition parameter.

The electrochemical parameter includes energy density and power density, and freely further includes data one at least one selected from voltage relaxation behavior or a capacity maintenance rate. The electrochemical parameter can be extracted by electrochemically analyzing the charge-discharge process of the evaluation charge-discharge protocol. For example, the energy density can be computed by the following equation: weight energy density (Wh/kg) = integrated current capacity (Wh)/battery weight (kg) or the following equation: volume energy density (Wh/L) = integrated current capacity (Wh)/battery volume (L) from the integrated current capacity (Wh) and the battery weight (kg) or the battery volume (L) when the storage battery is discharged from an SOC of 100% to 0%. The power density can be computed by the following equation: weight power density (W/kg) = voltage drop (V) × current value Iₘₐₓ (A)/battery weight (kg) or the following equation: volume power density (W/L) = voltage drop (V) × current value Iₘₐₓ (A)/battery volume (L) from the voltage drop (V) and the battery weight (kg) or the battery volume (L) after discharging when the maximum current value Iₘₐₓ (A) is temporarily output. It should be noted that the battery weight (kg) or the battery volume (L) is acquired separately from the charge-discharge data. For example, these pieces of information are measured before the storage battery is connected to the charge-discharge device 100, and a measurement value is input to the charge-discharge device terminal 200 or the entity terminal 500. The information on the battery weight (kg) or the battery volume (L) is transmitted from the charge-discharge device terminal 200 or the entity terminal 500 to the acquisition unit (reception unit) 301 of the entity server 300 via the network N1. The entity server 300 may store the acquired (received) information on the battery weight (kg) or the battery volume (L) in the storage unit 303. Then, the explanatory variable extraction unit 302 of the entity server 300 uses the information on the battery weight (kg) or the battery volume (L) for computation of the energy density and the power density as described above. The voltage relaxation behavior is acquired by setting a parameter of behavior in which an overvoltage is relaxed when the maximum current value Iₘₐₓ is output and then charging and discharging are temporarily caused to pause, and the voltage relaxation behavior is computed by, for example, the following equation: voltage relaxation (V) = voltage (V) after charging and discharging are caused to pause for 1 minute - voltage (V) after maximum current value Iₘₐₓ is output. For example, when the evaluation charge-discharge protocol shown in Table 2 described above is used, the energy density, the power density at the SOC of 80%, the SOC of 50%, and the SOC of 20%, and the voltage relaxation behavior at each temperature are acquired from the first to fourth single charge-discharge processes. The capacity maintenance rate can be computed by the following equation: capacity maintenance rate = (discharge capacity of storage battery at point in time of measurement in life evaluation test/discharge capacity of storage battery at time of start of life evaluation test) × 100 from a discharge capacity (for example, an integrated current capacity when discharging is performed from the SOC of 100% to 0%) of the storage battery in a brand-new state (at the time of the start of the life evaluation test) and a discharge capacity of the storage battery at the point in time of measurement in the life evaluation test (for example, a point in time at which the single charge-discharge process of the evaluation charge-discharge protocol is executed) in an execution condition of the life evaluation test. For example, when the evaluation charge-discharge protocol including performing the single charge-discharge process illustrated in FIG. 2A for each fixed period or each fixed number of charge-discharge cycles is used, the energy density, the power density at the SOC of 80%, the SOC of 50%, and the SOC of 20%, the voltage relaxation behavior, and the capacity maintenance rate are acquired from each single charge-discharge process.

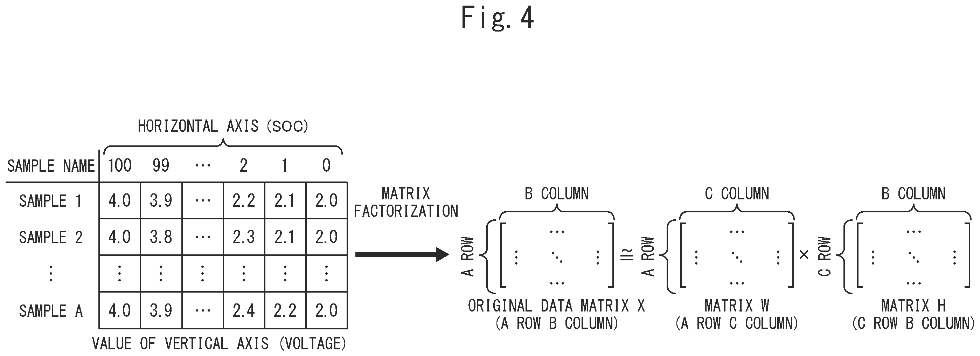

The mathematical parameter can be extracted by mathematically processing a shape of a discharge curve in the charge-discharge process. The mathematical parameter includes, for example, data acquired by mathematically processing a discharge curve freely combining a voltage of the storage battery on a vertical axis, and a time, a current capacity, an SOC, and the like on a horizontal axis. More specifically, first, for discharge curve data in which a value of an SOC of the storage battery being an evaluation target is the horizontal axis and a value of a voltage (V) corresponding to the value of the SOC is the vertical axis, a matrix X with 1 row and B columns acquired by arranging, as elements, values of the voltage (V) corresponding to values of B (B ≥ 2) different SOCs in a column direction is acquired as the mathematical parameter. The number B of values of the SOCs to be adopted is about 10 to 1,000, and corresponds to the number B of values of the SOCs used for generation of the learned model. For example, as illustrated in FIG. 4, when values of the SOCs are divided into 1% increments from 100% to 0%, B is 101 in total of 100%, 99%, 98%, ..., 2%, 1%, and 0%. The reason why the number of rows of the matrix X is 1 is that the evaluation prediction processing is performed on one storage battery (for each storage battery). Next, a mathematical constraint is imposed, and the matrix X is then factorized into X ≈ W × H (in the equation, a matrix W is a coefficient matrix with 1 row and C columns, and a matrix H is a basis matrix with C rows and B columns). The mathematical constraint is determined in such a way that the matrix W and the matrix H are uniquely decided. C corresponds to C used for generation of the learned model, and is, for example, equal to or less than the same number as the number B of values of the SOCs. As a method of the matrix factorization, principal component analysis, non-negative matrix factorization, and the like can be used. Then, one or a plurality of explanatory variables can be selected from among C coefficients (referred to as a "first principal component" to a "C-th principal component" in an order from a first column) in the matrix W.

The material analysis parameter can be acquired by mathematically processing the material analysis data on the storage battery, for example, an X-ray diffraction (XRD) spectrum, a nuclear magnetic resonance (NMR) spectrum, an electron spin resonance (ESR) spectrum, a scanning electron microscope (SEM) image, an ion chromatography (IC) spectrum, or the like of a material constituting the storage battery. Examples of a method for acquiring the material analysis parameter from the material analysis data include the following processing (1) to (3).

The processing (1) is a method for acquiring a material analysis parameter from a spectrum such as the XRD, the NMR, the ESR, and the IC. First, a matrix Y with 1 row and E columns (E is the number of elements, and E ≥ 2) is acquired by arranging spectrum data in a brand-new state and spectrum data at a point in time of analysis as elements in the column direction. At this time, a difference between the spectrum data in the brand-new state and the spectrum data at the point in time of the analysis may be used. The number E of the elements to be adopted is about 10 to 1,000, and corresponds to the division number E in a horizontal axial direction of the spectrum data before matrix factorization. The reason why the number of rows of the matrix Y is 1 is that the evaluation prediction processing is performed on one storage battery (for each storage battery). Next, a mathematical constraint is imposed, and the matrix Y is then factorized into Y ≈ V × I (in the equation, a matrix V is a coefficient matrix with 1 row and F columns, and a matrix I is a basis matrix with F rows and E columns). The mathematical constraint is determined in such a way that the matrix V and the matrix I are uniquely decided. F is, for example, equal to or less than the same number as the number E of the elements. As a method of the matrix factorization, principal component analysis, non-negative matrix factorization, and the like can be used. For example, when the principal component analysis is executed, F coefficients (referred to as a "first principal component" to a "C-th principal component" in an order from a first column) in the matrix V can be acquired as material analysis parameters. Then, one or a plurality of explanatory variables can be selected from among the acquired material analysis parameters.

The processing (2) is another method for acquiring a material analysis parameter from a spectrum such as the XRD, the NMR, the ESR, and the IC. First, parameters that are characteristics of a curve shape, for example, intensity, an integral value, a half-value width, and the like of a peak that characterize a material being an analysis target are calculated from each of spectrum data in a brand-new state and spectrum data at a point in time of analysis. Moreover, for example, a difference between a parameter in the brand-new state and a parameter at the point in time of the analysis is taken, and the acquired difference can be acquired as a material analysis parameter. Then, one or a plurality of explanatory variables can be selected from among the acquired material analysis parameters.

The processing (3) is a method for acquiring a material analysis parameter from image data such as the SEM image. First, image data in a brand-new state and image data at a point in time of analysis are each subjected to filter processing such as a Gaussian filter, and noise is removed. Next, binarization processing such as Otsu's binarization is performed, and a characteristic parameter such as an area ratio between a light portion and a dark portion, and circularity is computed. Moreover, for example, a difference between a parameter in the brand-new state and a parameter at the point in time of the analysis is taken, and the acquired difference can be acquired as a material analysis parameter. Then, one or a plurality of explanatory variables can be selected from among the acquired material analysis parameters.

The explanatory variable may be one preselected in such a way as to improve prediction accuracy by the learned model and/or improve interpretability for a predicted evaluation result. More specifically, the explanatory variable may be one preselected by eliminating one or a plurality of parameters having multicollinearity with the other parameter when the learned model is generated.

For example, when the evaluation charge-discharge protocol shown in Table 2 described above is used, and B = C = 101 as exemplified in FIG. 4, 106 parameters in total of five electrochemical parameters (energy density, power density of the SOC of 80%, power density of the SOC of 50%, power density of the SOC of 20%, and voltage relaxation behavior) and 101 (first principal component to 101-st principal component) mathematical parameters can be extracted from one single charge-discharge process for a storage battery being an evaluation target. When all of the first to fourth single charge-discharge processes are executed, 424 parameters in total in which 4 temperatures × 106 are extracted. All of these parameters may be used as input variables of the learned model, but, when a plurality of parameters having a strong correlation with each other are included, prediction accuracy and/or interpretability decreases instead due to multicollinearity. Thus, prediction accuracy and/or interpretability can be improved by using, as an input variable, a preselected explanatory variable in which one or a plurality of parameters having multicollinearity with the other parameter is eliminated manually or by using some sort of variable selection technique. For example, Table 3 below shows examples of the preselected explanatory variables when the evaluation charge-discharge protocol shown in Table 2 described above is used. The charge-discharge data acquired by executing the evaluation charge-discharge protocol are subjected to matrix factorization by using principal component analysis as described below, and each obtained principal component is set as a candidate for an explanatory variable. The combinations of the explanatory variables, and prediction accuracy shown in Table 3 below are merely exemplifications.

**[Table 3]**

| CHARGE-DISCHARGE PROCESS | TEMPERATURE | PRESELECTED EXPLANATORY VARIABLE | ACCUMULATED PREDICTION ACCURACY |
|---|---|---|---|
| FIRST | 25°C | E DENSITY, P DENSITY (SOC 80%), AND FIRST PRINCIPAL COMPONENT TO FIFTH PRINCIPAL COMPONENT | 40% |
| SECOND | -20°C | E DENSITY, P DENSITY (SOC 50%), AND FIRST PRINCIPAL COMPONENT TO FOURTH PRINCIPAL COMPONENT | 70% |
| THIRD | 45°C | E DENSITY, P DENSITY (SOC 20%), AND FIRST PRINCIPAL COMPONENT TO THIRD PRINCIPAL COMPONENT | 85% |
| FOURTH | 0°C | P DENSITY (SOC 80%), AND FIRST PRINCIPAL COMPONENT TO SECOND PRINCIPAL COMPONENT | 90% |

As in Table 3 shown above, prediction accuracy required by a user can be acquired by fewer charge-discharge processes by using the preselected explanatory variable, and thus time for the evaluation prediction processing is further shortened. For example, when prediction accuracy desired by a user is 80%, the evaluation charge-discharge protocol ends at a point in time at which the third single charge-discharge process ends, and time for performing the fourth single charge-discharge process can be omitted. Further, by using the preselected explanatory variable, a factor contributing to a target variable is easily recognized, and interpretability of a computation result by machine learning improves.

Examples of a combination of explanatory variables include: for example, one or a plurality of test condition parameters and one or a plurality of electrochemical parameters; one or a plurality of test condition parameters, one or a plurality of electrochemical parameters, and one or a plurality of mathematical parameters; one or a plurality of test condition parameters, one or a plurality of electrochemical parameters, and one or a plurality of material analysis parameters; one or a plurality of test condition parameters, one or a plurality of electrochemical parameters, one or a plurality of mathematical parameters, and one or a plurality of material analysis parameters; and the like. In such a manner, by using a multimodal learned model acquired by learning different characteristic data acquired from a plurality of information sources, a (white-box) predicted evaluation result having high interpretability based on rules and principles of deterioration of storage batteries can be acquired. Further, prediction accuracy of a predicted evaluation result further improves by using a learned model acquired by simultaneously learning (multitasking-learning) a plurality of related explanatory variables. Among the combinations of the explanatory variables described above, the combination including the test condition parameter, the electrochemical parameter, and the material analysis parameter is preferable in a point that a prediction result achieving both of prediction accuracy and interpretability can be acquired, even from little data.

### Storage Unit:

The storage unit 303 of the entity server 300 includes a memory device such as a random access memory (RAM) and a read only memory (ROM), a fixed disk device such as a hard disk, a portable storage device such as a flexible disk and an optical disk, or the like. The storage unit can store a computer program used for various types of processing of the entity server 300, acquired charge-discharge data, a learned model, a database used for learning processing of the learned model, and the like. The computer program may be installed onto the storage unit from a computer-readable portable recording medium by using a known setup program and the like. The portable recording medium is, for example, a compact disc read only memory (CD-ROM), a digital versatile disc read only memory (DVD-ROM), and the like. The computer program may be stored in the recording medium included in a predetermined server, and may be installed via the network N1 and/or N2.

In a case where an evaluation result of the predetermined life evaluation test is predicted, the learned model is learned in such a way as to output a predicted evaluation result including an evaluation result that may be acquired if the predetermined life evaluation test is performed, and predicted deterioration information on a storage battery at a time at which the end of life is reached, when a plurality of explanatory variables extracted from charge-discharge data on the storage battery are input. In a case where an evaluation result of the predetermined charge-discharge protocol is predicted, the learned model is learned in such a way as to output a predicted evaluation result including energy density and power density being measured by the predetermined charge-discharge protocol when a plurality of explanatory variables extracted from charge-discharge data on the storage battery are input. The learned model may be learned in such a way as to be able to predict an evaluation result of the predetermined life evaluation test and predict an evaluation result of the predetermined charge-discharge protocol. As described above, the plurality of explanatory variables may be preselected explanatory variables.

The database stores a data set used for generation of the learned model. In a case where an evaluation result of the predetermined life evaluation test is predicted, the data set includes an evaluation result as supervised data acquired by executing the predetermined life evaluation test on the plurality of storage batteries, and deterioration information on the storage battery as supervised data acquired by analyzing a material of the storage battery when the end of life is reached. The data set further includes test condition data of the life evaluation test, charge-discharge data acquired by executing the evaluation charge-discharge protocol on the plurality of storage batteries in various deterioration states, and material analysis data on the storage battery acquired by disassembling and analyzing the plurality of storage batteries in various deterioration states. Further, the database further includes a plurality of explanatory variables extracted from the test condition data, the charge-discharge data, and the material analysis data described above, and the plurality of explanatory variables are associated with the supervised data described above and used for learning of a machine learning model. In a case where an evaluation result of the predetermined charge-discharge protocol is predicted, the data set includes an evaluation result including energy density and power density as supervised data acquired by executing the predetermined charge-discharge protocol on a plurality of storage batteries, and a plurality of explanatory variables that are extracted from charge-discharge data acquired by executing the evaluation charge-discharge protocol on the plurality of storage batteries and are associated with the evaluation result described above. In a case where an evaluation result of the predetermined life evaluation test is predicted and an evaluation result of the predetermined charge-discharge protocol is predicted, the data set stores a data set used for learning of both. The database is updated at any time, and is used for relearning of the learned model. Details of construction of the database will be described below.

The storage unit 303 of the entity server 300 stores (accumulates) the test condition data when the life evaluation test is performed on a storage battery being an evaluation target, the charge-discharge data acquired by performing the evaluation charge-discharge protocol, and the material analysis data acquired by disassembling the storage battery being the evaluation target. Further, when additional charge-discharge data and/or material analysis data are acquired by further continuing the life evaluation test after evaluation prediction ends, and performing the evaluation charge-discharge protocol and/or material analysis on the storage battery being the evaluation target, the charge-discharge data and/or the material analysis data are stored (added) to the database. When an evaluation result and/or deterioration information as new supervised data is acquired by executing the predetermined life evaluation test on a storage battery of the same lot as the storage battery being the evaluation target, the new supervised data and an extracted explanatory variable are associated with each other, and are stored (added) in the database. Further, when an evaluation result as new supervised data is acquired by further performing the predetermined charge-discharge protocol on the storage battery being the evaluation target, the new supervised data and an explanatory variable extracted from the charge-discharge data are associated with each other, and are stored (added) in the database.

### Evaluation Prediction Unit:

The evaluation prediction unit 304 of the entity server 300 acquires a predicted evaluation result by inputting a plurality of explanatory variables extracted from the test condition data, the charge-discharge data, and the material analysis data to the learned model, and computes prediction accuracy of the predicted evaluation result.

The predicted evaluation result includes an evaluation result that may be acquired if the predetermined life evaluation test is performed on a storage battery being an evaluation target, and predicted deterioration information on the storage battery when the end of life is reached, and/or includes energy density and power density that may be acquired if the predetermined charge-discharge protocol is performed on the storage battery being the evaluation target. Examples of the evaluation result that may be acquired if the predetermined life evaluation test is performed include a voltage retention rate after the test of the storage battery, a capacity maintenance rate after the test, time to reach the end of life, a cycle number to reach the end of life, and the like. The time to reach the end of life may be, for example, time until a capacity maintenance rate of the storage battery reaches 80%. The cycle number to reach the end of life may be, for example, a cycle number until a capacity maintenance rate of the storage battery reaches 80%. Further, examples of the predicted deterioration information on the storage battery include a degree of deterioration of a material of the storage battery, a degree of deterioration of a member, and the like when the end of life is reached (for example, when a capacity maintenance rate of the storage battery reaches 80%, or when a temperature of the storage battery reaches an upper limit value). For a material of the storage battery such as, for example, a positive electrode active material, a negative electrode active material, a material of a separator, and a material of an electrolyte solution (solvent, salt, and additive), the degree of deterioration of the material indicates, as a percentage, an extent to which each of the materials remains in a state of functioning soundly when the end of life is reached by setting, for example, a brand-new state (at a time of a start of the life evaluation test) as 100%. For a member of the storage battery such as, for example, a positive electrode, a negative electrode, a separator, and an electrolyte, the degree of deterioration of the member indicates soundness when the end of life is reached. Examples of the degree of deterioration of a member include, for example, a degree of blockage of pores of a separator (a reduction rate of the number of pores) indicated as a percentage by setting a brand-new state as 0%, the presence or absence of a tear in a separator indicated by binary evaluation, a decrease rate of strength of a separator indicated as a percentage by setting a brand-new state as 100%, and the like. In such a manner, the predicted evaluation result includes the predicted deterioration information on the storage battery when the end of life is reached, and thus there are advantages in such a way that a user can recognize a cause of deterioration of the storage battery, and perform consideration of a deterioration mechanism, formulation of a deterioration measure, and the like. When there are a plurality of measurement conditions of energy density and power density of a prediction target as energy density and power density that may be acquired if the predetermined charge-discharge protocol is performed, at least one of them, preferably, all are included. For example, when the IEC62660-1 is set as a prediction target as the predetermined charge-discharge protocol, a predicted evaluation result can include (1) energy density at 25°C, (2) power density at 25°C and an SOC of 20%, (3) power density at 25°C and the SOC of 50%, (4) power density at 25°C and the SOC of 80%, (5) power density at -20°C and the SOC of 50%, (6) power density at 0°C and the SOC of 50%, and (7) power density at 45°C and the SOC of 50%. The predicted evaluation result includes a predicted evaluation result of (1) described above and at least one predicted evaluation result selected from a group of (2) to (7). The predicted evaluation result preferably includes a predicted evaluation result of (1) to (4) described above, and more preferably includes a predicted evaluation result of all of (1) to (7) described above.

Prediction accuracy of an evaluation result of the predetermined life evaluation test indicates likelihood of a predicted evaluation result with respect to an evaluation result and deterioration information on an assumption that the predetermined life evaluation test is performed on a storage battery being an evaluation target, and material analysis is performed when the end of life is reached. As an index of the prediction accuracy, a determination coefficient (R² value), a root mean squared error (RMSE), a mean absolute error (MAE), a mean absolute percentage error (MAPE), and the like can be used. The prediction accuracy is changed by a degree of accumulation of the charge-discharge data, the presence or absence of acquisition of the material analysis data, a degree of accumulation of the material analysis data, a combination of input explanatory variables, and the like. As more charge-discharge data and material analysis data are accumulated by continuing the life evaluation test longer, and performing more charge-discharge processes and material analyses, the prediction accuracy increases. Further, the prediction accuracy increases by eliminating one or a plurality of explanatory variables having multicollinearity with the other explanatory variable from the input explanatory variables. Prediction accuracy of an evaluation result of the predetermined charge-discharge protocol indicates likelihood of a predicted evaluation result with respect to an evaluation result on an assumption that the predetermined charge-discharge protocol is performed on a storage battery being an evaluation target, and energy density and power density are evaluated. As an index of the prediction accuracy, a determination coefficient (R² value), a root mean squared error (RMSE), a mean absolute error (MAE), a mean absolute percentage error (MAPE), and the like can be used. The prediction accuracy is changed by which charge-discharge process of the evaluation charge-discharge protocol has been completed (a degree of accumulation of the charge-discharge data), and a combination of input explanatory variables. As more charge-discharge processes are completed, and more charge-discharge data are accumulated, the prediction accuracy increases. Further, the prediction accuracy increases by eliminating one or a plurality of explanatory variables having multicollinearity with the other explanatory variable from the input explanatory variables (Table 2 and Table 3).

### Output Unit (Transmission Unit):

The output unit (transmission unit) 305 of the entity server 300 includes a wired communication interface circuit conforming to a communication protocol such as a transmission control protocol/Internet protocol (TCP/IP), and communicates with and is connected to the networks N1 and N2 according to communication standards such as Ethernet (registered trademark). It should be noted that the acquisition unit (reception unit) 301 may include an antenna that transmits and receives a wireless signal, and a wireless communication interface circuit conforming to a communication protocol such as wireless LAN, and may communicate with and be connected to the networks N1 and N2 according to communication standards such as wireless LAN.

The output unit (transmission unit) 305 of the entity server 300 outputs (transmits) information (hereinafter also simply referred to as "prediction information") including the predicted evaluation result and the prediction accuracy described above to the acquisition unit 401 of the virtual environment 400 that can be accessed from a user terminal via the network N2. Output (transmission) of the prediction information is performed in real time. In this way, a user can confirm the prediction information on the storage battery in real time, and control the evaluation result prediction device. It should be noted that, in the present disclosure, "output" of the prediction information includes "transmission" of the prediction information to the other device, "display" of the prediction information in any form such as a graphical user interface (GUI) on a display unit (not illustrated) of its own device or the other device, and the like. In the entity server 300 in FIG. 3, "output" of the prediction information is "transmission" to the virtual environment 400. The output unit (transmission unit) 305 may output (transmit) the prediction information to the entity terminal 500 and/or the customer terminal 600. The entity server 300 may further include a functional unit that performs "display" on the display unit (not illustrated) of its own device or the other device. The display unit is a display including a liquid crystal display, an organic electro-luminescence (EL) display, and the like.

### Control Unit:

The control unit 306 of the entity server 300 can control the charge-discharge device 100 in such a way that the evaluation charge-discharge protocol ends or continues (the life evaluation test ends or continues) via the charge-discharge device terminal 200. For example, after a certain charge-discharge process is executed, the control unit 306 can output commands for (i) ending the evaluation charge-discharge protocol (ending the life evaluation test) when the prediction accuracy is equal to or more than a predetermined threshold value, and (ii) continuing the evaluation charge-discharge protocol (continuing the life evaluation test) and executing a next charge-discharge process when the prediction accuracy is less than the predetermined threshold value. In the case of (ii), the acquisition unit acquires further charge-discharge data acquired from the next charge-discharge process and freely acquires further material analysis data, and the explanatory variable extraction unit extracts an explanatory variable from the accumulated charge-discharge data and material analysis data as described above. The evaluation prediction unit inputs the explanatory variable extracted from the accumulated charge-discharge data and material analysis data to the learned model, and performs acquisition of a predicted evaluation result and computation of prediction accuracy as described above. Then, by comparing the prediction accuracy of the predicted evaluation result acquired based on the accumulated charge-discharge data and material analysis data with a predetermined threshold value, the control unit 306 can output the commands for (i) ending the evaluation charge-discharge protocol (ending the life evaluation test) when the prediction accuracy is equal to or more than the predetermined threshold value, and (ii) continuing the evaluation charge-discharge protocol (continuing the life evaluation test) and executing a next charge-discharge process when the prediction accuracy is less than the predetermined threshold value. The control unit 306 can repeat the processing above until the prediction accuracy is equal to or more than the predetermined threshold value, or an n-th (all) charge-discharge process ends. In such a manner, the entity server 300 can automatically control an end or continuation of the evaluation charge-discharge protocol, based on prediction accuracy, and more quickly feed back a predicted evaluation result that satisfies the prediction accuracy desired by a user.

The entity server 300 may be further configured to control the evaluation result prediction device when the entity server 300 receives a command for controlling the evaluation result prediction device from the virtual environment 400 (command from a user), in addition to being able to perform automatic control by the control unit 306 described above. Examples of the command for controlling the evaluation result prediction device from a user include, for example, a command for setting or changing a threshold value of prediction accuracy, a command for ending or continuing the evaluation charge-discharge protocol (ending or continuing the life evaluation test), and the like. Details of the control of the evaluation result prediction device using the virtual environment 400 will be described below.

### Learning Processing Unit:

The learning processing unit 307 of the entity server 300 can perform learning processing of a machine learning model, based on a machine learning program, and perform generation and relearning of a learned model. Details of the learning processing of the machine learning model will be described below.

### <Virtual Environment>

In FIG. 3, the virtual environment 400 is a virtual server constructed on the network N2, and is communicably connected to the entity server 300 via the network N2. The virtual environment 400 may be a virtual server constructed by using a hardware resource of the entity server 300, or may be an environment constructed by using a hardware resource of one or a plurality of servers other than the entity server 300. The virtual environment 400 includes an acquisition unit 401 that acquires information including a predicted evaluation result and prediction accuracy, an output unit 405 that outputs (displays) the information including the predicted evaluation result and the prediction accuracy in a form of a graphical user interface (GUI), and a control unit 406 that outputs the command for controlling the evaluation result prediction device when the command for controlling the evaluation result prediction device is input from a user.

The acquisition unit 401 of the virtual environment 400 can acquire the information (hereinafter simply referred to as "prediction information") including the predicted evaluation result and the prediction accuracy and freely acquire information including the charge-discharge data and the like from the entity server 300 in real time via the network N2. The output unit (GUI) 405 of the virtual environment 400 can output (display), in real time in the form of the GUI, the prediction information and the like acquired by the acquisition unit 401 on a display device (display unit) of a terminal device (such as the entity terminal 500, and the customer terminal 700) that has accessed the virtual environment 400. The information displayed on the GUI is, for example, an SOC, a voltage, and a current value of a storage battery, progress of the life evaluation test, current predicted evaluation result and prediction accuracy, prediction accuracy when a next charge-discharge process is performed, and the like. The GUI can graphically display the information.

The GUI also functions as an input unit that inputs a command for controlling the evaluation result prediction device from a user in addition to output (display) of the prediction information and the like. Examples of the command include, for example, a command for setting or changing a threshold value of prediction accuracy, a command for ending or continuing the evaluation charge-discharge protocol (ending or continuing the life evaluation test), and the like. The GUI displays an icon, a tab, an input bar, and the like corresponding to the commands, and the user can thus input the command via the GUI. When the command from the user is input via the GUI, the control unit 406 of the virtual environment 400 outputs (transmits) the command for controlling the evaluation result prediction device to the entity server 300 via the network N2. When the plurality of storage batteries are simultaneously evaluated, the virtual environment 400 is configured to be able to output (display) the prediction information for each storage battery in the form of the GUI, and control charging and discharging for each storage battery. In this way, the user can confirm the prediction information on the plurality of storage batteries being evaluation targets in real time for each storage battery, and control the evaluation result prediction device. For example, the user can continue the evaluation charge-discharge protocol (continue the life evaluation test) by changing a threshold value to a higher value before prediction accuracy of a certain storage battery reaches a preset threshold value, can end the evaluation charge-discharge protocol (end the life evaluation test) even when prediction accuracy of the evaluation charge-discharge protocol of a certain storage battery is less than a preset threshold value, and the like.

### <Entity Terminal>

The entity terminal 500 in FIG. 3 is one or a plurality of information processing devices operated by a battery evaluation entrusted entity, and may be, for example, an information processing device such as a personal computer, a note PC, a tablet PC, or a multifunctional cellular phone, (so-called smartphone). The entity terminal 500 is communicably connected to the charge-discharge device terminal 200 and the entity server 300 via the private network N1 of the entity, and can perform management, operation, alteration, and the like of the evaluation result prediction system 1. Further, the entity terminal 500 is communicably connected to the virtual environment 400 and the customer terminal 600 via the accessible network N2 of a user, and thus the entity can perform management, operation, and alteration of the virtual environment 400, and technical support and the like of a customer.

### <Customer Terminal>

The customer terminal 600 in FIG. 3 is one or a plurality of information processing devices operated by an entity entrusting battery evaluation, and may be, for example, an information processing device such as a personal computer, a note PC, a tablet PC, or a multifunctional cellular phone, (so-called smartphone). The customer terminal 600 is communicably connected to the virtual environment 400 via the network N2, and can display the GUI of the virtual environment 400. The user can acquire the prediction information in real time via the GUI of the virtual environment 400, and can transmit the command for controlling the evaluation result prediction device to the virtual environment 400 at any timing. Further, the customer terminal 600 is communicably connected to the entity terminal 500 via the network N2, and can receive technical support from the entity.

### <<Learning Processing of Life Evaluation Data>>

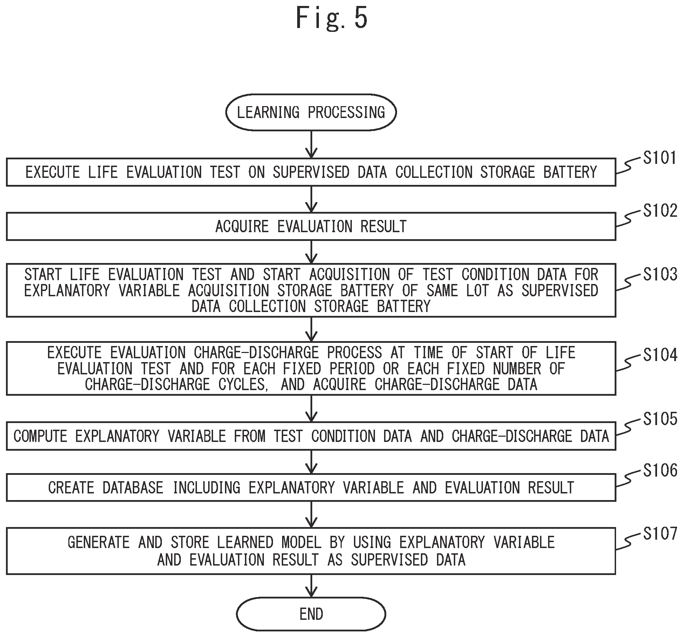

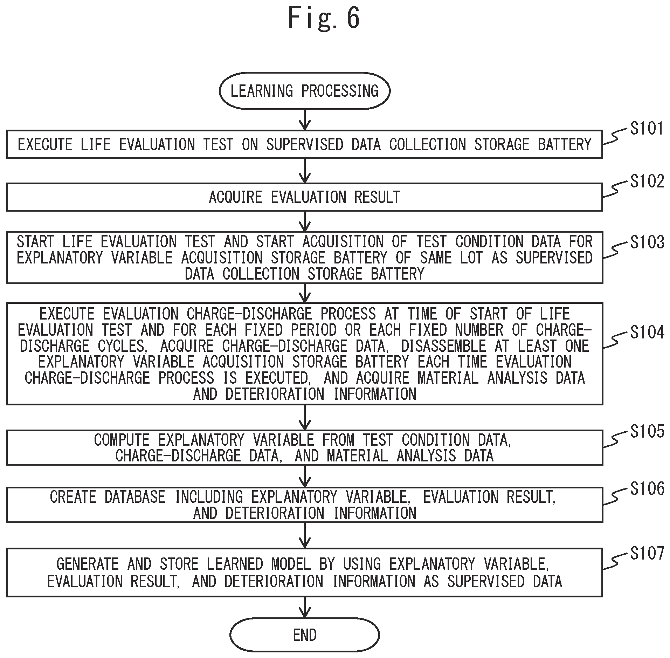

FIGS. 5 and 6 are flowcharts illustrating an example of a motion of learning processing of a learned model that outputs a predicted evaluation result including an evaluation result that may be acquired if the predetermined life evaluation test is performed, and predicted deterioration information on a storage battery when the end of life is reached. It should be noted that a flow of the motion described below is performed in cooperation with each element mainly by the explanatory variable extraction unit 302 and the learning processing unit 307 included in the processing unit of the entity server 300, based on the program stored in the storage unit 303 of the entity server 300.

### <Creation of Database of Life Evaluation Data>

FIG. 5 illustrates the example of the motion of the learning processing of the learned model not accompanied by collection of material analysis data. First, the one or the plurality of storage batteries (supervised data collection storage batteries) 101 for supervised data collection are connected in series or parallel to the power supply unit 102 of the charge-discharge device 100, and the predetermined life evaluation test is executed (S101). The supervised data collection storage battery is preferably the same kind (such as an LiB, a lead storage battery, or a nickel-hydrogen secondary battery) in terms of a category as a storage battery being an evaluation target, and a storage battery having at least one of materials (such as a positive electrode active material, a negative electrode active material, a material of a separator, and a material of an electrolyte solution) used for members (such as a positive electrode, a negative electrode, a separator, and an electrolyte solution) in common is more preferably used.

In FIG. 5, next, an evaluation result by the predetermined life evaluation test is acquired (S102). The evaluation result includes at least one evaluation result selected from a voltage retention rate after the test of the storage battery, a capacity maintenance rate after the test, time to reach the end of life, a cycle number to reach the end of life, or a deterioration state when the end of life is reached. The acquired evaluation result is used as supervised data. When there are a plurality of evaluation results that need to be acquired in the predetermined life evaluation test, all of the evaluation results are basically acquired. For example, when a storage test of a storage battery in the IEC62660-1 is performed as the predetermined life evaluation test, the evaluation result includes a voltage retention rate after the storage battery is stored at 45°C for 28 days, and a capacity maintenance rate after the storage battery is stored at 45°C for 42 days, for 84 days, and for 126 days. When a cycle test of a storage battery in the IEC62660-1 is performed, the evaluation result includes (i) a temperature and a capacity maintenance rate after each deterioration step, and includes, (ii) when the capacity maintenance rate of the storage battery reaches 80% or (iii) the temperature of the storage battery reaches an upper limit temperature, time and a cycle number required until the time (time to reach the end of life and a cycle number to reach the end of life). However, only a part of the evaluation results may be acquired as supervised data for a part of the supervised data collection storage batteries.

In FIG. 5, next, one or a plurality of storage batteries (explanatory variable acquisition storage batteries) in a brand-new state of the same lot (manufactured at once by the same material and the same condition) as the supervised data collection storage batteries are connected in series or parallel to the power supply unit 102 of the charge-discharge device 100, the life evaluation test starts, and acquisition of test condition data starts (S103). The test condition data are acquired (received) by the acquisition unit (reception unit) 301 of the entity server 300 from the charge-discharge device terminal 200 via the network N1. A condition of the life evaluation test is assumed to be the same condition as that of the predetermined life evaluation test performed on the supervised data collection storage batteries except that the evaluation charge-discharge process is performed at the time of the start of the life evaluation test and for each fixed period or each fixed number of cycles. The test condition data are used for extracting an explanatory variable being an input of the learning processing later. Thus, the acquired test condition data basically include all of a temperature, a current value, a voltage, and a charge-discharge pause time of the storage battery. However, only a part of the test condition data may be acquired for a part of the explanatory variable acquisition storage batteries.

In FIG. 5, next, the evaluation charge-discharge process is executed at the time of the start of the life evaluation test and for each fixed period or each fixed number of charge-discharge cycles, based on the evaluation charge-discharge protocol, and acquires charge-discharge data (S104). The charge-discharge data are measured by the sensor unit 103 of the charge-discharge device 100, and transmitted to the charge-discharge device terminal 200. Step S104 of acquiring the charge-discharge data is repeated until the charge-discharge data are acquired when the end of life is reached (for example, when a capacity maintenance rate of the storage battery reaches 80% or when a temperature of the storage battery reaches an upper limit value). Then, a plurality of explanatory variables are computed (extracted) from the test condition data and the charge-discharge data (S105). Computation of the explanatory variables is performed by the explanatory variable extraction unit 302 of the entity server 300. The explanatory variables include a test condition parameter selected from the test condition data, an electrochemical parameter acquired by electrochemically analyzing the charge-discharge data, and a mathematical parameter acquired by mathematically processing a shape of a discharge curve in the charge-discharge process.

The test condition parameter includes a temperature, a current value, a voltage (for example, an upper limit voltage and a lower limit voltage), and a charge-discharge pause time of the storage battery during the life evaluation test, parameters acquired by mathematically processing these, and the like. The acquired test condition parameters are each a candidate for an explanatory variable when a "selected explanatory variable" is decided.

The electrochemical parameter can be computed (extracted) by electrochemically analyzing the charge-discharge process of the evaluation charge-discharge protocol, and includes energy density, power density, voltage relaxation behavior, a capacity maintenance rate, and the like. Details of computation of the electrochemical parameter are as described in the item of "Explanatory Variable Extraction Unit" described above. For example, as exemplified in FIG. 2B, when the evaluation charge-discharge protocol including performing the single charge-discharge process at the time of the start of the life evaluation test and for each fixed period or each fixed number of the charge-discharge cycles during the life evaluation test is used, the energy density, the power density at the SOC of 80%, the SOC of 50%, and the SOC of 20%, the voltage relaxation behavior, and the capacity maintenance rate by setting a capacity maintenance rate at the time of the start of the life evaluation test as 100% are acquired from each single charge-discharge process. The acquired electrochemical parameters are each a candidate for an explanatory variable when a "selected explanatory variable" is decided.

The mathematical parameter can be extracted by mathematically processing a shape of a discharge curve in the charge-discharge process. The mathematical parameter includes, for example, data acquired by mathematically processing a discharge curve freely combining a voltage of the storage battery on a vertical axis, and a time, a current capacity, an SOC, and the like on a horizontal axis. FIG. 4 is the diagram illustrating the example of computation of the mathematical parameters as the explanatory variables. As exemplified in FIG. 4, the mathematical parameter is acquired by factorizing the matrix representing the shape of the discharge curve. First, for discharge curve data in which a value of an SOC of the storage battery is the horizontal axis and a value of a voltage (V) corresponding to the value of the SOC is the vertical axis, the matrix X with A rows and B columns acquired by arranging, as elements, values of the voltage (V) of the plurality of storage batteries (the sample number is assumed to be A (A ≥ 2)) corresponding to values of B (B ≥ 2) different SOCs in the column direction is acquired. The number B of values of the SOCs to be adopted may be about 10 to 1,000. For example, as exemplified in FIG. 4, when values of the SOCs are divided into 1% increments from 100% to 0%, B is 101 in total of 100%, 99%, 98%, ..., 2%, 1%, and 0%. The sample number A of the storage batteries is, for example, 10 or more, 50 or more, 100 or more, 500 or more, or 1,000 or more, and prediction accuracy of the learned model improves as the sample number A increases. Next, a mathematical constraint is imposed, and the matrix X is then factorized into X ≈ W × H (in the equation, the matrix W is a coefficient matrix with A rows and C columns, and the matrix H is a basis matrix with C rows and B columns). The mathematical constraint is determined in such a way that the matrix W and the matrix H are uniquely decided. C is, for example, equal to or less than the same number as the number B of values of the SOCs. As a method of the matrix factorization, principal component analysis, non-negative matrix factorization, and the like can be used. C coefficient matrices (referred to as a "first principal component" to a "C-th principal component" in an order from a first column) in the matrix W are each a candidate for an explanatory variable when a "selected explanatory variable" is decided.

It should be noted that execution of the predetermined life evaluation test and acquisition of the evaluation result (S101 and S102) and evaluation of the life evaluation test for explanatory variable acquisition to computation of the explanatory variable (S103 to S105) may be a reversed order (an order of S103 to S105 first and S101 and S102 later). Further, the predetermined life evaluation test, and the life evaluation test for explanatory variable acquisition may be performed simultaneously (S101 and S102, and S103 to S105 may be performed simultaneously).

In FIG. 5, next, a database including the explanatory variables and the evaluation result is created (S106). The database includes the plurality of explanatory variables computed from the test condition data and the charge-discharge data described above, and the evaluation result by the predetermined life evaluation test being associated with the explanatory variables, and the database is stored in the storage unit 303 of the entity server 300.

### <Generation of Learned Model of Life Evaluation Data>

In FIG. 5, lastly, the learned model is generated and stored by using the explanatory variables and the evaluation result as supervised data (S107), and a series of the processing ends. Generation of the learned model can be performed by previously learning a machine learning model by supervised learning such as, for example, ridge regression, support vector regression, or a neural network. As an input variable, data acquired by standardizing the explanatory variables described above (processing of setting an average of data as 0 and setting a standard deviation as 1) are used. It should be noted that an evaluation result as an output variable may be standardized. Next, the machine learning model is caused to learn the input variable and the output variable (evaluation result) corresponding to the input variable, and prediction accuracy of the model is calculated. As an index of the prediction accuracy, a determination coefficient (R² value), a root mean squared error (RMSE), a mean absolute error (MAE), a mean absolute percentage error (MAPE), and the like can be used. When the prediction accuracy is verified, cross validation is preferably performed. Then, a hyper parameter is adjusted in such a way that the prediction accuracy of the machine learning model is the highest.

The input variable is preferably a combination of explanatory variables selected from among the plurality of explanatory variables described above in such a way as to improve prediction accuracy by the learned model and/or improve interpretability for a predicted evaluation result. More specifically, the input variable may be an explanatory variable selected by eliminating one or a plurality of parameters having multicollinearity with the other parameter instead of using all parameters acquired in computation of the explanatory variables described above (S105). Examples of the method for selecting an explanatory variable include a method using, for example, Boruta, recursive feature elimination, a genetic algorithm (GA), and the like. Boruta is a variable selection method based on variable importance of random forest (RF), and the method selects an explanatory variable by adding a dummy variable to the explanatory variable, constructing a model of random forest, computing importance of each variable, and deleting a variable having lower importance than the dummy variable. The recursive feature elimination is a method for deleting an explanatory variable having lowest importance from a state where a prediction model is created by using all explanatory variables, creating a prediction model again with remaining explanatory variables, and deleting an explanatory variable having lowest importance again until explanatory variables reach the number designated in advance. The genetic algorithm (GA) is a method for solving an optimization problem by considering two options of whether or not (1 or 0) to use each explanatory variable, and finding a combination of the explanatory variables in such a way as to determine which explanatory variable is used to maximize accuracy. From a viewpoint of prediction accuracy and interpretability, it is preferable to try all the techniques and then select the technique in which the prediction accuracy and the interpretability are the most excellent. Examples of a combination of the explanatory variables include: for example, one or a plurality of test condition parameters and one or a plurality of electrochemical parameters; one or a plurality of test condition parameters, one or a plurality of electrochemical parameters, and one or a plurality of mathematical parameters; and the like.

As described above, the learned model being learned in such a way as to output a predicted evaluation result measured by the predetermined life evaluation test when a plurality of explanatory variables extracted from charge-discharge data on a storage battery are input can be generated. Output of the generated learned model in FIG. 5 includes, as a predicted evaluation result, at least one selected from a voltage retention rate after the test of the storage battery, a capacity maintenance rate after the test, time to reach the end of life, or a cycle number to reach the end of life. The generated learned model is stored in the storage unit 303 of the entity server 300.

### <Creation of Database of Life Evaluation Data>

FIG. 6 illustrates the example of the motion of the learning processing of the learned model accompanied by collection of material analysis data. First, one or a plurality of storage batteries (supervised data collection storage batteries) 101 for supervised data collection are connected in series or parallel to the power supply unit 102 of the charge-discharge device 100, and a predetermined life evaluation test is executed (S101). Details of step S101 are similar to step S101 in FIG. 5 described above. Next, an evaluation result by the predetermined life evaluation test is acquired (S102). Details of step S102 are similar to step S102 in FIG. 5 described above.

In FIG. 6, next, a plurality of (N) storage batteries (explanatory variable acquisition storage batteries) in a brand-new state of the same lot (manufactured at once by the same material and the same condition) as the supervised data collection storage batteries are connected in series or parallel to the power supply unit 102 of the charge-discharge device 100, the life evaluation test starts, and acquisition of test condition data starts (S103). The test condition data are acquired (received) by the acquisition unit (reception unit) 301 of the entity server 300 from the charge-discharge device terminal 200 via the network N1. As described below, at least one explanatory variable acquisition storage battery is disassembled each time the evaluation charge-discharge process is executed from the time of the start of the life evaluation test to a time at which the end of life is reached, and the material analysis data and deterioration information in various deterioration states are acquired. Thus, the number N of the explanatory variable acquisition storage batteries to be prepared is equal to or more than the number of times the evaluation charge-discharge process is performed in the life evaluation test. A condition of the life evaluation test is assumed to be the same condition as that of the predetermined life evaluation test performed on the supervised data collection storage batteries except that the evaluation charge-discharge process is performed at the time of the start of the life evaluation test and for each fixed period or each fixed number of cycles. The test condition data are used for extracting an explanatory variable being an input of the learning processing later. Thus, the acquired test condition data basically include all of a temperature, a current value, a voltage, and a charge-discharge pause time of the storage battery. However, only a part of the test condition data may be acquired for a part of the explanatory variable acquisition storage batteries.

In FIG. 6, next, the evaluation charge-discharge process is executed at the time of the start of the life evaluation test and for each fixed period or each fixed number of charge-discharge cycles, based on the evaluation charge-discharge protocol, and acquires charge-discharge data (S104). The charge-discharge data are measured by the sensor unit 103 of the charge-discharge device 100, and transmitted to the charge-discharge device terminal 200. Furthermore, each time the evaluation charge-discharge process is executed, at least one explanatory variable acquisition storage battery is disassembled and analyzed, and the material analysis data and the deterioration information are acquired (S104). The material analysis data include, for example, an X-ray diffraction (XRD) spectrum, a nuclear magnetic resonance (NMR) spectrum, an electron spin resonance (ESR) spectrum, a scanning electron microscope (SEM) image, an ion chromatography (IC) spectrum, and the like of a material constituting the storage battery. As the deterioration information on the storage battery, a degree of deterioration of a material of the storage battery and a degree of deterioration of a member at a point in time of material analysis (after the evaluation charge-discharge protocol is performed) are included. For a material of the storage battery such as, for example, a positive electrode active material, a negative electrode active material, a material of a separator, and a material of an electrolyte solution (solvent, salt, and additive), the degree of deterioration of the material indicates, as a percentage, an extent to which each of the materials remains in a state of functioning soundly at a point in time of material analysis by setting, for example, a brand-new state (at the time of the start of the life evaluation test) as 100%. For a member of the storage battery such as, for example, a positive electrode, a negative electrode, a separator, and an electrolyte, the degree of deterioration of the member indicates soundness of when the end of life is reached. Examples of the degree of deterioration of a member include, for example, a degree of blockage of pores of a separator (a reduction rate of the number of pores) indicated as a percentage by setting a brand-new state as 0%, the presence or absence of a tear in a separator indicated by binary evaluation, a decrease rate of strength of a separator indicated as a percentage by setting a brand-new state as 100%, and the like. Examples of a method for computing a degree of deterioration of a material include a method for comparing material analysis data and the like on a storage battery in a brand-new state and at a point in time of material analysis, and computing, as a percentage (such as % by mass), an extent to which each material remains in a state of functioning soundly. Further, examples of a method for computing a degree of deterioration of a material include a method for setting an evaluation item and a criterion related to soundness of each member by a threshold value or qualitatively in advance, and computing or deciding a degree of deterioration of each member of a storage battery at a point in time of material analysis. Step S104 of acquiring the charge-discharge data, the material analysis data, and the deterioration information is repeated until the charge-discharge data, the material analysis data, and the deterioration information when the end of life is reached (for example, when a capacity maintenance rate of the storage battery reaches 80% or when a temperature of the storage battery reaches an upper limit value) are acquired.

In FIG. 6, next, a plurality of explanatory variables are computed (extracted) from the test condition data, the charge-discharge data, and the material analysis data (S105). Computation of the explanatory variables is performed by the explanatory variable extraction unit 302 of the entity server 300. The explanatory variables include a test condition parameter selected from the test condition data, an electrochemical parameter acquired by electrochemically analyzing the charge-discharge data, a mathematical parameter acquired by mathematically processing a shape of a discharge curve in the charge-discharge process, and a material analysis parameter acquired by processing the material analysis data. Details of acquisition of the test condition parameter, the electrochemical parameter, and the mathematical parameter are referred to the description of FIG. 5 described above. The acquired test condition parameter, electrochemical parameter, and mathematical parameter are each a candidate for an explanatory variable when a "selected explanatory variable" is decided.

The material analysis parameter can be acquired by mathematically processing the material analysis data on the storage battery, for example, an X-ray diffraction (XRD) spectrum, a nuclear magnetic resonance (NMR) spectrum, an electron spin resonance (ESR) spectrum, a scanning electron microscope (SEM) image, an ion chromatography (IC) spectrum, or the like of a material constituting the storage battery. Examples of a method for acquiring the material analysis parameter from the material analysis data include the following processing (1) to (3).

The processing (1) is a method for acquiring a material analysis parameter from a spectrum such as the XRD, the NMR, the ESR, and the IC. First, for a D sample, a matrix Y with D row and E columns (D is a sample number, D ≥ 1, E is the number of elements, and E ≥ 2) acquired by arranging, as an element, a difference between spectrum data in a brand-new state and spectrum data at a point in time of analysis in the column direction is acquired. The sample number D of the storage battery corresponds to the number of the explanatory variable acquisition storage batteries analyzed in step S104, and can be 1 or more, 2 or more, 5 or more, 10 or more, 20 or more, 50 or more, or 100 or more. In general, as the sample number D increases, prediction accuracy of the learned model improves. The number E corresponding to the division number in a horizontal axial direction of the spectrum data is about 10 to 1,000. Next, a mathematical constraint is imposed, and the matrix Y is then factorized into Y ≈ V × I (in the equation, a matrix V is a coefficient matrix with D row and F columns, and a matrix I is a basis matrix with F rows and E columns). The mathematical constraint is determined in such a way that the matrix V and the matrix I are uniquely decided. F is, for example, equal to or less than the same number as the number E of the elements. As a method of the matrix factorization, principal component analysis, non-negative matrix factorization, and the like can be used. Then, F coefficients (referred to as a "first principal component" to a "C-th principal component" in an order from a first column) in the matrix V can be acquired as material analysis parameters. The acquired material analysis parameters are candidates for explanatory variables when a "selected explanatory variable" is decided.

Details of the processing (2) and (3) are as described in the section of "Explanatory Variable Extraction Unit" of "Entity Server" described above. The acquired material analysis parameters are candidates for explanatory variables when a "selected explanatory variable" is decided.

It should be noted that execution of the predetermined life evaluation test and acquisition of the evaluation result and the deterioration information (S101 and S102) and execution of the life evaluation test for explanatory variable acquisition to computation of the explanatory variable (S103 to S105) may be a reversed order (an order of S103 to S105 first and S101 and S102 later). Further, the predetermined life evaluation test and the life evaluation test for explanatory variable acquisition may be performed simultaneously (S101 and S102 and S103 to S105 may be performed simultaneously).

In FIG. 6, next, a database including the explanatory variables and the evaluation result is created (S106). The database includes the plurality of explanatory variables computed from the test condition data, the charge-discharge data, and the material analysis data described above, and the evaluation result and the deterioration information by the predetermined life evaluation test being associated with the explanatory variables, and the database is stored in the storage unit 303 of the entity server 300.

### <Generation of Learned Model of Life Evaluation Data>

In FIG. 6, lastly, the learned model is generated and stored by using the explanatory variables and the evaluation result as supervised data (S107), and a series of the processing ends. Details of step S107 are similar to step S107 in FIG. 5 described above except that the one or the plurality of material analysis parameters are included in the explanatory variables. The input variable is preferably a combination of explanatory variables selected from among the plurality of explanatory variables described above in such a way as to improve prediction accuracy by the learned model and/or improve interpretability for a predicted evaluation result. Selection of the explanatory variable is also similar to step S107 in FIG. 5 described above except that the one or the plurality of material analysis parameters are included in the explanatory variables. Examples of a combination of the explanatory variables input to the learned model in FIG. 6 include: for example, one or a plurality of test condition parameters, one or a plurality of electrochemical parameters, and one or a plurality of material analysis parameters; and one or a plurality of test condition parameters, one or a plurality of electrochemical parameters, one or a plurality of mathematical parameters, and one or a plurality of material analysis parameters.

As described above, the learned model being learned in such a way as to output a predicted evaluation result measured by the predetermined life evaluation test when a plurality of explanatory variables extracted from charge-discharge data on a storage battery are input can be generated. Output of the generated learned model in FIG. 6 includes, as a predicted evaluation result, at least one selected from a voltage retention rate after the test of the storage battery, a capacity maintenance rate after the test, time to reach the end of life, or a cycle number to reach the end of life, and further includes predicted deterioration information. The generated learned model is stored in the storage unit 303 of the entity server 300.

### <<Evaluation Prediction Processing of Life Evaluation Test>>

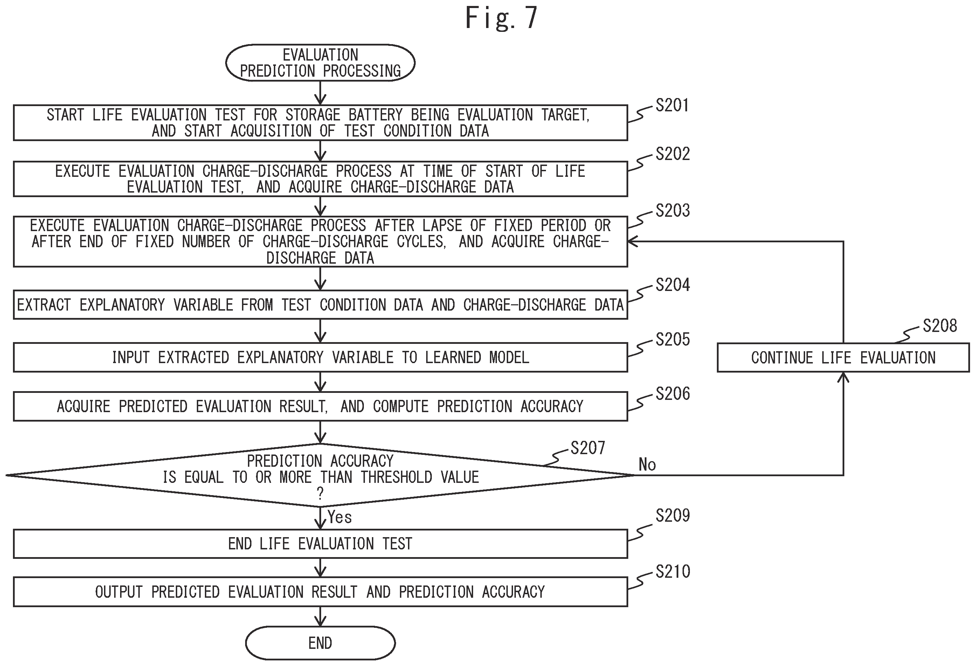

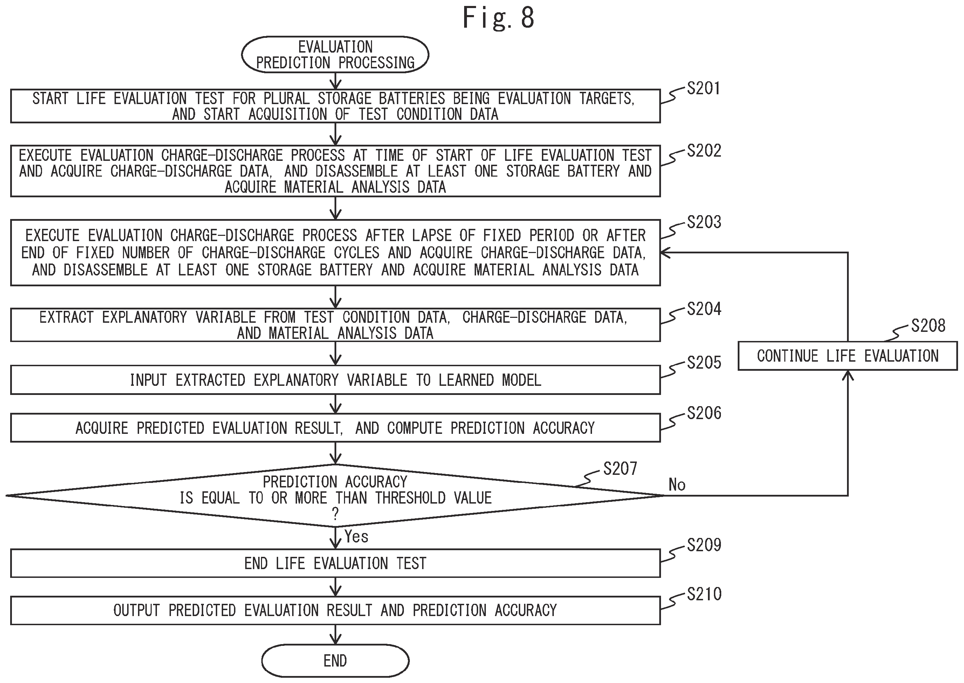

FIGS. 7 and 8 are flowcharts illustrating an example of a motion of the evaluation prediction processing (evaluation result prediction method). It should be noted that a flow of the motion described below is performed in cooperation with each element of the evaluation result prediction device and system mainly by the explanatory variable extraction unit 302, the evaluation prediction unit 304, and the control unit 306 included in the processing unit of the entity server 300, based on an evaluation result prediction program of the present disclosure stored in the storage unit 303 of the entity server 300.

### <Evaluation Prediction of Life Evaluation Test>

FIG. 7 is the flowchart illustrating the example of the motion of the evaluation prediction processing (evaluation result prediction method) using the learned model generated in FIG. 5. First, the one or the plurality of storage batteries 101 being evaluation targets are connected in series or parallel to the power supply unit 102 of the charge-discharge device 100, the life evaluation test starts, and acquisition of test condition data starts (S201). A series of the evaluation prediction processing is performed on one storage battery (for each storage battery). However, the plurality of storage batteries being the evaluation targets may be connected to one charge-discharge device 100, and a series of the evaluation prediction processing may be simultaneously executed on the plurality of storage batteries. The test condition data are acquired (received) by the acquisition unit (reception unit) 301 of the entity server 300 from the charge-discharge device terminal 200 via the network N1. A condition of the life evaluation test is assumed to be the same condition as that of the predetermined life evaluation test being a target for prediction except that the evaluation charge-discharge process is performed at the time of the start of the life evaluation test and for each fixed period or each fixed number of cycles.

In FIG. 7, next, the single charge-discharge process of the evaluation charge-discharge protocol is executed on the storage battery at the time of the start of the life evaluation test (brand-new state), and charge-discharge data are acquired (S202). Next, the evaluation charge-discharge process is executed again after a lapse of a fixed period or after an end of a fixed number of charge-discharge cycles, and the charge-discharge data are acquired (S203). The charge-discharge data are measured by the sensor unit 103 of the charge-discharge device 100, and transmitted to the acquisition unit (reception unit) 301 of the entity server 300 via the charge-discharge device terminal 200. Then, a plurality of explanatory variables are extracted from the test condition data and the charge-discharge data (S204). Extraction of the explanatory variables is performed by the explanatory variable extraction unit 302 of the entity server 300. The plurality of explanatory variables include a test condition parameter selected from the test condition data, and an electrochemical parameter acquired by electrochemically analyzing the charge-discharge data, and freely further include one or a plurality of mathematical parameters acquired by mathematically processing a shape of a discharge curve in the charge-discharge process. Details of the test condition parameter, the electrochemical parameter, and the mathematical parameter are as described in the sections of "Explanatory Variable Extraction Unit" described above and "Creation of Database" related to FIG. 5. The explanatory variable may be an explanatory variable preselected in such a way as to improve prediction accuracy by the learned model and/or improve interpretability for a predicted evaluation result. Details of the preselected explanatory variable are as described in the sections of "Explanatory Variable Extraction Unit" described above and "Creation of Learned Model" related to FIG. 5.

In FIG. 7, next, the extracted explanatory variables are input to a learned model (S205), and a predicted evaluation result is acquired, and prediction accuracy is also computed (S206). Input of the explanatory variables to the learned model, and acquisition of the predicted evaluation result and computation of the prediction accuracy are performed by the evaluation prediction unit 304 of the entity server 300. Details of the learned model and the predicted evaluation result are as described in the sections of "Storage Unit", "Learning Processing", and "Evaluation Prediction Unit" described above. As more charge-discharge processes are completed by continuing the life evaluation test longer, and more charge-discharge data are accumulated, the prediction accuracy increases. Further, the prediction accuracy increases by eliminating one or a plurality of explanatory variables having multicollinearity with the other explanatory variable from the input explanatory variables. Details of the prediction accuracy are as described in the section of "Evaluation Prediction Unit" described above.

### <Control of Charging and Discharging of Life Evaluation Test>

In FIG. 7, next, whether the prediction accuracy is equal to or more than a threshold value is determined (S207), and, when an answer is No, i.e., the prediction accuracy is less than the threshold value, the life evaluation test continues until a next process of the evaluation charge-discharge protocol is executed (S208). The steps (S203 to S208) described above are repeated until an answer in S207 is Yes. When an answer in S207 is Yes, the life evaluation test (evaluation charge-discharge protocol) ends (S209). Control of the charge-discharge device 100 based on the prediction accuracy is performed by the control unit 306 of the entity server 300. Details of the control are as described in the section of "Control Unit" described above.

In FIG. 7, lastly, information (prediction information) including the predicted evaluation result and the prediction accuracy is output (S210), and a series of the processing ends. Output of the prediction information is performed by the output unit (transmission unit) 305 of the entity server 300. Details of an output form are as described in the sections of "Output Unit" and "Virtual Environment" described above.

### <Evaluation Prediction of Life Evaluation Test>

FIG. 8 is the flowchart illustrating the example of the motion of the evaluation prediction processing (evaluation result prediction method) using the learned model generated in FIG. 6. FIG. 8 is different from the evaluation prediction processing (evaluation result prediction method) in FIG. 7 in a point that collection of material analysis data is accompanied. First, the plurality of storage batteries 101 being the evaluation targets are connected in series or parallel to the power supply unit 102 of the charge-discharge device 100, the life evaluation test starts, and acquisition of test condition data starts (S201). Details of step S201 are referred to the description of FIG. 7.

In FIG. 8, next, the single charge-discharge process of the evaluation charge-discharge protocol is executed on the storage batteries at the time of the start of the life evaluation test (brand-new state) and charge-discharge data are acquired, and at least one storage battery is disassembled and the material analysis data are acquired (S202). Next, the evaluation charge-discharge process is executed again after a lapse of a fixed period or after an end of a fixed number of charge-discharge cycles and the charge-discharge data are acquired, and at least one storage battery is disassembled and the material analysis data are acquired (S203). The charge-discharge data are measured by the sensor unit 103 of the charge-discharge device 100, and transmitted to the acquisition unit (reception unit) 301 of the entity server 300 via the charge-discharge device terminal 200. The material analysis data are transmitted to the acquisition unit (reception unit) 301 of the entity server 300 from the entity terminal 500 and the like via the network N1. Then, a plurality of explanatory variables are extracted from the test condition data, the charge-discharge data, and the material analysis data (S204). Extraction of the explanatory variables is performed by the explanatory variable extraction unit 302 of the entity server 300. The plurality of explanatory variables include a test condition parameter selected from the test condition data, and an electrochemical parameter acquired by electrochemically analyzing the charge-discharge data, and freely further include one or a plurality of mathematical parameters acquired by mathematically processing a shape of a discharge curve in the charge-discharge process. The plurality of explanatory variables freely further include one or a plurality of material analysis parameters extracted from the material analysis data. Details of the test condition parameter, the electrochemical parameter, the mathematical parameter, and the material analysis parameter are as described in the sections of "Explanatory Variable Extraction Unit" described above and "Creation of Database" related to FIG. 6. The explanatory variable may be an explanatory variable preselected in such a way as to improve prediction accuracy by the learned model and/or improve interpretability for a predicted evaluation result. Details of the preselected explanatory variable are as described in the sections of "Explanatory Variable Extraction Unit" described above and "Creation of Learned Model" related to FIG. 6.

In FIG. 8, next, the extracted explanatory variables are input to a learned model (S205), and a predicted evaluation result is acquired and prediction accuracy is also computed (S206). Input of the explanatory variables to the learned model, and acquisition of the predicted evaluation result and computation of the prediction accuracy are performed by the evaluation prediction unit 304 of the entity server 300. Details of the learned model and the predicted evaluation result are as described in the sections of "Storage Unit", "Learning Processing", and "Evaluation Prediction Unit" described above. As more charge-discharge processes are completed by continuing the life evaluation test longer, and more charge-discharge data are accumulated, the prediction accuracy increases. Further, the prediction accuracy increases by eliminating one or a plurality of explanatory variables having multicollinearity with the other explanatory variable from the input explanatory variables. Details of the prediction accuracy are as described in the section of "Evaluation Prediction Unit" described above.

### <Control of Charging and Discharging of Life Evaluation Test>

In FIG. 8, next, whether the prediction accuracy is equal to or more than a threshold value is determined (S207), and, when an answer is No, i.e., the prediction accuracy is less than the threshold value, the life evaluation test continues until a next process of the evaluation charge-discharge protocol is executed (S208). The steps (S203 to S208) described above are repeated until an answer in S207 is Yes. When an answer in S207 is Yes, the life evaluation test (evaluation charge-discharge protocol) ends (S209). Control of the charge-discharge device 100 based on the prediction accuracy is performed by the control unit 306 of the entity server 300. Details of the control are as described in the section of "Control Unit" described above.

In FIG. 8, lastly, information (prediction information) including the predicted evaluation result and the prediction accuracy is output (S210), and a series of the processing ends. Output of the prediction information is performed by the output unit (transmission unit) 305 of the entity server 300. The predicted evaluation result as output of the evaluation prediction processing in FIG. 8 further includes predicted deterioration information when the end of life is reached. Details of an output form are as described in the sections of "Output Unit" and "Virtual Environment" described above.

### <<Learning Processing of Data on Energy Density and Power Density>>

FIG. 12 is a flowchart illustrating an example of a motion of learning processing of a learned model that outputs a predicted evaluation result including energy density and power density being measured by the predetermined charge-discharge protocol. It should be noted that a flow of the motion described below is performed in cooperation with each element mainly by the explanatory variable extraction unit 302 and the learning processing unit 307 included in the processing unit of the entity server 300, based on the program stored in the storage unit 303 of the entity server 300.

### <Creation of Database of Data on Energy Density and Power Density>

First, the one or the plurality of storage batteries 101 for supervised data collection are connected in series or parallel to the power supply unit 102 of the charge-discharge device 100, and the predetermined charge-discharge protocol is executed (S301). The storage battery for supervised data collection is preferably the same kind (such as an LiB, a lead storage battery, or a nickel-hydrogen secondary battery) in terms of a category as a storage battery being an evaluation target, and a storage battery having at least one of materials (such as a positive electrode active material, a negative electrode active material, a material of a separator, and a material of an electrolyte) used for members (such as a positive electrode, a negative electrode, a separator, and an electrolyte) in common is more preferably used.

Next, an evaluation result by the predetermined charge-discharge protocol is acquired (S302). The evaluation result includes energy density and power density acquired by processing charge-discharge data measured by the sensor unit 103 of the charge-discharge device 100. The acquired evaluation result is used as supervised data. Therefore, when there are a plurality of measurement conditions of the energy density and the power density in the predetermined charge-discharge protocol, all of the measurement conditions are basically acquired. For example, when the IEC62660-1 is set as a target as the predetermined charge-discharge protocol, an acquired evaluation result includes all of (1) energy density at 25°C, (2) power density at 25°C and an SOC of 20%, (3) power density at 25°C and the SOC of 50%, (4) power density at 25°C and the SOC of 80%, (5) power density at -20°C and the SOC of 50%, (6) power density at 0°C and the SOC of 50%, and (7) power density at 45°C and the SOC of 50%. However, only a part of the evaluation results may be acquired as supervised data for a part of the storage batteries.

Next, the evaluation charge-discharge protocol is executed on the one or the plurality of storage batteries connected in series or parallel (S303). The storage battery on which the evaluation charge-discharge protocol is executed is basically the same individual as the storage battery on which the predetermined charge-discharge protocol described above is performed. However, for a purpose of shortening time for database creation, and the like, the evaluation charge-discharge protocol may be executed on an individual different from the storage battery of the same lot (a plurality of storage batteries manufactured at once by the same material and the same condition) as the storage battery on which the predetermined charge-discharge protocol is performed. The charge-discharge data acquired by the evaluation charge-discharge protocol are used for computing an explanatory variable being an input of the learning processing later. Therefore, when the evaluation charge-discharge protocol includes a plurality of single charge-discharge processes, all of the single charge-discharge processes are basically executed. For example, when the evaluation charge-discharge protocol shown in Table 2 described above is used, all of the first to fourth single charge-discharge processes are executed. However, only a part of the charge-discharge processes may be executed on a part of the storage batteries.

Next, the charge-discharge data by the evaluation charge-discharge protocol are acquired (S304). The charge-discharge data are measured by the sensor unit 103 of the charge-discharge device 100, and transmitted to the charge-discharge device terminal 200. Then, a plurality of explanatory variables are computed (extracted) from the charge-discharge data (S305). Computation of the explanatory variables is performed by the explanatory variable extraction unit 302 of the entity server 300. The explanatory variables include both of an electrochemical parameter acquired by electrochemically analyzing the charge-discharge data, and a mathematical parameter acquired by mathematically processing a shape of a discharge curve in the charge-discharge process.

The electrochemical parameter includes energy density and power density, and freely includes data on voltage relaxation behavior. The electrochemical parameter can be computed (extracted) by electrochemically analyzing the single charge-discharge process of the evaluation charge-discharge protocol, and includes the energy density, the power density, and the voltage relaxation behavior. Details of computation of the electrochemical parameter are as described in the item of "Explanatory Variable Extraction Unit" described above. For example, when the evaluation charge-discharge protocol shown in Table 2 described above is used, the energy density, the power density at the SOC of 80%, the SOC of 50%, and the SOC of 20%, and the voltage relaxation behavior at each temperature are acquired from the first to fourth single charge-discharge processes. The acquired electrochemical parameters are each a candidate for an explanatory variable when a "selected explanatory variable" is decided.

The mathematical parameter can be extracted by mathematically processing a shape of a discharge curve in the charge-discharge process. The mathematical parameter includes, for example, data acquired by mathematically processing a discharge curve freely combining a voltage of the storage battery on a vertical axis, and a time, a current capacity, an SOC, and the like on a horizontal axis. FIG. 4 is the diagram illustrating the example of computation of the mathematical parameters as the explanatory variables. As exemplified in FIG. 4, the mathematical parameter is acquired by factorizing the matrix representing the shape of the discharge curve. First, for discharge curve data in which a value of an SOC of the storage battery is the horizontal axis and a value of a voltage (V) corresponding to the value of the SOC is the vertical axis, the matrix X with A rows and B columns acquired by arranging values of B (B ≥ 2) different SOCs in a column and arranging, as elements, values of the voltage (V) of the plurality of storage batteries (the sample number is assumed to be A (A ≥ 2)) corresponding to the values of the SOCs is acquired. The number B of values of the SOCs to be adopted may be about 10 to 1,000. For example, as exemplified in FIG. 4, when values of the SOCs are divided into 1% increments from 100% to 0%, B is 101 in total of 100%, 99%, 98%, ..., 2%, 1%, and 0%. The sample number A of the storage batteries is, for example, 10 or more, 50 or more, 100 or more, 500 or more, or 1,000 or more, and prediction accuracy of the learned model improves as the sample number A increases. Next, a mathematical constraint is imposed, and the matrix X is then factorized into X ≈ W × H (in the equation, the matrix W is a coefficient matrix with A rows and C columns, and the matrix H is a basis matrix with C rows and B columns). The mathematical constraint is determined in such a way that the matrix W and the matrix H are uniquely decided. C is, for example, equal to or less than the same number as the number B of values of the SOCs. As a method of the matrix factorization, principal component analysis, non-negative matrix factorization, and the like can be used. C coefficient matrices (referred to as a "first principal component" to a "C-th principal component" in an order from a first column) in the matrix W are each a candidate for an explanatory variable when a "selected explanatory variable" is decided.

It should be noted that execution of the predetermined charge-discharge protocol and acquisition of the evaluation result (S301 and S302) and execution of the evaluation charge-discharge protocol to computation of the explanatory variable (S303 to S305) may be a reversed order (an order of S303 to S305 first and S301 and S302 later). Further, when the plurality of storage batteries of the same lot are used as described above, the predetermined charge-discharge protocol and the evaluation charge-discharge protocol may be performed simultaneously (S301 and S302, and S303 to S305 may be performed simultaneously).

Next, a database including the explanatory variables and the evaluation result is created (S306). The database includes the plurality of explanatory variables computed from the charge-discharge data by the evaluation charge-discharge protocol described above, and the evaluation result by the predetermined charge-discharge protocol being associated with the explanatory variables, and the database is stored in the storage unit 303 of the entity server 300. For example, when the evaluation charge-discharge protocol shown in Table 2 described above is used, and B = C = 101 as exemplified in FIG. 4, 106 parameters in total of five electrochemical parameters (energy density, power density of the SOC of 80%, power density of the SOC of 50%, power density of the SOC of 20%, and voltage relaxation behavior) and 101 (first principal component to 101-st principal component) mathematical parameters are generated from one single charge-discharge process for one storage battery. In other words, when all of the first to fourth single charge-discharge processes are executed, 424 parameters in total in which 4 temperatures × 106 are generated. The parameters are stored as explanatory variables (input variables) providing an evaluation result being a target variable (output variable) in the database.

### <Generation of Learned Model of Data on Energy Density and Power Density>

Lastly, the learned model is generated and stored by using the explanatory variables and the evaluation result as supervised data (S307), and a series of the processing ends. Generation of the learned model can be performed by previously learning a machine learning model by supervised learning such as, for example, ridge regression, support vector regression, or a neural network. As an input variable, data acquired by standardizing the explanatory variables described above (processing of setting an average of data as 0 and setting a standard deviation as 1) are used. It should be noted that an evaluation result as an output variable may be standardized. Next, the machine learning model is caused to learn the input variable and the output variable (evaluation result) corresponding to the input variable, and prediction accuracy of the model is calculated. As an index of the prediction accuracy, a determination coefficient (R² value), a root mean squared error (RMSE), a mean absolute error (MAE), a mean absolute percentage error (MAPE), and the like can be used. When the prediction accuracy is verified, cross validation is preferably performed. Then, a hyper parameter is adjusted in such a way that the prediction accuracy of the machine learning model is the highest.

The input variable is preferably a combination of explanatory variables selected from among the plurality of explanatory variables described above in such a way as to improve prediction accuracy by the learned model and/or improve interpretability for a predicted evaluation result. More specifically, the input variable may be an explanatory variable selected by eliminating one or a plurality of parameters having multicollinearity with the other parameter instead of using all parameters acquired in computation of the explanatory variables described above (S305). Examples of the method for selecting an explanatory variable include a method using, for example, Boruta, recursive feature elimination, a genetic algorithm (GA), and the like. Boruta is a variable selection method based on variable importance of random forest (RF), and the method selects an explanatory variable by adding a dummy variable to the explanatory variable, constructing a model of random forest, computing importance of each variable, and deleting a variable having lower importance than the dummy variable. The recursive feature elimination is a method for deleting an explanatory variable having lowest importance from a state where a prediction model is created by using all explanatory variables, creating a prediction model again with remaining explanatory variables, and deleting an explanatory variable having lowest importance again until explanatory variables reach the number designated in advance. The genetic algorithm (GA) is a method for solving an optimization problem by considering two options of whether or not (1 or 0) to use each explanatory variable, and finding a combination of the explanatory variables in such a way as to determine which explanatory variable is used to maximize accuracy. From a viewpoint of prediction accuracy and interpretability, it is preferable to try all the techniques and then select the technique in which the prediction accuracy and the interpretability are the most excellent. For example, for 424 parameters in total acquired from the evaluation charge-discharge protocol shown in Table 2 described above, examples of explanatory variables selected by using the genetic algorithm (GA) are shown in Table 4 below. The selected explanatory variables correspond to "preselected explanatory variables" (Table 3 described above) in the motions of the evaluation result prediction device and system and the evaluation prediction method and program of the present disclosure. The combinations of the explanatory variables, and prediction accuracy shown in Table 4 below are merely exemplifications.

**[Table 4]**

| CHARGE-DISCHARGE PROCESS | TEMPERATURE | SELECTED EXPLANATORY VARIABLE | ACCUMULATED PREDICTION ACCURACY |
|---|---|---|---|
| FIRST | 25°C | E DENSITY, P DENSITY (SOC 80%), AND FIRST PRINCIPAL COMPONENT TO FIFTH PRINCIPAL COMPONENT | 40% |
| SECOND | -20°C | E DENSITY, P DENSITY (SOC 50%), AND FIRST PRINCIPAL COMPONENT TO FOURTH PRINCIPAL COMPONENT | 70% |
| THIRD | 45°C | E DENSITY, P DENSITY (SOC 20%), AND FIRST PRINCIPAL COMPONENT TO THIRD PRINCIPAL COMPONENT | 85% |
| FOURTH | 0°C | P DENSITY (SOC 80%), AND FIRST PRINCIPAL COMPONENT TO SECOND PRINCIPAL COMPONENT | 90% |

As described above, the learned model being learned in such a way as to output a predicted evaluation result including energy density and power density being measured by the predetermined charge-discharge protocol when a plurality of explanatory variables extracted from charge-discharge data on a storage battery are input can be generated. The generated learned model is stored in the storage unit 303 of the entity server 300.

### <<Evaluation Prediction Processing of Energy Density and Power Density>>

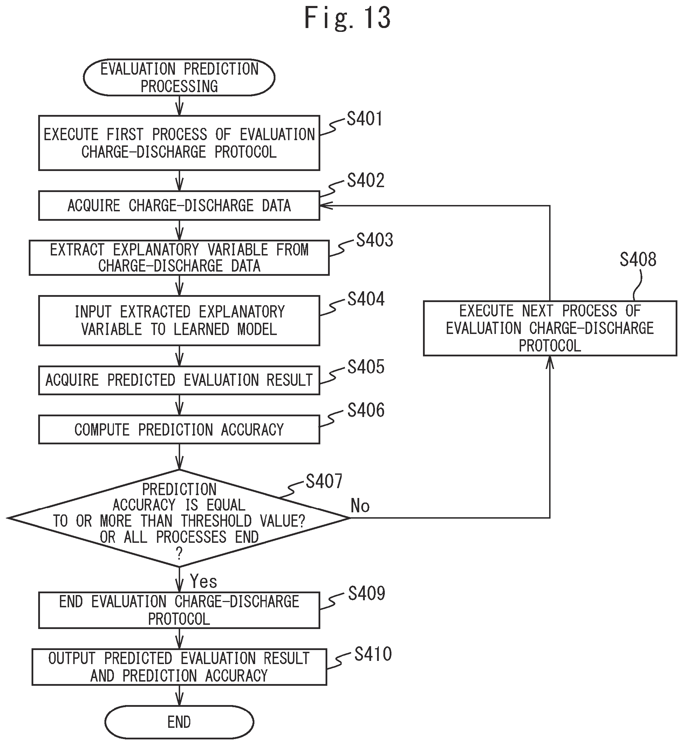

FIG. 13 is a flowchart illustrating an example of a motion of the evaluation prediction processing (evaluation result prediction method). It should be noted that a flow of the motion described below is performed in cooperation with each element of the evaluation result prediction device and system mainly by the explanatory variable extraction unit 302, the evaluation prediction unit 304, and the control unit 306 included in the processing unit of the entity server 300, based on the evaluation result prediction program of the present disclosure stored in the storage unit 303 of the entity server 300.

### <Evaluation Prediction of Energy Density and Power Density>

First, the one or the plurality of storage batteries 101 are connected in series or parallel to the power supply unit 102 of the charge-discharge device 100, and the first single charge-discharge process of the evaluation charge-discharge protocol is executed (S401). A series of the evaluation prediction processing is performed on one storage battery (for each storage battery). However, the plurality of storage batteries being the evaluation targets may be connected to one charge-discharge device 100, and a series of the evaluation prediction processing may be simultaneously executed on the plurality of storage batteries.

Next, charge-discharge data are acquired (S402). The charge-discharge data are measured by the sensor unit 103 of the charge-discharge device 100, and transmitted to the charge-discharge device terminal 200. Then, a plurality of explanatory variables are extracted from the charge-discharge data (S403). Extraction of the explanatory variables is performed by the explanatory variable extraction unit 302 of the entity server 300. The plurality of explanatory variables include an electrochemical parameter acquired by electrochemically analyzing the charge-discharge data, and freely further include one or a plurality of mathematical parameters acquired by mathematically processing a shape of a discharge curve in the charge-discharge process. Details of the electrochemical parameter and the mathematical parameter are as described in the sections of "Explanatory Variable Extraction Unit" and "Creation of Database" described above. The explanatory variable may be an explanatory variable preselected in such a way as to improve prediction accuracy by the learned model and/or improve interpretability for a predicted evaluation result. Details of the preselected explanatory variable are as described in the sections of "Explanatory Variable Extraction Unit" and "Creation of Learned Model" described above.

Next, the extracted explanatory variables are input to a learned model (S404), and a predicted evaluation result is acquired (S405). Input of the explanatory variables to the learned model and acquisition of the predicted evaluation result are performed by the evaluation prediction unit 304 of the entity server 300. Details of the learned model and the predicted evaluation result are as described in the sections of "Storage Unit", "Learning Processing", and "Evaluation Prediction Unit" described above.

Next, prediction accuracy of the predicted evaluation result is computed (S406). Computation of the prediction accuracy is also performed by the evaluation prediction unit 304 of the entity server 300. As more charge-discharge processes are completed, and more charge-discharge data are accumulated, the prediction accuracy increases. Further, the prediction accuracy increases by eliminating one or a plurality of explanatory variables having multicollinearity with the other explanatory variable from the input explanatory variables (Table 2 and Table 3). Details of the prediction accuracy are as described in the section of "Evaluation Prediction Unit" described above.

### <Control of Charging and Discharging of Energy Density and Power Density>

Next, whether the prediction accuracy is equal to or more than a threshold value is determined or whether all of the processes has ended is determined (S407), and, when an answer is No, i.e., the prediction accuracy is less than the threshold value and all of the processes has not ended, a next process of the evaluation charge-discharge protocol is executed (S408). The steps (S402 to S408) described above are repeated until an answer in S407 is Yes. When an answer in S407 is Yes, the evaluation charge-discharge protocol ends (S409). Control of the charge-discharge device 100 based on the prediction accuracy is performed by the control unit 306 of the entity server 300. Details of the control are as described in the section of "Control Unit" described above.

Lastly, information (prediction information) including the predicted evaluation result and the prediction accuracy is output (S410), and a series of the processing ends. Output of the prediction information is performed by the output unit (transmission unit) 305 of the entity server 300. Details of an output form are as described in the sections of "Output Unit" and "Virtual Environment" described above.

### <<Modification Example>>

The case where the entity server in the evaluation result prediction system has functions as the "evaluation result prediction device" that predicts an evaluation result measured in the predetermined life evaluation test and/or predicts energy density and power density of a storage battery being successively measured by the predetermined charge-discharge protocol is described above as one example of the embodiment. However, when the evaluation result prediction system of the present disclosure can execute the evaluation prediction processing and the like of the present disclosure as the entire system mutually connected via a network, any device constituting the system may function as the "evaluation result prediction device". Each device (functional unit) constituting the evaluation result prediction system, i.e., an acquisition device (acquisition unit), an explanatory variable extraction device (explanatory variable extraction unit), a storage device (storage unit), an evaluation prediction device (evaluation prediction unit), an output device (output unit), a control device (control unit), a learning processing device (learning processing unit), and the like may be constituted by a single device (a single device may include all functional units), or may be constituted by a plurality of devices mutually connected via a network. When the evaluation result prediction system is constituted by a plurality of devices, one device may include one or a plurality of functional units, and the same functional unit may be mounted on the plurality of devices.

### <Modification Example 1>

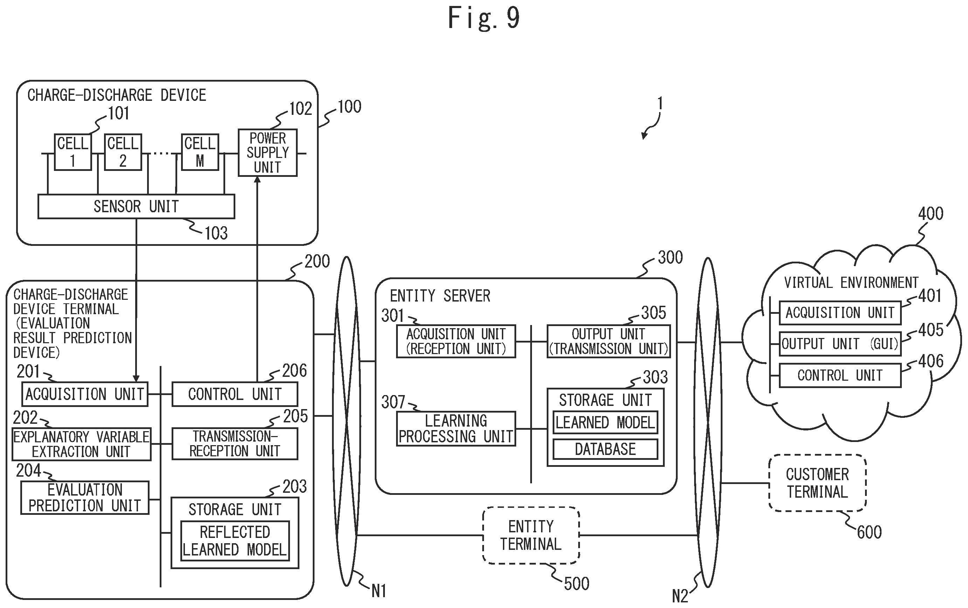

FIG. 9 is a diagram illustrating an example of the evaluation result prediction system 1 according to the embodiment of the present disclosure in FIG. 1. The evaluation result prediction system 1 includes the charge-discharge device 100, the charge-discharge device terminal 200 being communicably connected to the charge-discharge device 100 and serving as the "evaluation result prediction device", the entity server 300 communicably connected to the charge-discharge device terminal 200 via the private network N1 of the entity, and the virtual environment 400 constructed on the network N2 and communicably connected to the entity server 300. The evaluation result prediction system 1 can be accessed from a terminal device such as the entity terminal 500 and the customer terminal 600 indicated by a broken line. The entity terminal 500 is communicably connected to the charge-discharge device terminal 200 and the entity server 300 via the private network N1 of the entity, and is also communicably connected to the virtual environment 400 and the customer terminal 600 via the network N2. The customer terminal 600 is communicably connected to the virtual environment 400 and the entity terminal 500 via the network N2. In cooperation with each element mainly by the charge-discharge device terminal 200, the evaluation result prediction system 1 can predict an evaluation result that may be acquired if the predetermined life evaluation test and/or the predetermined charge-discharge protocol is performed on a storage battery being an evaluation target, based on the test condition data of the life evaluation test, and the charge-discharge data acquired by executing charging and discharging based on the evaluation charge-discharge protocol on the storage battery being the evaluation target.

The charge-discharge device terminal 200 in FIG. 9 includes the acquisition unit 201, an explanatory variable extraction unit 202, a storage unit 203 that stores a reflected learned model and the like, an evaluation prediction unit 204, and an output unit (a transmission unit of a transmission-reception unit) 205, and thus functions as the "evaluation result prediction device". The acquisition unit 201 acquires the test condition data from the charge-discharge device 100. Further, the acquisition unit 201 directly acquires the charge-discharge data on the storage battery based on the evaluation charge-discharge protocol from the sensor unit 103 of the charge-discharge device 100. Furthermore, the acquisition unit 201 acquires (receives) the material analysis data on the storage battery from the entity terminal 500 and the like via the network N1. The explanatory variable extraction unit 202 extracts a plurality of explanatory variables from the test condition data, the charge-discharge data, and the material analysis data. And/or the explanatory variable extraction unit 202 extracts a plurality of explanatory variables including an electrochemical parameter including energy density and power density from the charge-discharge data. The storage unit 203 stores a reflected learned model being learned in such a way as to output a predicted evaluation result measured by the predetermined life evaluation test when the plurality of explanatory variables are input, and or being learned in such a way as to output a predicted evaluation result including the energy density and the power density being measured by the predetermined charge-discharge protocol when the plurality of explanatory variables are input. The "reflected" learned model is a learned model stored in the storage unit 203 of the charge-discharge device terminal 200 by receiving the learned model generated by the entity server 300 via the network N1, and, when there is an update of the learned model on the entity server 300 side, the update is reflected at any time. The evaluation prediction unit 204 acquires a predicted evaluation result by inputting the plurality of explanatory variables to the learned model, and computes prediction accuracy of the predicted evaluation result. Then, the output unit (the transmission unit of the transmission-reception unit) 205 outputs (transmits) prediction information including the predicted evaluation result and the prediction accuracy to the acquisition unit (reception unit) 301 of the entity server 300 via the network N1. Further, the output unit (the transmission unit of the transmission-reception unit) 205 outputs (transmits) the evaluation result of the predetermined life evaluation test and/or the predetermined charge-discharge protocol, and data needed for constructing a database such as the charge-discharge data of the evaluation charge-discharge protocol and a computed explanatory variable to the acquisition unit (reception unit) 301 of the entity server 300 via the network N1. The charge-discharge device terminal 200 further includes the control unit 206, and can control the charge-discharge device 100, based on the prediction accuracy.

The entity server 300 in FIG. 9 includes the acquisition unit (reception unit) 301, the storage unit 303 that stores the learned model, the database, and the like, the output unit (transmission unit) 305, and the learning processing unit 307. The acquisition unit (reception unit) 301 acquires (receives) the prediction information, and the data needed for constructing the database from the output unit (the transmission unit of the transmission-reception unit) 205 of the charge-discharge device terminal 200 via the network N1, and stores the prediction information and the data in the storage unit 303. The output unit (transmission unit) 305 outputs (transmits) the prediction information in real time to the virtual environment 400 via the network N2. The learning processing unit 307 can perform generation and relearning of the learned model, based on the constructed database. The generated learned model is stored in the storage unit 303, also transmitted from the output unit (transmission unit) 305 to the reception unit (the reception unit of the transmission-reception unit) 205 of the charge-discharge device terminal 200 via the network N1, and reflected in the storage unit 203 of the charge-discharge device terminal 200.

In FIG. 9, the entity terminal 500 is communicably connected to the charge-discharge device terminal 200 and the entity server 300 via the private network N1 of the entity. Further, the entity terminal 500 is communicably connected to the virtual environment 400 and the customer terminal 600 via the network N2. The customer terminal 600 is communicably connected to the virtual environment 400 via the network N2, and can display the GUI of the virtual environment 400.

For details of each functional unit and the processing in FIG. 9, the description of each functional unit and the processing described for FIGS. 1 to 8 is quoted. In the aspect of FIG. 9, the charge-discharge device terminal 200 that performs the evaluation prediction processing and the entity server 300 that performs generation of the learned model and accumulation of data are separated, and there is an advantage that hardware resources related to a mathematical operation, data retention, and the like can be dispersed.

### <Modification Example 2>

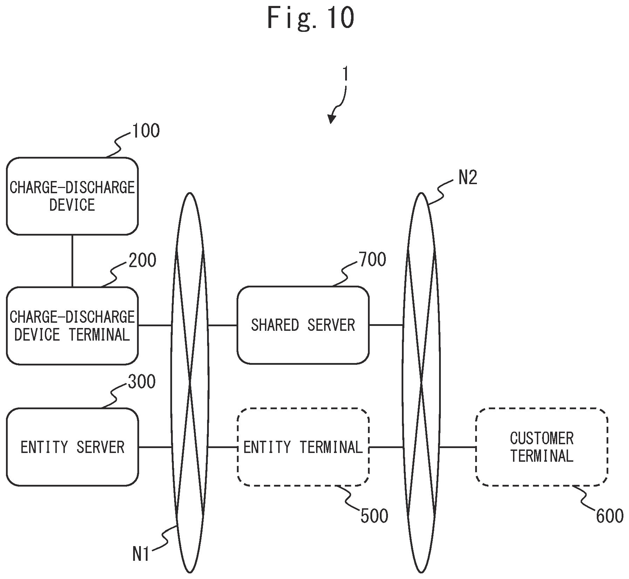

FIG. 10 is a diagram illustrating a schematic configuration of the evaluation result prediction system 1 according to the embodiment of the present disclosure. The evaluation result prediction system 1 includes the charge-discharge device 100, the charge-discharge device terminal 200 communicably connected to the charge-discharge device 100, the entity server 300 communicably connected to the charge-discharge device terminal 200 and a shared server 700 via the private network N1 of the entity, and the shared server 700 communicably connected to the charge-discharge device terminal 200 and the entity server 300 via the network N1. The evaluation result prediction system 1 can be accessed from a terminal device such as the entity terminal 500 and the customer terminal 600 indicated by a broken line. The entity terminal 500 is communicably connected to the charge-discharge device terminal 200, the entity server 300, and the shared server 700 via the private network N1 of the entity, and is also communicably connected to the shared server 700 and the customer terminal 600 via the network N2. The customer terminal 600 is communicably connected to the shared server 700 and the entity terminal 500 via the network N2.

FIG. 11 is a diagram illustrating an example of the evaluation result prediction system 1 according to the embodiment of the present disclosure in FIG. 10. The shared server 700 in FIG. 11 is an information processing terminal positioned at a higher level than the charge-discharge device terminal 200 as a control system, and is more specifically a SCADA terminal, for example. The shared server 700 includes an acquisition unit (reception unit) 701, an explanatory variable extraction unit 702, a storage unit 703 that stores a reflected learned model and the like, an evaluation prediction unit 704, and an output unit (GUI) 705, and thus functions as the "evaluation result prediction device". The acquisition unit (reception unit) 701 acquires the test condition data from the charge-discharge device terminal 200 via the network N1. Further, the acquisition unit (reception unit) 701 acquires (receives) the charge-discharge data on the storage battery based on the evaluation charge-discharge protocol from the transmission-reception unit 205 of the charge-discharge device terminal 200 via the network N1. Furthermore, the acquisition unit (reception unit) 701 acquires (receives) the material analysis data on the storage battery from the entity terminal 500 and the like via the network N1. The explanatory variable extraction unit 702 extracts a plurality of explanatory variables from the test condition data, the charge-discharge data, and the material analysis data. And/or the explanatory variable extraction unit 702 extracts a plurality of explanatory variables including an electrochemical parameter including energy density and power density from the charge-discharge data. The storage unit 703 stores a reflected learned model being learned in such a way as to output a predicted evaluation result measured by the predetermined life evaluation test, and or being learned in such a way as to output a predicted evaluation result including the energy density and the power density being measured by the predetermined charge-discharge protocol when the plurality of explanatory variables are input. The "reflected" learned model is a learned model stored in the storage unit 703 of the shared server 700 by receiving the learned model generated by the entity server 300 via the network N1, and, when there is an update of the learned model on the entity server 300 side, the update is reflected at any time. The evaluation prediction unit 704 acquires a predicted evaluation result by inputting the plurality of explanatory variables to the learned model, and computes prediction accuracy of the predicted evaluation result. Then, the output unit (GUI) 705 outputs (displays) prediction information including the predicted evaluation result and the prediction accuracy in a form of the GUI. The shared server 700 further includes a control unit 706, and can control the charge-discharge device 100, based on the prediction accuracy.

The entity server 300 in FIG. 11 includes the acquisition unit (reception unit) 301, the storage unit 303 that stores the learned model, the database, and the like, the output unit (transmission unit) 305, and the learning processing unit 307. The acquisition unit (reception unit) 301 acquires (receives) an evaluation result of the predetermined life evaluation test and/or the predetermined charge-discharge protocol, and data needed for constructing a database such as the charge-discharge data of the evaluation charge-discharge protocol and a computed explanatory variable from the transmission-reception unit 205 of the charge-discharge device terminal 200 via the network N1, and stores the evaluation result and the data in the storage unit 303. The learning processing unit 307 can perform generation and relearning of the learned model, based on the constructed database. The generated learned model is stored in the storage unit 303, also transmitted from the output unit (transmission unit) 305 to the acquisition unit (reception unit) 701 of the shared server 700 via the network N1, and reflected in the storage unit 703 of the shared server 700.

In FIG. 11, the entity terminal 500 is communicably connected to the charge-discharge device terminal 200, the entity server 300, and the shared server 700 via the private network N1 of the entity. Further, the entity terminal 500 is communicably connected to the shared server 700 and the customer terminal 600 via the network N2. The customer terminal 600 is communicably connected to the shared server 700 via the network N2, and can display the GUI of the shared server 700.

For details of each functional unit and the processing in FIG. 11, the description of each functional unit and the processing described for FIGS. 1 to 8 is quoted. In the aspect of FIG. 11, the shared server 700 that performs the evaluation prediction processing and the entity server 300 that performs generation of the learned model and accumulation of data are separated, and there is an advantage that hardware resources related to a mathematical operation, data retention, and the like can be dispersed.

### <<Manipulable Factor Prediction Method>>

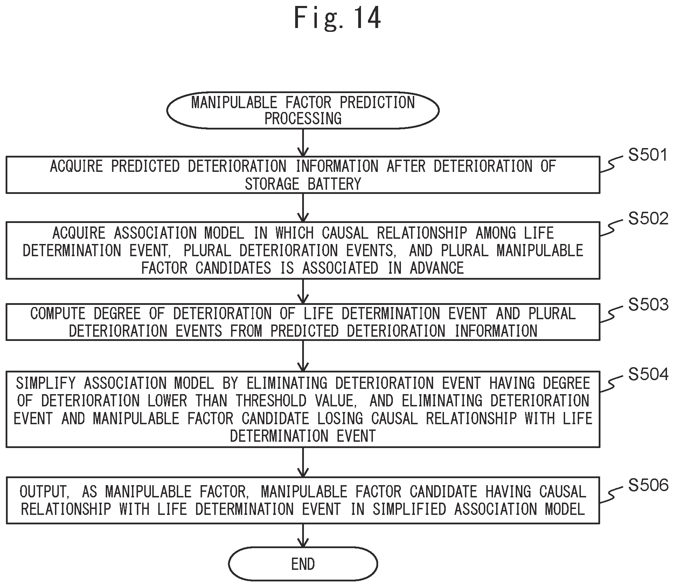

FIG. 14 illustrates an example of processing in a manipulable factor prediction method of the present disclosure. The manipulable factor prediction method of the present disclosure is a method for predicting a manipulable factor being a factor in terms of design of a storage battery that influences life of the storage battery. It should be noted that a flow of the processing described below can be executed in cooperation with each element of the manipulable factor prediction device or system mainly by an acquisition unit (acquisition device), a deterioration degree computation unit (deterioration degree computation device), a storage unit (storage device), a simplified association model generation unit (simplified association model generation device), and an output unit (output device) in the manipulable factor prediction device or system, based on a manipulable factor prediction program of the present disclosure being stored in the storage unit or the storage device in the manipulable factor prediction device or system.

In FIG. 14, the method includes: a step (S501) of acquiring predicted deterioration information after deterioration of a storage battery; a step (S502) of acquiring an association model in which a causal relationship among a life determining event being a reference for life determination of the storage battery, a plurality of deterioration events, and a plurality of manipulable factor candidates is associated in advance; a step (S503) of computing a degree of deterioration of each of the life determination event and the plurality of deterioration events from the acquired predicted deterioration information; a step (S504) of simplifying the association model by eliminating the deterioration event in which the degree of deterioration is low, and the like; and a step (S506) of outputting, as a manipulable factor, the manipulable factor candidate having the causal relationship with the life determination event in the simplified association model.

In general, the deterioration event appearing together with deterioration of a storage battery includes various deterioration events such as a charge-discharge characteristic deterioration event such as an increase in a resistance component in the charge-discharge data; an electrochemical analytical deterioration event such as an ohmic resistance increase, a reaction resistance increase; and a diffusion resistance increase; and a material analytical deterioration event such as SEI formation, a current collection resistance increase, and separator clogging, and each deterioration event has a complicated causal relationship with the life determination event being a reference for life determination of the storage battery. Further, the manipulable factor candidate being a factor in terms of design of the storage battery that may improve the deterioration events also has massive options, and has a complicated causal relationship with the life determination event and the plurality of deterioration events. Thus, it is difficult to predict which specific manipulable factor needs to be manipulated to efficiently improve the life of the storage battery from the predicted deterioration information after deterioration of the storage battery. In this point, according to the method of the present disclosure, by preparing the association model in which the causal relationship among the life determination event, the plurality of deterioration events, and the plurality of manipulable factor candidates is associated in advance, and simplifying the association model, based on a degree of deterioration, the deterioration event having a small degree of deterioration, i.e., the deterioration event having little latitude (hereinafter referred to as an "improvement margin") of the degree of deterioration that may be improved, and the deterioration event considered to have a low or no causal relationship with the life determination event are eliminated. In this way, a main deterioration event having a direct or indirect mutual relationship with the life determination event can be recognized, and thus the manipulable factor that influences the life can be easily extracted. Therefore, the method of the present disclosure can contribute to an efficient life improvement in the storage battery.

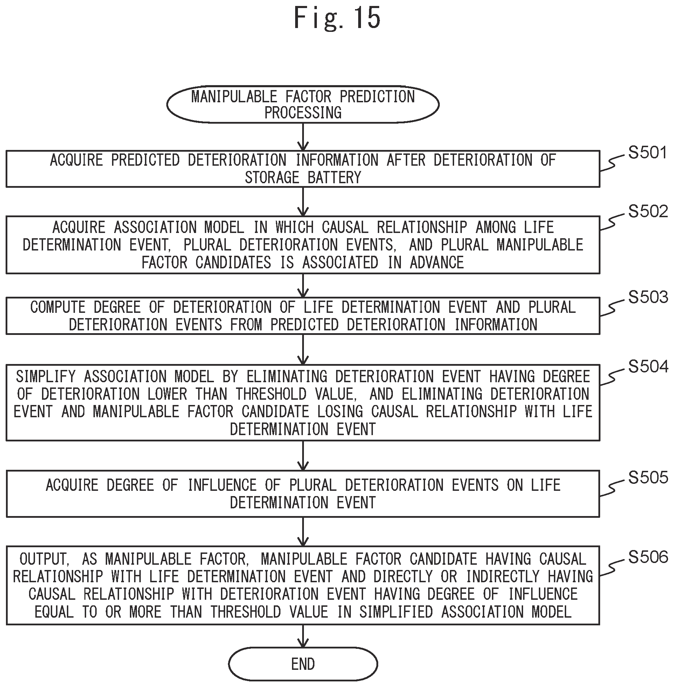

FIG. 15 illustrates a modification example of the processing in the manipulable factor prediction method of the present disclosure. It should be noted that a flow of the processing in FIG. 15 can also be executed in cooperation with the manipulable factor prediction device or system mainly by the acquisition unit (acquisition device), the deterioration degree computation unit (deterioration degree computation device), the storage unit (storage device), the simplified association model generation unit (simplified association model generation device), an influence degree acquisition unit (influence degree acquisition device), and the output unit (output device) in the manipulable factor prediction device or system, based on the manipulable factor prediction program of the present disclosure being stored in the storage unit or the storage device in the manipulable factor prediction device or system.

As illustrated in FIG. 15, the manipulable factor prediction method may further include a step (S505) of acquiring a degree of influence of the plurality of deterioration events on the life determination event. In the step (S505) of acquiring the degree of influence, the degree of influence corresponding to each of one or more of the plurality of deterioration events can be acquired by inputting the degree of deterioration of the life determination event and the degrees of deterioration of the plurality of deterioration events to a learned model being learned in such a way as to output the degree of influence representing an improvement effect with respect to the degree of deterioration of the life determination event when one or more of the plurality of deterioration events are each improved in a case where the degree of deterioration of the life determination event and the degrees of deterioration of the plurality of deterioration events are input. In this aspect, in the output step (S506), one or a plurality of manipulable factor candidates directly or indirectly having a causal relationship with the one or the plurality of deterioration events having the degree of influence equal to or more than a threshold value in the simplified association model can be output as a manipulable factor that influences the life of the storage battery. Herein, the "degree of influence" represents a degree of contribution to a life improvement effect, i.e., an extent to which a degree of deterioration of the life determination event may be improved when a degree of deterioration of the deterioration event is improved. In the aspect in FIG. 15, similarly to the aspect in FIG. 14, the simplified association model is used based on the degree of deterioration, and thus a manipulable factor candidate having a degree of deterioration lower than the threshold value and a manipulable factor candidate considered to have no causal relationship with the life determination event are excluded in advance. By considering the degree of influence in addition to the degree of deterioration, a manipulable factor having a great improvement margin and having a high improvement effect with respect to a degree of deterioration of the life determination event can be easily predicted, which can more greatly contribute to an efficient life improvement in the storage battery.

### <Step of Acquiring Predicted Deterioration Information>

In the step (S501) of acquiring predicted deterioration information, at least one piece of the predicted deterioration information selected from a group consisting of a predicted charge-discharge characteristic, predicted electrochemical analysis data, and predicted material analysis data after deterioration of the storage battery is acquired. Herein, the storage battery "after deterioration" refers to the storage battery in any deterioration state when charging and discharging are repeated on the storage battery in a brand-new state. For example, the storage battery after deterioration may be a storage battery at a time at which the end of life is reached when the predetermined life evaluation test is performed on the storage battery. More specifically, examples of the predetermined life evaluation test include a storage test, a cycle test, and the like of a storage battery defined by the IEC62660-1 (performance test) standardized by the International Electrotechnical Commission (IEC).

Examples of the predicted charge-discharge characteristic include energy density, power density, a capacity, charge-discharge efficiency, and the like of the storage battery when the end of life is reached. Including the charge-discharge characteristic in the predicted deterioration information is preferable from a viewpoint of more accurately computing a degree of deterioration of a charge-discharge characteristic deterioration event. Examples of the predicted electrochemical analysis data include data such as charge curve analysis (CCA), discharge curve analysis, a galvanostatic intermittent titration technique (GITT), and electrochemical impedance spectroscopy (EIS) of the storage battery when the end of life is reached. Including the electrochemical analysis data in the predicted deterioration information is preferable from a viewpoint of more accurately computing a degree of deterioration of an electrochemical analytical deterioration event and a material analytical deterioration event. Examples of the predicted material analysis data include nuclear magnetic resonance (NMR) data, ion chromatography (IC) data, scanning electron microscope (SEM) observation data, X-ray diffraction (XRD) data, electron spin resonance (ESR) data, X-ray CT image data, air permeability measurement data, and the like of a material constituting the storage battery when the end of life is reached. Including the material analysis data in the predicted deterioration information is preferable from a viewpoint of more accurately computing a degree of deterioration of the electrochemical analytical deterioration event and the material analytical deterioration event.

Examples of a method for acquiring predicted deterioration information include, for example, a method for using a learned model (hereinafter referred to as a "learned model I") being learned in such a way as to output a predicted evaluation result including predicted deterioration information that may be acquired if the life evaluation test is performed when a plurality of explanatory variables extracted from test condition data of the life evaluation test, and charge-discharge data and material analysis data during the life evaluation test are input. The predicted deterioration information can be acquired by inputting the plurality of explanatory variables described above to the learned model I. In this way, a result of the life evaluation test can be predicted from data before completion of the life evaluation test of the storage battery, and thus time for the life evaluation test of the storage battery can be shortened. As described below, the learned model I is stored in the storage unit in the manipulable factor prediction device or the storage device in the manipulable factor prediction system, and can be acquired from the storage unit and the storage device.

Examples of the test condition data include, for example, a test condition parameter such as a temperature, a current value, a voltage (for example, an upper limit voltage and a lower limit voltage), and a charge-discharge pause time of the storage battery. The test condition parameter can be used as it is as the learned model I without processing. However, the test condition data may be freely used as the test condition parameter by being mathematically processed.

For example, the charge-discharge data can be acquired by charging and discharging the storage battery, based on the predetermined evaluation charge-discharge protocol, during the life evaluation test. Then, an electrochemical parameter and a mathematical parameter computed from the charge-discharge data can be used as an explanatory variable of the learned model I described above. As the evaluation charge-discharge protocol, for example, the charge-discharge protocol including performing measurement of energy density and power density during the life evaluation test can be used. The evaluation charge-discharge protocol preferably includes performing measurement of the energy density and the power density by the single charge-discharge process, and the single charge-discharge process includes: measuring the energy density by discharging the storage battery at a predetermined temperature and a predetermined current value; measuring the power density at a target charge rate by causing the maximum current value Iₘₐₓ to be temporarily output when a charge rate reaches the target charge rate in a process of the discharging described above, and subsequently returning the current value to the predetermined current value described above again, which are performed each time the one or the plurality of target charge rates are reached, thereby performing measurement of the energy density described above and the power density described above by a single discharge process.

FIG. 2A is the diagram illustrating the example of the single discharge process in the evaluation charge-discharge protocol. The single discharge process in FIG. 2A includes measuring energy density of a storage battery being an evaluation target having an SOC adjusted to 100% by discharging the storage battery at a current value of 1 C until the SOC reaches 0% from 100% (evaluation A). Further, when the SOC of the storage battery reaches 80% in a process of performing Evaluation A, the single discharge process includes causing the maximum current value Iₘₐₓ being a current value of 2 C or more to be output for 10 seconds, measuring power density at the SOC of 80%, causing discharging to pause for one minute, and then continuing discharging at the current value of 1 C again (evaluation B). The single discharge process includes performing a similar operation when the SOC of the storage battery reaches 50% and reaches 20%, and measuring power density at the SOC of 50% and 20% (evaluation C and evaluation D).

The evaluation charge-discharge protocol may include, first, performing the single discharge process illustrated in FIG. 2A on a storage battery in a brand-new state when the life evaluation test starts, and then performing the single discharge process for each fixed period (X') shorter than a period (X) in which the storage battery is stored in the predetermined life evaluation test or for each fixed number (Y') of charge-discharge cycles smaller than a charge-discharge cycle number (Y) performed in the predetermined life evaluation test. By performing the single discharge process when the life evaluation test starts, charge-discharge data on the storage battery in the brand-new state can be acquired, and an electrochemical parameter such as, for example, energy density, power density, and discharge capacity in the brand-new state can be computed from the acquired charge-discharge data. For example, when an evaluation result of a storage test (X = 28 days or 42 days) of a storage battery in the IEC62660-1 is set as a prediction target, the evaluation charge-discharge protocol may include performing the single discharge process illustrated in FIG. 2A at 45°C and, for example, every 14 days, every 7 days, every 4 days, every 2 days, or every day. When an evaluation result of a cycle test of a storage battery in the IEC62660-1 is set as a prediction target, the evaluation charge-discharge protocol may include performing the single discharge process illustrated in FIG. 2A at 45°C and, for example, every 100 cycles, every 50 cycles, every 25 cycles, every 20 cycles, or every 10 cycles. In this way, a predicted evaluation result and prediction accuracy can be acquired for each fixed period or each fixed number of charge-discharge cycles, and the evaluation charge-discharge protocol can end (i.e., the life evaluation test can end) at a point in time at which prediction accuracy desired by a user is acquired, and thus a subsequent life evaluation test does not need to be performed. Thus, time for the life evaluation test can be significantly shortened. For example, FIG. 2B is the diagram illustrating the example of the evaluation charge-discharge protocol including performing the single discharge process for each fixed number of charge-discharge cycles. FIG. 2B illustrates that the single discharge process in FIG. 2A described above is first performed on a storage battery in a brand-new state when the life evaluation test starts, and the single discharge process is then performed for each charge-discharge cycle number (for example, Y' = 100) smaller than a charge-discharge cycle number performed in the cycle test of the storage battery in the IEC62660-1.

The electrochemical parameter may include, for example, data on at least one selected from energy density, power density, voltage relaxation behavior, and a capacity maintenance rate. The electrochemical parameter can be extracted by electrochemically analyzing the charge-discharge process of the evaluation charge-discharge protocol. For example, the energy density can be computed by the following equation: weight energy density (Wh/kg) = integrated current capacity (Wh)/battery weight (kg) or the following equation: volume energy density (Wh/L) = integrated current capacity (Wh)/battery volume (L) from the integrated current capacity (Wh) and the battery weight (kg) or the battery volume (L) when the storage battery is discharged from an SOC of 100% to 0%. The power density can be computed by the following equation: weight power density (W/kg) = voltage drop (V) × current value Iₘₐₓ (A)/battery weight (kg) or the following equation: volume power density (W/L) = voltage drop (V) × current value Iₘₐₓ (A)/battery volume (L) from the voltage drop (V) and the battery weight (kg) or the battery volume (L) after discharging when the maximum current value Iₘₐₓ (A) is temporarily output. It should be noted that the battery weight (kg) or the battery volume (L) is acquired separately from the charge-discharge data. The voltage relaxation behavior is acquired by setting a parameter of behavior in which an overvoltage is relaxed when the maximum current value Iₘₐₓ is output and then charging and discharging are temporarily caused to pause, and the voltage relaxation behavior is computed by, for example, the following equation: voltage relaxation = voltage after charging and discharging are caused to pause for 1 minute - voltage after maximum current value Iₘₐₓ is output. The capacity maintenance rate can be computed by the following equation: capacity maintenance rate = (discharge capacity of storage battery at point in time of measurement in life evaluation test/discharge capacity of storage battery at time of start of life evaluation test) × 100 from a discharge capacity (for example, an integrated current capacity when discharging is performed from the SOC of 100% to 0%) of the storage battery in a brand-new state (at the time of the start of the life evaluation test) and a discharge capacity of the storage battery at the point in time of measurement in the life evaluation test (for example, a point in time at which the single charge-discharge process of the evaluation charge-discharge protocol is executed) in an execution condition of the life evaluation test.

The mathematical parameter can be extracted by mathematically processing a shape of a discharge curve in the charge-discharge process. The mathematical parameter includes, for example, data acquired by mathematically processing a discharge curve freely combining a voltage of the storage battery on a vertical axis, and a time, a current capacity, an SOC, and the like on a horizontal axis. More specifically, first, for discharge curve data in which a value of an SOC of the storage battery being an evaluation target is the horizontal axis and a value of a voltage (V) corresponding to the value of the SOC is the vertical axis, the matrix X with 1 row and B columns acquired by arranging, as elements, values of the voltage (V) corresponding to values of B (B ≥ 2) different SOCs in the column direction is acquired as the mathematical parameter. The number B of values of the SOCs to be adopted is about 10 to 1,000, and corresponds to the number B of values of the SOCs used for generation of the learned model. For example, as exemplified in FIG. 4, when values of the SOCs are divided into 1% increments from 100% to 0%, B is 101 in total of 100%, 99%, 98%, ..., 2%, 1%, and 0%. The reason why the number of rows of the matrix X is 1 is that the evaluation prediction processing is performed on one storage battery (for each storage battery). Next, a mathematical constraint is imposed, and the matrix X is then factorized into X ≈ W × H (in the equation, the matrix W is a coefficient matrix with 1 row and C columns, and the matrix H is a basis matrix with C rows and B columns). The mathematical constraint is determined in such a way that the matrix W and the matrix H are uniquely decided. C corresponds to C used for generation of the learned model, and is, for example, equal to or less than the same number as the number B of values of the SOCs. As a method of the matrix factorization, principal component analysis, non-negative matrix factorization, and the like can be used. Then, one or a plurality of explanatory variables can be selected from among C coefficients (referred to as a "first principal component" to a "C-th principal component" in an order from a first column) in the matrix W.

For example, material analysis data can be acquired by measuring nuclear magnetic resonance (NMR) data, ion chromatography (IC) data, scanning electron microscope (SEM) observation data, X-ray diffraction (XRD) data, electron spin resonance (ESR) data, X-ray CT image data, air permeability measurement data, and the like of a material constituting a storage battery during the life evaluation test. Then, a material analysis parameter acquired by mathematically processing the material analysis data can be used as an explanatory variable of the learned model I described above. Since acquisition of the material analysis data is accompanied by disassembly of the storage battery, when the life evaluation test is performed, one or a plurality of storage batteries for acquiring the test condition data and the charge-discharge data and one or a plurality of storage batteries of the same kind for acquiring the material analysis data are prepared. Examples of a method for acquiring the material analysis parameter from the material analysis data include the following processing (1) to (3).

The processing (1) is a method for acquiring a material analysis parameter from a spectrum such as the XRD, the NMR, the ESR, and the IC. First, the matrix Y with 1 row and E columns (E is the number of elements, and E ≥ 2) acquired by arranging spectrum data in a brand-new state and spectrum data at a point in time of analysis as elements in the column direction is acquired. At this time, a difference between the spectrum data in the brand-new state and the spectrum data at the point in time of the analysis may be used. The number E of the elements to be adopted is about 10 to 1,000, and corresponds to the division number E in a horizontal axial direction of the spectrum data before matrix factorization. The reason why the number of rows of the matrix Y is 1 is that the evaluation prediction processing is performed on one storage battery (for each storage battery). Next, a mathematical constraint is imposed, and the matrix Y is then factorized into Y ≈ V × I (in the equation, the matrix V is a coefficient matrix with 1 row and F columns, and the matrix I is a basis matrix with F rows and E columns). The mathematical constraint is determined in such a way that the matrix V and the matrix I are uniquely decided. F is, for example, equal to or less than the same number as the number E of the elements. As a method of the matrix factorization, principal component analysis, non-negative matrix factorization, and the like can be used. For example, when the principal component analysis is executed, F coefficients (referred to as a "first principal component" to a "C-th principal component" in an order from the first column) in the matrix V can be acquired as material analysis parameters. Then, one or a plurality of explanatory variables can be selected from among the acquired material analysis parameters.

The processing (2) is another method for acquiring a material analysis parameter from a spectrum such as the XRD, the NMR, the ESR, and the IC. First, parameters that are characteristics of a curve shape, for example, intensity, an integral value, a half-value width, and the like of a peak that characterize a material being an analysis target are calculated from each of spectrum data in a brand-new state and spectrum data at a point in time of analysis. Moreover, for example, a difference between a parameter in the brand-new state and a parameter at the point in time of the analysis is taken, and the acquired difference can be acquired as a material analysis parameter. Then, one or a plurality of explanatory variables can be selected from among the acquired material analysis parameters.

The processing (3) is a method for acquiring a material analysis parameter from image data such as the SEM image. First, image data in a brand-new state and image data at a point in time of analysis are each subjected to filter processing such as a Gaussian filter, and noise is removed. Next, binarization processing such as Otsu's binarization is performed, and a characteristic parameter such as an area ratio between a light portion and a dark portion, and circularity is computed. Moreover, for example, a difference between a parameter in the brand-new state and a parameter at the point in time of the analysis is taken, and the acquired difference can be acquired as a material analysis parameter. Then, one or a plurality of explanatory variables can be selected from among the acquired material analysis parameters.

The learned model I is learned in such a way as to output a predicted evaluation result including predicted deterioration information on a storage battery that may be acquired with the storage battery in a deterioration state when the plurality of explanatory variables described above are input. More specifically, first, a database used for learning of the learned model I is prepared. The database includes a charge-discharge characteristic (charge-discharge data) and electrochemical analysis data as supervised data on the storage battery when the end of life is reached, which are acquired by executing the predetermined life evaluation test on the plurality of storage batteries, and material analysis data on the storage battery as supervised data being acquired by analyzing a material of the storage battery when the end of life is reached. A data set further includes test condition data of the life evaluation test, the charge-discharge data acquired by executing the evaluation charge-discharge protocol on the plurality of storage batteries in various deterioration states, and the material analysis data on the storage battery acquired by disassembling and analyzing the plurality of storage batteries in various deterioration states. Further, the database further includes a plurality of explanatory variables extracted from the test condition data, the charge-discharge data, and the material analysis data described above, and the plurality of explanatory variables are associated with the supervised data described above. Next, the learned model I can be generated by using the database for learning of a machine learning model. Generation of the learned model I can be performed by previously learning the machine learning model by supervised learning such as, for example, ridge regression, support vector regression, or a neural network.

### <Step of Acquiring Association Model>

In the step (S502) of acquiring an association model, the association model in which a causal relationship among a life determination event being a reference for life determination of the storage battery, a plurality of deterioration events, and a plurality of manipulable factor candidates is associated in advance is acquired. The association model can be constructed in advance, based on a correlation between events well known by the person skilled in the art, an experimentally acquired rule of thumb, and the like. As described below, the association model is stored in the storage unit in the manipulable factor prediction device or the storage device in the manipulable factor prediction system, and can be acquired from the storage unit and the storage device.

The "life determination event" refers to a deterioration event being a reference for determining an extent of deterioration of the storage battery and whether the end of life is reached. As the life determination event, a deterioration event used in a general life determination test, for example, capacity deterioration of the storage battery is preferable. However, the life determination event is not limited to the capacity deterioration of the storage battery, and can be selected from among a plurality of deterioration events described below. For example, deterioration of the charge-discharge characteristic other than a capacity of a battery, for example, deterioration of charge-discharge efficiency, deterioration of performance, or deterioration of safety can be used as the life determination event.

The "deterioration event" refers to a change appearing in a storage battery by repeating charging and discharging of a storage battery as compared to a storage battery in a brand-new state. Examples of the deterioration event include, for example, a charge-discharge characteristic deterioration event, an electrochemical analytical deterioration event, and a material analytical deterioration event. The charge-discharge characteristic deterioration event is a decrease in a characteristic acquired from the charge-discharge data on the storage battery, and examples include, for example, capacity deterioration, load deterioration (resistance component increase), non-load deterioration (0.2 C capacity deterioration), an energy density decrease, a power density decrease, and the like. The electrochemical analytical deterioration event is a decrease in a characteristic acquired by electrochemical analysis of the storage battery, and examples include, for example, an ohmic resistance increase, a reaction resistance increase, a diffusion resistance increase, a positive electrode capacity reduction, a negative electrode capacity reduction, a shift in a utilization range of positive and negative electrodes (a shift in a capacity balance of positive and negative electrodes due to Li deactivation), and the like. The material analytical deterioration event is deterioration information acquired by disassembling a storage battery and analyzing a material, and examples include, for example, negative electrode SEI formation, a current collection resistance increase, separator clogging, positive electrode-electrolyte solution interface coating, negative electrode-electrolyte solution interface coating, an electrolyte solution composition change, a positive electrode crystalline structure change, high resistance coating formation in a positive electrode, a negative electrode crystalline structure change, a negative electrode conductivity loss, high resistance coating formation in a negative electrode, SEI coating growth, and the like. The deterioration events can be quantified by a generally known parameter.

The "manipulable factor candidate" refers to a factor in terms of design that can be changed and manipulated in manufacturing of a storage battery. Examples of the manipulable factor candidate include, for example, density, a thickness, volume resistance, interface resistance, peel strength, porosity, and a basis weight of a negative electrode active material layer, a negative electrode active material type, a particle structure, a particle diameter, a specific surface area, a crystalline structure, crystallinity, the amount of impurities, and content of a negative electrode active material, negative electrode binder type and content, content of silicon oxide (SiOx), density, a thickness, volume resistance, interface resistance, peel strength, porosity, and a basis weight of a positive electrode active material layer, a positive electrode active material type, a particle structure, a particle diameter, a specific surface area, a crystalline structure, crystallinity, the amount of impurities, and content of a positive electrode active material, positive electrode binder type and content, material type and content of a conductive auxiliary, electrolyte salt type (for example, LiPF₆, and LiFSI) and content in an electrolyte solution, solvent type and content in an electrolyte solution, additive type (for example, vinylene carbonate) and content in an electrolyte solution, a thickness, a hole diameter, a porosity rate, tortuosity, and strength of a separator, a thickness of a coating layer of a separator, a filler type of a coating layer, particle diameter and content of a filler of a coating layer, binder type and content of a coating layer, a coating position of a coating layer, and the like. It should be noted that examples of a "coating position of a coating layer" include single-sided coating for providing a coating layer on only a surface located on a positive electrode side, single-sided coating for providing a coating layer on only a surface located on a negative electrode side, or double-sided coating for providing a coating layer on both surfaces on a positive electrode side and a negative electrode side. For example, when capacity deterioration is the life determination event, and negative electrode SEI formation is a root cause thereof, these manipulable factor candidates may efficiently contribute to a life improvement and are thus preferable.

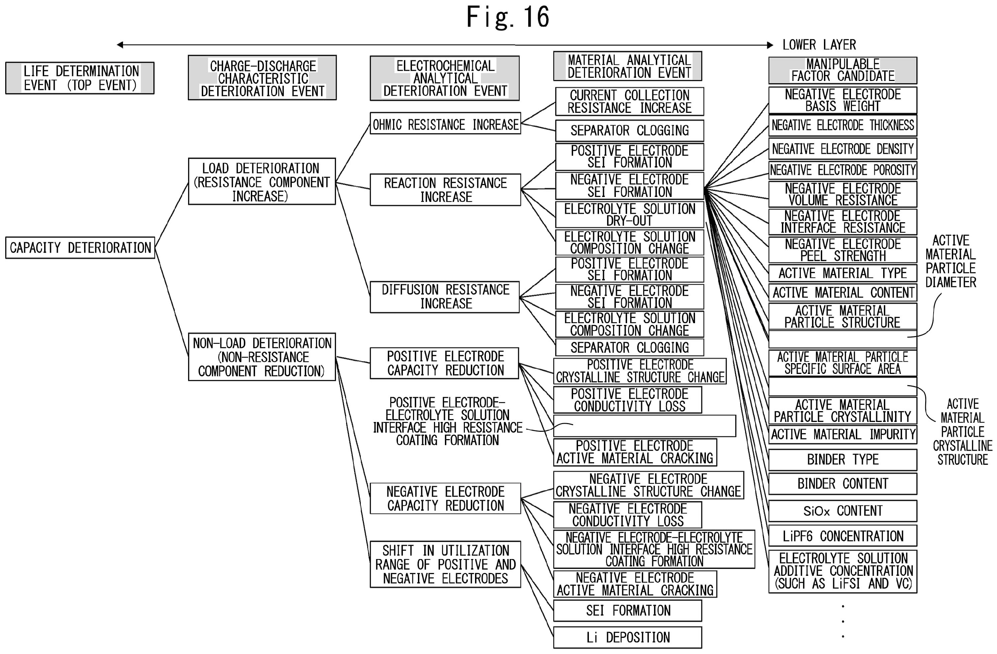

FIG. 16 is an example of an association model of a tree shape based on fault tree analysis (FTA) in which a life determination event is set as a top event. As exemplified in FIG. 16, the association model is the association model of the tree shape based on the fault tree analysis (FTA) in which the life determination event is set as the top event, and can be configured in such a way that a plurality of deterioration events are an upper layer and a plurality of manipulable factor candidates are a lower layer. It is indicated that events connected by a solid line each have a causal relationship. By using such an association model based on the FTA, a manipulable factor having a causal relationship with wide-ranging deterioration events can be predicted by minimum analysis, which can greatly contribute to an efficient life improvement in a storage battery. Each of events and causal relationships exemplified in FIG. 16 is merely an exemplification, and the association model is not limited to this example.

As exemplified in FIG. 16, in the association model based on the FTA, the plurality of deterioration events preferably include one or a plurality of charge-discharge characteristic deterioration events, a plurality of electrochemical analytical deterioration events, and a plurality of material analytical deterioration events in an order from the upper layer. Then, the plurality of manipulable factor candidates can be positioned in the lower layer than each of the plurality of material analytical deterioration events. In general, by the association model based on the FTA of a storage battery having such a hierarchical structure, a manipulable factor having a causal relationship with wide-ranging deterioration events can be predicted by minimum analysis, and readability of a prediction result also improves. In the present disclosure, a deterioration event in a lowest layer directly having a causal relationship with a manipulable factor candidate is also referred to as a "root cause".

### <Step of Computing Degree of Deterioration>

In the step (S503) of computing a degree of deterioration, a plurality of degrees of deterioration representing an extent of deterioration and each corresponding to a life determination event and a plurality of deterioration events directly or indirectly having a causal relationship with the life determination event are computed from acquired predicted deterioration information. Herein, the "degree of deterioration" is a value indicating an extent to which each of a life determination event and a plurality of deterioration events (a charge-discharge characteristic, an electrochemical analytical characteristic, and a material analytical characteristic) after deterioration of a storage battery is deteriorated in comparison with a storage battery in a brand-new state. The degree of deterioration is computed for each of the life determination event and the plurality of deterioration events directly or indirectly having a causal relationship with the life determination event. Even when the degree of deterioration of the life determination event is the same value, the degree of deterioration may take a value varying by the deterioration event.

A degree of deterioration of the charge-discharge characteristic deterioration event can indicate, as a percentage, a change rate (a decrease rate or an increase rate) of each characteristic predicted during deterioration (for example, when the end of life is reached) by setting a brand-new state as a reference (0%) for, for example, capacity deterioration, load deterioration (resistance component increase), non-load deterioration (non-resistance component reduction), an energy density decrease, a power density decrease, and the like.

A degree of deterioration of the electrochemical analytical deterioration event can indicate, as a percentage, a change rate (such as a decrease rate, an increase rate, or magnitude of a shift) of each characteristic predicted during deterioration (for example, when the end of life is reached) by setting a brand-new state as a reference (0%) for, for example, an ohmic resistance increase, a reaction resistance increase, a diffusion resistance increase, a positive electrode capacity reduction, a negative electrode capacity reduction, a shift in a utilization range of positive and negative electrodes (a shift in a capacity balance of positive and negative electrodes due to Li deactivation), and the like.

A degree of deterioration of the material analytical deterioration event can indicate, as a percentage, a change rate (such as a decrease rate and an increase rate) of each feature predicted during deterioration (for example, when the end of life is reached) by setting a brand-new state as a reference (0%) and quantifying any feature for a material of a storage battery such as, for example, a positive electrode active material, a negative electrode active material, a material of a separator, and a material of an electrolyte solution (solvent, salt, and additive). The quantified material analytical deterioration event is, for example, positive electrode SEI formation, negative electrode SEI formation, electrolyte solution dry-out, a current collection resistance increase, separator clogging, an electrolyte solution composition change, a positive electrode crystalline structure change, a positive electrode conductivity loss, positive electrode-electrolyte solution interface high resistance coating formation, cracking of positive electrode active material particles, a negative electrode crystalline structure change, a negative electrode conductivity loss, negative electrode-electrolyte solution interface high resistance coating formation, cracking of negative electrode active material particles, Li deposition, and the like. More specifically, for example, examples of the quantified material analytical deterioration event include indicating a change rate of crystallinity of positive electrode crystal as a percentage by setting a brand-new state as a reference (0%), indicating an increase rate of negative electrode-electrolyte solution interface coating resistance as a percentage by setting a brand-new state as a reference (0%), indicating a degree of blockage of pores of a separator (a reduction rate of the number of pores) as a percentage by setting a brand-new state as a reference (0%), indicating a decrease rate of strength of a separator as a percentage by setting a brand-new state as a reference (0%), and the like.

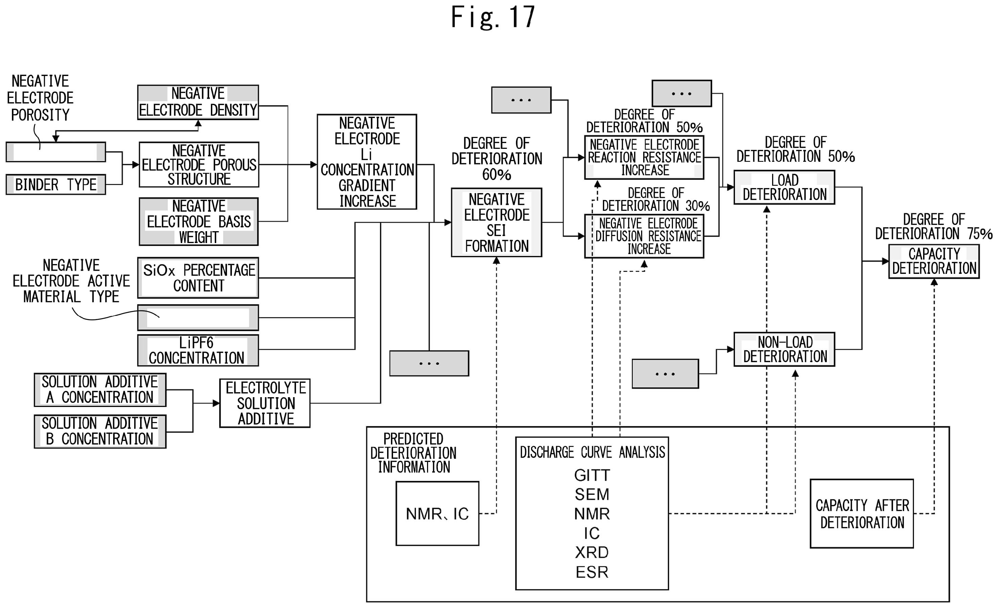

FIG. 17 illustrates an example of computing, from predicted deterioration information, a degree of deterioration corresponding to each of a life determination event and a plurality of deterioration events directly or indirectly having a causal relationship with the life determination event. FIG. 17 illustrates only a part of an exemplificative association model. In this example, the association model based on the fault tree analysis (FTA) in which capacity deterioration is set as the life determination event is used. It should be noted that a manipulable factor candidate is indicated by hatching in dark gray, and a deterioration event being a target for computation of a degree of deterioration is indicated by hatching in light gray. For example, a degree of deterioration related to the capacity deterioration is computed based on a predicted capacity after deterioration (charge-discharge characteristic), a degree of deterioration related to a negative electrode reaction resistance increase, a negative electrode diffusion resistance increase, and load deterioration is computed based on discharge curve analysis and GITT (electrochemical analysis data), and SEM, NMR, IC, XRD, and ESR data (material analysis data) being predicted, and then a degree of deterioration related to negative electrode SEI growth is computed based on predicted NMR and IC data (material analysis data).

The degree of deterioration of the capacity can be computed by the following equation: degree of deterioration of capacity = (discharge capacity of storage battery at time of deterioration/discharge capacity of storage battery in brand-new state) × 100 from the discharge capacity (for example, an integrated current capacity when discharging is performed from the SOC of 100% to 0%) of the storage battery in the brand-new state and the predicted discharge capacity of the storage battery at the time of deterioration. This computation method is one example, and an average of predicted values by a plurality of calculation equations may be acquired. Prediction latitude of the degree of deterioration can be computed from a difference between prediction results by the plurality of calculation equations. FIG. 17 exemplifies a case where the degree of deterioration of the capacity is computed to be 75% on average.

For example, the degree of deterioration of the negative electrode SEI growth can be computed from values acquired by acquiring, as predicted NMR data, intensity, an area, a half-value width, and the like of a peak estimated to be derived from an organic SEI component, and acquiring, as predicted IC data, intensity, an area, a half-value width, and the like of a peak estimated to be derived from an inorganic SEI component. As an example of the computation method, each element may be simply linearly combined, or each element may be weighed. An influence of measurement noise can be suppressed by multiplying a value of each element by some sort of function (such as a step function). Furthermore, an average of predicted values by a plurality of calculation equations may be acquired. Prediction latitude of a deterioration value can be computed from a difference between prediction results by the plurality of calculation equations.

The degree of deterioration of the load deterioration and the non-load deterioration can be computed by acquiring a parameter of the predicted discharge curve analysis. Further, the degree of deterioration of the load deterioration and the non-load deterioration can also be computed by acquiring and analyzing direct current internal resistance-discharge amount curve and open circuit potential-discharge amount curve being predicted by GITT measurement. For example, the negative electrode reaction resistance and the negative electrode diffusion resistance can each be computed based on a ratio between reaction resistance and diffusion resistance in a negative electrode overvoltage in a predicted voltage relaxation waveform (hereinafter "voltage relaxation") during the GITT measurement. The positive electrode reaction resistance and the positive electrode diffusion resistance can also be similarly computed from a voltage relaxation waveform during the GITT measurement. The computation methods are one example, and the negative electrode reaction resistance, the negative electrode diffusion resistance, and a shift in a capacity balance of positive and negative electrodes may be computed by a plurality of calculation equations. Then, each degree of deterioration can be computed from the negative electrode reaction resistance, the negative electrode diffusion resistance, and the shift in the capacity balance of the positive and negative electrodes obtained by the plurality of techniques. As an example of the computation method, each element may be simply linearly combined, or each element may be weighed. An influence of measurement noise can be suppressed by multiplying a value of each element by some sort of function (such as a step function). Prediction latitude of a deterioration value can be computed from a difference between prediction results by the plurality of calculation equations.

A deterioration value can be more accurately computed by computing a deterioration value, based on a plurality of pieces of predicted deterioration information, instead of setting a value computed from a single piece of predicted deterioration information as a deterioration value. For example, a deterioration value is computed by freely combining the charge-discharge characteristic, the electrochemical analysis data, and the material analysis data. More specifically, for example, the SEM, the NMR, the IC, the XRD, and the ESR have high measurement accuracy of capacity deterioration and resistance deterioration, but are limited to local information. Thus, a degree of deterioration of the negative electrode reaction resistance, the negative electrode diffusion resistance, and the shift in the capacity balance of the positive and negative electrodes can be accurately recognized by combining the electrochemical analysis data from which overall information on the storage battery can be acquired, such as the discharge curve analysis and the GITT waveform analysis, and computing a degree of deterioration.

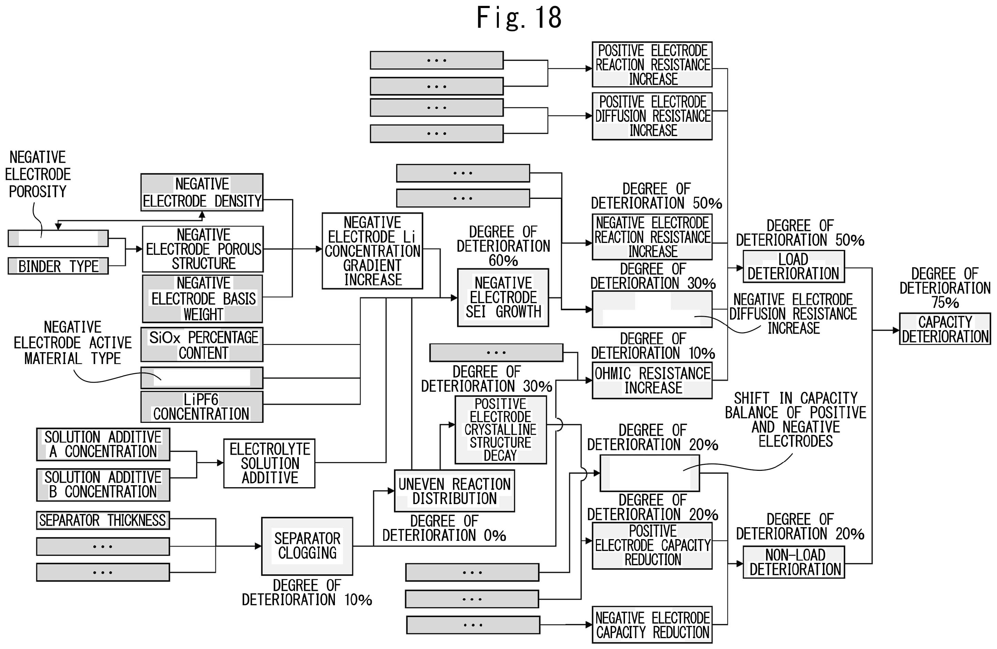

FIG. 17 illustrates the example of computing each degree of deterioration while focusing on the negative electrode SEI growth being one of root causes of the capacity deterioration. By a similar procedure, for example, as illustrated in FIG. 18, degrees of deterioration of a deterioration event being a root cause other than the negative electrode SEI growth and a deterioration event directly or indirectly having a causal relationship with the deterioration event being the root cause can also be computed. FIG. 18 illustrates only a part of an exemplificative association model. It is preferable to prepare an association model in such a way as to include a deterioration event related to a main constituent member of the storage battery such as a positive electrode, a negative electrode, an electrolyte solution, and a separator, and compute each degree of deterioration. In this way, wide-ranging deterioration events of the storage battery can be comprehensively considered.

### <Step of Simplifying Association Model>

In the step (S504) of simplifying the association model, the association model is simplified by eliminating the one or the plurality of deterioration events having the degree of deterioration lower than a threshold value from the acquired association model, and, as a result, when there are the deterioration event and the manipulable factor candidate losing a causal relationship with the life determination event, eliminating the deterioration event and the manipulable factor candidate. A small degree of deterioration suggests little latitude (improvement margin) of a degree of deterioration of the deterioration event that may be improved, and thus a root event of deterioration can be recognized and a manipulable factor candidate having an influence on the root event can be easily extracted by eliminating the deterioration event.

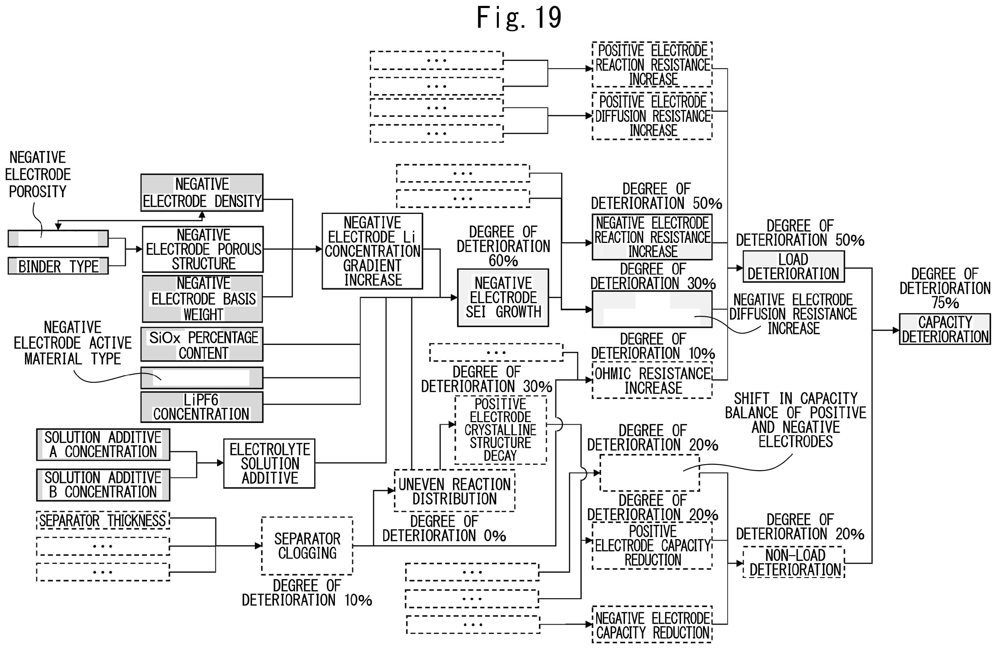

FIG. 19 illustrates an example of the step of simplifying the association model. In FIG. 19, a portion eliminated by simplification is indicated by a broken line, and a remaining association model is indicated by a solid line. In this example, a threshold value of a degree of deterioration is set to 30%, and a shift in a capacity balance of positive and negative electrodes, a positive electrode capacity reduction, an ohmic resistance increase, uneven reaction distribution, separator clogging, and the like being deterioration events having a degree of deterioration less than 30% are eliminated from the association model. Further, as a result, a deterioration event of positive electrode crystalline structure decay and a manipulable factor having a causal relationship with the deleted deterioration event lose a causal relationship with the life determination event, and are thus similarly eliminated. A single threshold value may be set for all of the deterioration events, or a threshold value different for each deterioration event may be set.

### <Step of Acquiring Degree of Influence>

In the step (S505) of acquiring a degree of influence, the degree of influence corresponding to each of one or more of the plurality of deterioration events is acquired by inputting the degree of deterioration of the life determination event and the degrees of deterioration of the plurality of deterioration events to a learned model (hereinafter referred to as a "learned model II") being learned in such a way as to output the degree of influence representing an improvement effect with respect to the degree of deterioration of the life determination event when one or more of the plurality of deterioration events are each improved in a case where the degree of deterioration of the life determination event and the degrees of deterioration of the plurality of deterioration events are input. As described below, the learned model II is stored in the storage unit in the manipulable factor prediction device or the storage device in the manipulable factor prediction system, and can be acquired from the storage unit and the storage device.

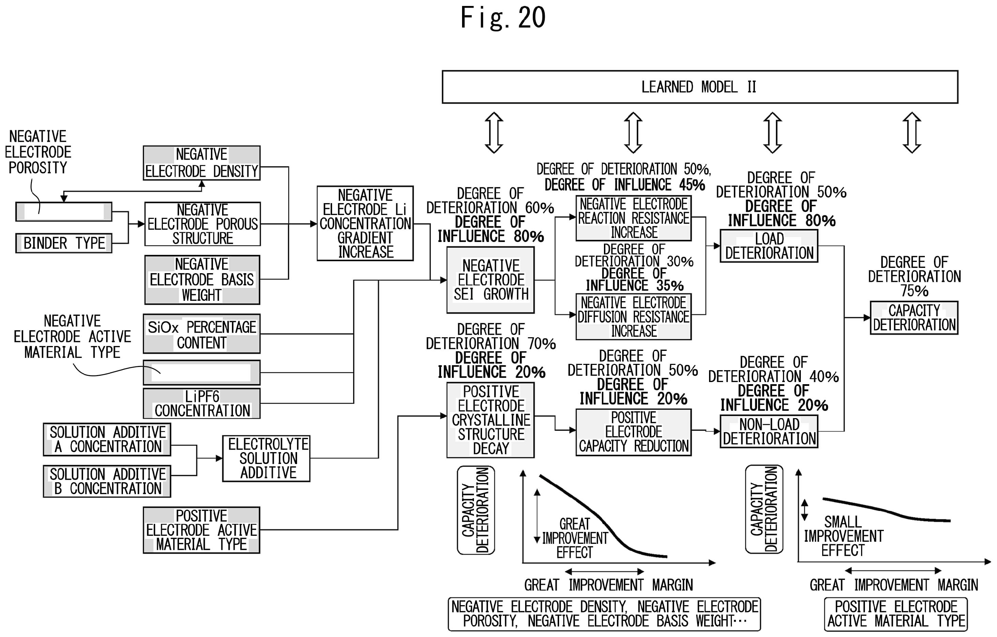

FIG. 20 illustrates an example of the step of acquiring a degree of influence. As exemplified in FIG. 20, degrees of influence of the plurality of deterioration events can be acquired by inputting, to the learned model II, degrees of deterioration corresponding to the life determination event and the plurality of deterioration events of the simplified association model acquired in the steps up to this time, with regard to the life determination event and the plurality of deterioration events. The degree of influence is an index representing a degree of contribution to a life improvement effect, i.e., an extent to which a degree of deterioration of the life determination event may be improved when a degree of deterioration of the deterioration event is improved. A deterioration value is a value related to a deterioration event alone, whereas a degree of influence is a relative value involved in another deterioration event. When all of deterioration events can be expressed in an association model, it is expected that a degree of influence in an upper layer can be acquired by adding all of degrees of influence of the deterioration events in a lower layer, i.e., it is expected that a degree of influence is 100% by adding all of degrees of influence in a lowest layer. However, there is actually a limit to deterioration events that can be expressed in an association model, and thus a smaller value than 100% may be acquired even by adding all of degrees of influence in a lowest layer, which has no problem as long as desired prediction accuracy is guaranteed.

The learned model II is learned in such a way as to output a degree of influence of each of the deterioration events with respect to a degree of deterioration of the life determination event when degrees of deterioration corresponding to the life determination event and the plurality of deterioration events are input, with regard to the life determination event and the plurality of deterioration events. More specifically, first, a database including, as supervised data, data on a degree of deterioration related to a plurality of various deterioration events including a life determination event, which are actually measured for a plurality of storage batteries in various deterioration states, is prepared. The database includes data acquired by computing an influence on degrees of deterioration of the life determination event and the other deterioration event when a degree of deterioration of a certain deterioration event is changed. For example, a database that stores at least one piece of deterioration information selected from a group consisting of a charge-discharge characteristic, electrochemical analysis data, and material analysis data being actually measured after deterioration of a storage battery is prepared, and the database is converted into a degree of deterioration by using the technique described in "Step of Computing Degree of Deterioration" described above. A data structure acquired by hierarchically arranging a degree of deterioration of a charge-discharge characteristic deterioration event, a degree of deterioration of an electrochemical analytical deterioration event, a degree of deterioration of a material analytical deterioration event, and a value of a manipulable factor at this time in this order is constructed as necessary. When a degree of deterioration of each deterioration event is specifically associated with a degree of deterioration of a deterioration event at a lower level, they can be associated based on a correlation between events well known by the person skilled in the art, an experimentally acquired rule of thumb, and the like as described in "Step of Acquiring Association Model" described above. Next, the learned model II can be generated by using the database for learning of a machine learning model. Generation of the learned model II can be performed by previously learning the machine learning model by supervised learning such as, for example, ridge regression, support vector regression, or a neural network. For example, when learning is performed, a degree of influence between a degree of deterioration of a certain deterioration event and a degree of deterioration of a deterioration event at one lower level can be learned. Specifically, for example, by performing machine learning on data on a degree of deterioration of a charge-discharge characteristic deterioration event and a degree of deterioration of an electrochemical analytical deterioration event across a plurality of storage batteries, a degree of influence of a degree of deterioration of a deterioration event at a lower level on a degree of deterioration of a deterioration event at a higher level can be computed, and which degree of deterioration having a great degree of influence can be distinguished.

### <Step of Outputting Manipulable Factor>

In the step (S506) of outputting a manipulable factor, one or a plurality of manipulable factor candidates directly or indirectly having a causal relationship with the life determination event in the simplified association model can be output as the manipulable factor that influences the life of the storage battery.

In the example illustrated in FIG. 20, it is clear that negative electrode SEI growth and positive electrode crystalline structure decay are root causes of capacity deterioration being the life determination event, and it is clear that negative electrode density, negative electrode porosity, binder type, negative electrode basis weight, SiOx percentage content, negative electrode active material type, LiPF₆ concentration, solution additive A concentration, and solution additive B concentration are manipulable factor candidates that may improve the negative electrode SEI growth, and a positive electrode active material is a manipulable factor candidate that may improve the positive electrode crystalline structure decay. Thus, the manipulable factor candidates are output as manipulable factors that influence the life of the storage battery. All of the output manipulable factors are factors that may improve a deterioration event having a great improvement margin, and thus contribute to an efficient improvement in the life of the storage battery.

When the method includes the step (S505) of acquiring the degree of influence described above, one or a plurality of manipulable factor candidates directly or indirectly having a causal relationship with the life determination event and directly or indirectly having a causal relationship with the one or the plurality of deterioration events having the degree of influence equal to or more than a threshold value in the simplified association model can be output as the manipulable factor that influences the life of the storage battery.

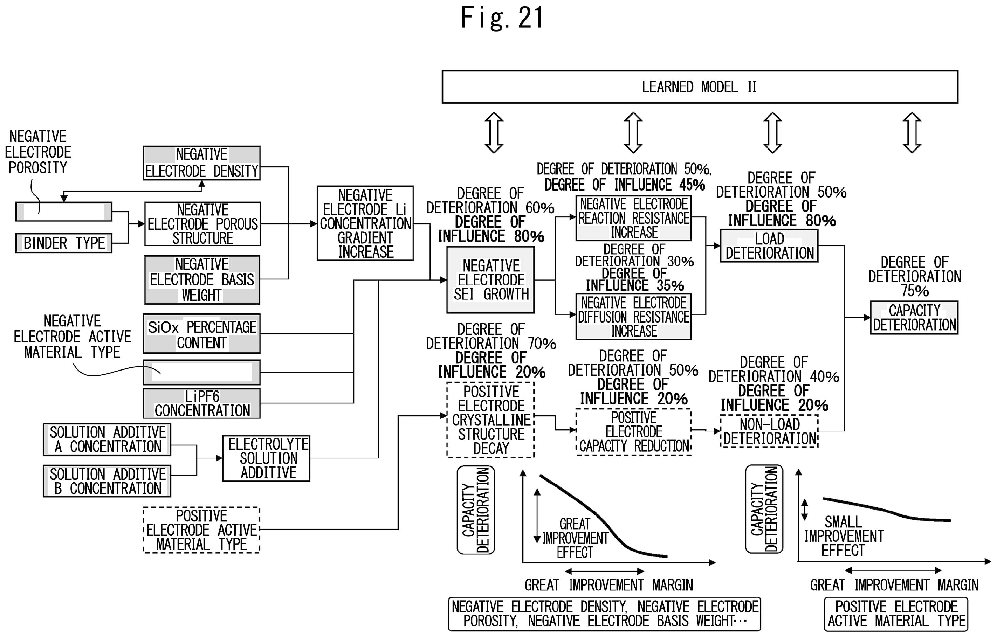

The example illustrated in FIG. 21 indicates that a threshold value of the degree of influence is set to 30%, and a causal relationship related to the positive electrode crystalline structure decay being the deterioration event having the degree of influence less than 30% is eliminated. As a result, as the manipulable factor that may improve the deterioration event having a great improvement margin and a great improvement effect of capacity deterioration, the negative electrode density, the negative electrode porosity, the binder type, the negative electrode basis weight, the SiOx percentage content, the negative electrode active material type, the LiPF₆ concentration, the solution additive A concentration, and the solution additive B concentration are output.

It should be noted that "output" of the manipulable factor includes "transmission" of the manipulable factor to the other device, "display" of the manipulable factor in any form such as a graphical user interface (GUI) on a display unit (not illustrated) of its own device or the other device, and the like.

### <Step of Predicting Change in Life of Storage Battery>

The manipulable factor prediction method may further include a step of predicting a change in life of a storage battery. In the step of predicting a change in life of a storage battery, the change in life of the storage battery when each output manipulable factor is changed is predicted, and a prediction result is output.

Examples of the method for predicting a change in life of a storage battery include the following, for example:
(i) a method (hereinafter referred to as a "learned model expansion type") for associating a manipulable factor with an input and/or output of the learned model II by using a theoretical calculation equation representing a relationship between the manipulable factor and degrees of deterioration and/or degrees of influence of a plurality of deterioration events in a simplified association model, and then predicting a change in life of a storage battery when each output manipulable factor is changed by performing forward analysis and/or inverse analysis on the learned model II from a specific manipulable factor; and
(ii) a method (hereinafter referred to as a "simulation model type") for constructing a simulation model that simulates a change in life of a storage battery when each output manipulable factor is changed by using a theoretical calculation equation representing a relationship among the output manipulable factor, degrees of deterioration of a plurality of deterioration events, and a degree of deterioration of a life determination event and using the learned model II in a simplified association model, and then simulating a change in life of a storage battery when each output manipulable factor is changed by the simulation model.

### (i) With Regard to Learned Model Expansion Type

In the learned model expansion type, a relationship between a manipulable factor and a deterioration event is calculated by a theoretical calculation equation, and an input and/or output of the learned model II is expanded to the manipulable factor by using the theoretical calculation equation. An input (deterioration value) side is preferably expanded to the manipulable factor, and it is particularly a deterioration value of a deterioration event being a root cause. A mathematical model that holds true between the manipulable factor and the deterioration value of the deterioration event (particularly, the root cause) is derived by the theoretical calculation equation, a fluctuation of the deterioration value of the deterioration event when the manipulable factor is changed is predicted, and an output (degree of influence) by the change in the deterioration value can be predicted with a value of the fluctuated deterioration value as an input. In this way, the manipulable factor can be indirectly associated with the degree of influence. Then, by performing inverse analysis on the learned model II, an improvement effect of life of a storage battery when the manipulable factor is changed can be predicted. In such a manner, examples of a reason for expanding an input (deterioration value) of the learned model II to a manipulable factor include a reason that an output (degree of influence) is a relative value involved in another deterioration cause, whereas the input (deterioration value) is a value with respect to the deterioration event alone. In other words, a technical hurdle when an influence on life of a storage battery is converted into a manipulable factor can be lowered by narrowing a range for deriving the theoretical calculation equation from the entire storage battery to a member or material level.

### (ii) With Regard to Simulation Model Type

In the simulation model type, a model that simulates a degree of deterioration of a life determination event when each manipulable factor is changed is constructed by using a theoretical calculation equation representing a relationship among the manipulable factor, degrees of deterioration of a plurality of deterioration events, and the degree of deterioration of the life determination event. It is important to fit various parameters of a simulation to actual behavior of a storage battery in order to increase accuracy of the simulation, and a deterioration value computed from predicted deterioration information can be used as an input for the fitting. In other words, accuracy of the simulation can be increased by fitting parameters of the simulation in such a way that a deterioration value of each deterioration event is a predetermined value matching behavior of the storage battery. Herein, the learned model II can be used as an auxiliary for fitting the parameters of the simulation. In other words, in order to efficiently perform the fitting described above, it is important to narrow down to parameters to be changed (fitted) to some extent from countlessly present parameters. By using, for the narrowing, a degree of influence being an output of the learned model II together with the computed deterioration value, the parameters of the simulation can be fitted while narrowing down to a parameter associated with a deterioration event having a high deterioration value and a high degree of influence. In this way, efficiency of constructing the simulation model can be increased, and accuracy can be increased.

It should be noted that "output" of a predicted change in life of a storage battery includes "transmission" of the information to the other device, "display" of the information in any form such as a graphical user interface (GUI) on a display unit (not illustrated) of its own device or the other device, and the like.

### <<Manipulable Factor Prediction Device>>

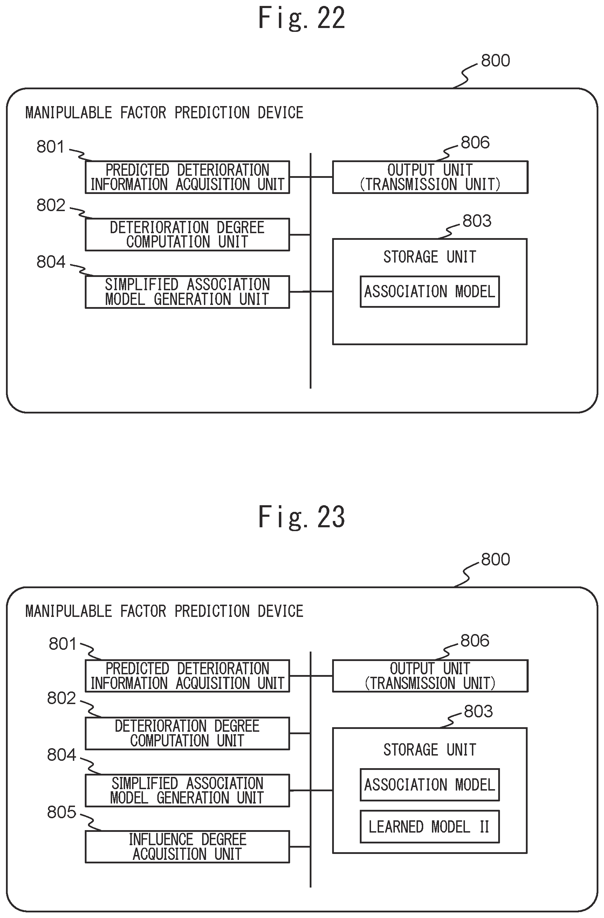

FIG. 22 is a diagram illustrating an example of a manipulable factor prediction device 800 of the present disclosure. The manipulable factor prediction device 800 includes: a predicted deterioration information acquisition unit 801 that acquires at least one piece of predicted deterioration information selected from a group consisting of a predicted charge-discharge characteristic, predicted electrochemical analysis data, and predicted material analysis data after deterioration of a storage battery; a deterioration degree computation unit 802 that computes, from the predicted deterioration information, a plurality of degrees of deterioration representing an extent of deterioration and each corresponding to a life determination event being a reference for life determination of the storage battery, and a plurality of deterioration events directly or indirectly having a causal relationship with the life determination event; a storage unit 803 that stores an association model in which a causal relationship among the life determination event, the plurality of deterioration events, and a plurality of manipulable factor candidates is associated in advance; a simplified association model generation unit 804 that simplifies the association model by eliminating the one or the plurality of deterioration events having the degree of deterioration lower than a threshold value from the association model, and, as a result, when there are the deterioration event and the manipulable factor candidate losing a causal relationship with the life determination event, also eliminating the deterioration event and the manipulable factor candidate; and an output unit 806 that outputs, as a manipulable factor that influences life of the storage battery, the one or the plurality of manipulable factor candidates directly or indirectly having a causal relationship with the life determination event in the simplified association model. Functional units such as the predicted deterioration information acquisition unit, the deterioration degree computation unit, and the storage unit are mutually connected via a bus, an interface unit, and/or the like. The manipulable factor prediction device 800 may be, for example, an information processing device such as a personal computer, a note PC, or a tablet PC. Each functional unit is implemented by a processing unit, for example, a central processing unit (CPU) of the information processing device that performs a motion, based on a program including the manipulable factor prediction program stored in advance in a storage unit of the information processing device. The processing unit may be a digital signal processor (DSP), a large scale integration (LSI), an application specific integrated circuit (ASIC), a field-programmable gate array (FPGA), and the like. In this way, the manipulable factor prediction device 800 is configured to be able to execute the manipulable factor prediction method of the present disclosure described above.

FIG. 23 is a diagram illustrating a modification example of the manipulable factor prediction device 800 of the present disclosure. The manipulable factor prediction device 800 preferably further includes an influence degree acquisition unit 805 that acquires a degree of influence corresponding to each of one or more of the plurality of deterioration events by inputting the degree of deterioration of the life determination event and the degrees of deterioration of the plurality of deterioration events to the learned model II being learned in such a way as to output the degree of influence representing an improvement effect with respect to the degree of deterioration of the life determination event when one or more of the plurality of deterioration events are each improved in a case where the degree of deterioration of the life determination event and the degrees of deterioration of the plurality of deterioration events are input. In this aspect, the storage unit of the manipulable factor prediction device 800 further stores the learned model II, and the output unit is configured to output, as a manipulable factor that influences life of the storage battery, one or a plurality of manipulable factor candidates directly or indirectly having a causal relationship with the one or the plurality of deterioration events having the degree of influence equal to or more than a threshold value in a simplified association model.

### <Predicted Deterioration Information Acquisition Unit>

The predicted deterioration information acquisition unit 801 may be a reception unit that acquires predicted deterioration information from an external device of the manipulable factor prediction device 800. The reception unit serving as the predicted deterioration information acquisition unit 801 includes a wired communication interface circuit conforming to a communication protocol such as a transmission control protocol/Internet protocol (TCP/IP), and can communicate with and be connected to a network according to communication standards such as Ethernet (registered trademark), or the reception unit includes an antenna that transmits/receives a wireless signal and a wireless communication interface circuit conforming to a communication protocol such as a wireless LAN, and can communicate with and be connected to a network according to communication standards such as the wireless LAN.

When output of predicted deterioration information by the learned model I is performed by the processing unit of the manipulable factor prediction device 800, the manipulable factor prediction device 800 acquires (receives) test condition data of the life evaluation test, charge-discharge data, and material analysis data from a charge-discharge device terminal of the storage battery via a network and the like. Then, the processing unit of the manipulable factor prediction device 800 extracts a plurality of explanatory variables from the data, and outputs predicted deterioration information by inputting the plurality of extracted explanatory variables to the learned model I, and the processing unit serving as the predicted deterioration information acquisition unit 801 acquires the predicted deterioration information.

### <Deterioration Degree Computation Unit>

The deterioration degree computation unit 802 may be a processing unit of the manipulable factor prediction device 800. The processing unit serving as the deterioration degree computation unit 802 computes, from predicted deterioration information, a plurality of degrees of deterioration representing an extent of deterioration and each corresponding to a life determination event being a reference for life determination of the storage battery and a plurality of deterioration events directly or indirectly having a causal relationship with the life determination event. Details of the computation processing are as described above.

### <Storage Unit>

The storage unit 803 includes a memory device such as a random access memory (RAM) and a read only memory (ROM), a fixed disk device such as a hard disk, a portable storage device such as a flexible disk and an optical disk, or the like. The computer program may be installed onto the storage unit from a computer-readable portable recording medium by using a known setup program and the like. The portable recording medium is, for example, a compact disc read only memory (CD-ROM), a digital versatile disc read only memory (DVD-ROM), and the like. The storage unit 803 stores a program needed for a motion of the manipulable factor prediction device 800, and the like in addition to the manipulable factor prediction program of the present disclosure. When output of predicted deterioration information by the learned model I is performed by the processing unit of the manipulable factor prediction device 800, the storage unit described above further stores the learned model I. When the processing unit of the manipulable factor prediction device 800 performs acquisition of a degree of influence, the storage unit described above further stores the learned model II. Details of the learned models I and II are as described above.

### <Simplified Association Model Generation Unit>

The simplified association model generation unit 804 may be a processing unit of the manipulable factor prediction device 800. The processing unit serving as the simplified association model generation unit 804 simplifies an association model by eliminating the one or the plurality of deterioration events having the degree of deterioration lower than a threshold value from the association model, and, as a result, when there are the deterioration event and the manipulable factor candidate losing a causal relationship with the life determination event, eliminating the deterioration event and the manipulable factor candidate. Details of the simplification processing are as described above.

### <Influence Degree Acquisition Unit>

The influence degree acquisition unit 805 may be a processing unit of the manipulable factor prediction device 800. The processing unit serving as the influence degree acquisition unit 805 acquires a degree of influence corresponding to each of one or more of the plurality of deterioration events by inputting the degree of deterioration of the life determination event and the degrees of deterioration of the plurality of deterioration events to the learned model II being learned in such a way as to output the degree of influence representing an improvement effect with respect to the degree of deterioration of the life determination event when one or more of the plurality of deterioration events are each improved in a case where the degree of deterioration of the life determination event and the degrees of deterioration of the plurality of deterioration events are input. Details of the influence degree acquisition processing are as described above.

### <Output Unit>

The output unit 806 may be a transmission unit that transmits a prediction result including information on a manipulable factor that influences life of the storage battery, a life change prediction of the storage battery when the manipulable factor is changed, and the like to an external device of the manipulable factor prediction device 800. The transmission unit serving as the output unit 806 includes a wired communication interface circuit conforming to a communication protocol such as a transmission control protocol/Internet protocol (TCP/IP), and can communicate with and be connected to a network according to communication standards such as Ethernet (registered trademark), or the transmission unit includes an antenna that transmits/receives a wireless signal and a wireless communication interface circuit conforming to a communication protocol such as a wireless LAN, and can communicate with and be connected to a network according to communication standards such as the wireless LAN. The prediction result transmitted to the external device can be displayed in any form such as a graphical user interface (GUI) on a display unit of the external device. Examples of the external device include an entity terminal that operates the manipulable factor prediction device of the present disclosure, a customer terminal using the manipulable factor prediction device of the present disclosure, or the like.

The output unit 806 may be a display unit of the manipulable factor prediction device 800. In this case, the display unit can display (output) the prediction result in any form such as a graphical user interface (GUI) for a user of the manipulable factor prediction device 800.

### <<Manipulable Factor Prediction System>>

The manipulable factor prediction system of the present disclosure includes: an acquisition device that acquires at least one piece of predicted deterioration information selected from a group consisting of a predicted charge-discharge characteristic, predicted electrochemical analysis data, and predicted material analysis data after deterioration of a storage battery; a deterioration degree computation device that computes, from the predicted deterioration information, a plurality of degrees of deterioration representing an extent of deterioration and each corresponding to a life determination event being a reference for life determination of the storage battery, and a plurality of deterioration events directly or indirectly having a causal relationship with the life determination event; a storage device that stores an association model in which a causal relationship among the life determination event, the plurality of deterioration events, and a plurality of manipulable factor candidates is associated in advance; a simplified association model generation device that simplifies the association model by eliminating the one or the plurality of deterioration events having the degree of deterioration lower than a threshold value from the association model, and, as a result, when there are the deterioration event and the manipulable factor candidate losing a causal relationship with the life determination event, also eliminating the deterioration event and the manipulable factor candidate; and an output device that outputs, as a manipulable factor that influences life of the storage battery, the one or the plurality of manipulable factor candidates directly or indirectly having a causal relationship with the life determination event in the simplified association model. Each device may be an information processing device such as, for example, a personal computer, a note PC, or a tablet PC mutually communicably connected via, for example, a wired/wireless network and the like.

As long as the manipulable factor prediction system can execute the manipulable factor prediction method of the present disclosure as the entire system mutually communicably connected, any device constituting the system may function as the predicted deterioration information acquisition device, the deterioration degree computation device, the storage device, the simplified association model generation device, the influence degree acquisition device, and the output device. Further, a single device may have a plurality of functions of the devices, or a plurality of devices may be configured to implement one function. Details of a motion of each device are referred to the description of each functional unit of the manipulable factor prediction device described above.

### <<Manipulable Factor Prediction Program>>

The manipulable factor prediction program of the present disclosure includes causing a computer to execute: computing, from at least one piece of predicted deterioration information selected from a group consisting of a predicted charge-discharge characteristic, predicted electrochemical analysis data, and predicted material analysis data after deterioration of a storage battery, a plurality of degrees of deterioration representing an extent of deterioration and each corresponding to a life determination event being a reference for life determination of the storage battery, and a plurality of deterioration events directly or indirectly having a causal relationship with the life determination event; simplifying an association model in which a causal relationship among the life determination event, the plurality of deterioration events, and a plurality of manipulable factor candidates is associated in advance by eliminating the one or the plurality of deterioration events having the degree of deterioration lower than a threshold value from the association model, and, as a result, when there are the deterioration event and the manipulable factor candidate losing a causal relationship with the life determination event, also eliminating the deterioration event and the manipulable factor candidate; and outputting, as a manipulable factor that influences life of the storage battery, the one or the plurality of manipulable factor candidates directly or indirectly having a causal relationship with the life determination event in the simplified association model.

The manipulable factor prediction program is stored in the storage unit or the storage device in the manipulable factor prediction device or system, and causes a computer of the manipulable factor prediction device or system to execute the manipulable factor prediction method of the present disclosure. Details of each motion are referred to the description of the manipulable factor prediction method, device, and program described above.

### <<Combination of Evaluation Result Prediction and Manipulable Factor Prediction>>

The manipulable factor prediction device 800 of the present disclosure as exemplified in FIGS. 22 and 23 may (1) also serve as the evaluation result prediction device of the present disclosure described above, or (2) be a device physically independent of the evaluation result prediction device. In the case of (1), the evaluation result prediction device further has the configuration serving as the manipulable factor prediction device 800. It can be said that such a device is the evaluation result prediction device having a manipulable factor prediction function, and is the manipulable factor prediction device having an evaluation result prediction function. For example, the charge-discharge device terminal 200, the entity server 300, or the shared server 700 serving as the evaluation result prediction device can further have the configuration serving as the manipulable factor prediction device 800. In the case of (2), another information processing device communicably connected to the evaluation result prediction device may further have the configuration serving as the manipulable factor prediction device 800. The other information processing device may be the charge-discharge device terminal 200, the entity server 300, the shared server 700 not being the evaluation result prediction device, or an information processing device different from these. Also in both aspects of (1) and (2), the manipulable factor prediction device 800 can perform prediction of a manipulable factor by using a predicted evaluation result being predicted by the evaluation result prediction device of the present disclosure, and can thus further efficiently improve life of a storage battery.

The manipulable factor prediction system of the present disclosure may also serve as the evaluation result prediction system of the present disclosure described above. In other words, the evaluation result prediction system further has the configuration serving as the manipulable factor prediction system. It can be said that such a system is the evaluation result prediction system having the manipulable factor prediction function, and is the manipulable factor prediction system having the evaluation result prediction function. For example, the charge-discharge device terminal 200, the entity server 300, the shared server 700 constituting the evaluation result prediction system, or another information processing device communicably connected to the evaluation result prediction system may further have the configuration serving as the manipulable factor prediction system alone or as a whole. By this configuration, the manipulable factor prediction system can perform prediction of a manipulable factor by using a predicted evaluation result being predicted by the evaluation result prediction method of the present disclosure, and can thus further efficiently improve life of a storage battery.

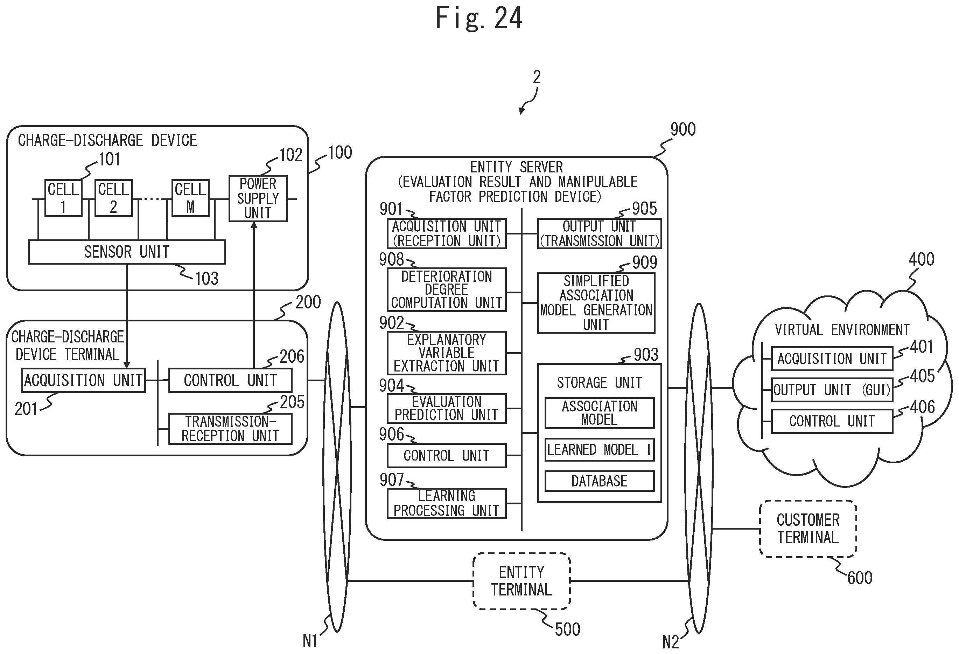

More specifically, FIG. 24 is a diagram illustrating a schematic configuration of an evaluation result and the manipulable factor prediction system of the present disclosure. An evaluation result and manipulable factor prediction system 2 includes the charge-discharge device 100, the charge-discharge device terminal 200 communicably connected to the charge-discharge device 100, an entity server 900 communicably connected to the charge-discharge device terminal 200 via the private network N1 of the entity, and the virtual environment 400 constructed on the network N2 and communicably connected to the entity server 900. The evaluation result and manipulable factor prediction system 2 can be accessed from a terminal device such as the entity terminal 500 and the customer terminal 600 indicated by a broken line. The entity terminal 500 is communicably connected to the charge-discharge device terminal 200 and the entity server 900 via the private network N1 of the entity, and is also communicably connected to the virtual environment 400 and the customer terminal 600 via the network N2. The customer terminal 600 is communicably connected to the virtual environment 400 and the entity terminal 500 via the network N2.

The entity server 900 in FIG. 24 is an "evaluation result and manipulable factor prediction device" that can predict an evaluation result of the predetermined life evaluation test, and energy density and power density of a storage battery being successively measured by the predetermined charge-discharge protocol, and can perform prediction of a manipulable factor, based on the predicted evaluation result. The entity server 900 includes an acquisition unit (reception unit) 901 that can acquire test condition data, charge-discharge data, material analysis data, and the like on the storage battery, an explanatory variable extraction unit 902 that extracts a plurality of explanatory variables from the test condition data, the charge-discharge data, and the material analysis data, a storage unit 903 that stores the learned model I being learned in such a way as to output a predicted evaluation result when the plurality of explanatory variables are input, a database, and the like, an evaluation prediction unit 904 that acquires the predicted evaluation result by inputting the plurality of explanatory variables to the learned model, and computes prediction accuracy of the predicted evaluation result, and an output unit (transmission unit) 905 that outputs information including the predicted evaluation result and the prediction accuracy.

The entity server 900 in FIG. 24 further includes a control unit 906 that outputs commands for (i) ending the evaluation charge-discharge protocol when the prediction accuracy is equal to or more than a predetermined threshold value, and (ii) continuing the evaluation charge-discharge protocol when the prediction accuracy is less than the predetermined threshold value. The entity server 900 further includes a learning processing unit 907 that can perform generation and relearning of the learned model I.

The acquisition unit (reception unit) 901 of the entity server 900 in FIG. 24 also functions as a predicted deterioration information acquisition unit that acquires at least one piece of predicted deterioration information selected from a group consisting of a predicted charge-discharge characteristic, predicted electrochemical analysis data, and predicted material analysis data after deterioration of the storage battery. The entity server 900 further includes a deterioration degree computation unit 908 that computes, from the predicted deterioration information, a plurality of degrees of deterioration representing an extent of deterioration and each corresponding to a life determination event being a reference for life determination of the storage battery and a plurality of deterioration events directly or indirectly having a causal relationship with the life determination event. The storage unit 903 further stores an association model in which a causal relationship among the life determination event being the reference for life determination of the storage battery, the plurality of deterioration events, and a plurality of manipulable factor candidates is associated in advance. The entity server 900 further includes a simplified association model generation unit 909 that simplifies the association model by eliminating the one or the plurality of deterioration events having the degree of deterioration lower than a threshold value from the association model, and, as a result, when there are the deterioration event and the manipulable factor candidate losing a causal relationship with the life determination event, eliminating the deterioration event and the manipulable factor candidate. The output unit (transmission unit) 905 outputs, as a manipulable factor that influences life of the storage battery, the one or the plurality of manipulable factor candidates directly or indirectly having a causal relationship with the life determination event in the simplified association model.

The entity server 900 preferably further includes an influence degree acquisition unit (not illustrated) that acquires a degree of influence corresponding to each of one or more of the plurality of deterioration events by inputting the degree of deterioration of the life determination event and the degrees of deterioration of the plurality of deterioration events to the learned model II being learned in such a way as to output the degree of influence representing an improvement effect with respect to the degree of deterioration of the life determination event when one or more of the plurality of deterioration events are each improved in a case where the degree of deterioration of the life determination event and the degrees of deterioration of the plurality of deterioration events are input. In this aspect, the storage unit 903 of the entity server 900 further stores the learned model II, and the output unit (transmission unit) 905 is further configured to output, as a manipulable factor that influences life of the storage battery, the one or the plurality of manipulable factor candidates directly or indirectly having a causal relationship with the one or the plurality of deterioration events having the degree of influence equal to or more than a threshold value in the simplified association model.

The evaluation result and manipulable factor prediction system 2 has the configuration described above, and can thus predict an evaluation result that may be acquired if the predetermined life evaluation test is performed on a storage battery being an evaluation target, and deterioration information on the storage battery when the end of life is reached, based on test condition data in the life evaluation test, and charge-discharge data acquired by executing charging and discharging based on the evaluation charge-discharge protocol on the storage battery being the evaluation target during the life evaluation test. Further, the evaluation result and manipulable factor prediction system 2 can predict an evaluation result that may be acquired if the predetermined charge-discharge protocol is performed on a storage battery being an evaluation target, based on charge-discharge data acquired by executing charging and discharging based on the evaluation charge-discharge protocol on the storage battery being the evaluation target. Furthermore, the evaluation result and manipulable factor prediction system 2 can perform prediction of a manipulable factor by using a predicted evaluation result being predicted.

### EXAMPLES

Examples and comparative examples of the present disclosure will be described below, but the present disclosure is not limited to the examples and the comparative examples below. A cycle number to reach the end of life being measured in the predetermined life evaluation test was predicted by using the evaluation result prediction device and system of the present disclosure.

**[Table 5]**

| | EXPLANATORY VARIABLE | | | RESULT | |
|---|---|---|---|---|---|
| | DETERIORATION CONDITION | POWER DENSITY | ENERGY DENSITY | R² VALUE | MAE VALUE |
| EXAMPLE 1 | ○ | × | × | 0.367 | 0.40 |
| EXAMPLE 2 | ○ | ○ | × | 0.405 | 0.37 |
| EXAMPLE 3 | ○ | × | ○ | 0.705 | 0.27 |
| EXAMPLE 4 | ○ | ○ | ○ | 0.709 | 0.26 |

In examples 1 to 4, a prediction model was constructed by using a support vector regression technique with, as a target variable, a natural logarithm of a cycle number to reach the end of life of a storage battery. A test condition set in a life evaluation test, power density, and energy density were prepared as explanatory variables, and a change in prediction performance was verified by comparing a case (○) where the power density and the energy density were added as the explanatory variables to the test condition and a case (×) where the power density and the energy density were not added as the explanatory variables to the test condition.

In a case (Example 3) where only the energy density was added as the explanatory variable to the test condition and a case (Example 2) where only the power density was added, a determination coefficient (R² value) was further increased and a mean absolute error (MAE) was further reduced than those in a case (Example 1) where prediction was performed only from the test condition. Further, in a case (Example 4) where both of the energy density and the power density were added as the explanatory variables, the determination coefficient was further increased and the mean absolute error was further reduced than those in the cases (Example 2 and Example 3) where only one was used. Therefore, by adding the energy density and the power density as the explanatory variables, it was verified that there was a possibility of improving prediction accuracy when the end of life was reached.

It should be noted that a predicted cycle number to reach the end of life was a cycle number to reach the end of life until a voltage retention rate or a capacity maintenance rate of a storage battery fell below a preset reference value, or the storage battery reached a preset upper limit temperature when an evaluation charge-discharge protocol was performed during a life evaluation test. The test condition included a condition such as a current, a voltage, and a temperature of a charge-discharge cycle in a deterioration step in the life evaluation test of the storage battery. The energy density included a value of a current capacity or a power capacity per volume or weight of the storage battery. The power density included an output characteristic at a high current value, and a difference in value of a current capacity or a power capacity at different current values.

In Examples 1 to 4, data acquired by performing the life evaluation test on 15 samples having different deterioration conditions of a lithium ion battery of the same type were used. In Examples 1 to 4, evaluation of the prediction accuracy was performed by using cross-validation. As an evaluation index of the prediction accuracy, the determination coefficient (R² value) and the mean absolute error (MAE) were used.

### INDUSTRIAL APPLICABILITY

The method, device, system and program of the present disclosure can predict an evaluation result of a predetermined life evaluation test and/or an evaluation result of a predetermined charge-discharge protocol. In addition to these, a manipulable factor that influences life of a storage battery can be predicted. Therefore, the method, device, system, and program of the present disclosure can not only speed up evaluation of storage batteries, but can also speed up development of storage batteries by providing a design guide of a next storage battery.

### REFERENCE SIGNS LIST

1 Evaluation result prediction system; 2 Evaluation result and manipulable factor prediction system; 100 Charge-discharge device, 101 Storage battery, 102 Power supply unit, 103 sensor unit; 200 Charge-discharge device terminal, 201 Acquisition unit, 202 Explanatory variable extraction unit, 203 Storage unit, 204 Evaluation prediction unit, 205 Transmission-reception unit, 206 Control unit; 300 Entity server, 301 Acquisition unit, 302 Explanatory variable extraction unit, 303 Storage unit, 304 Evaluation prediction unit, 305 Output unit (transmission unit), 306 Control unit, 307 Learning processing unit; 400 Virtual environment, 401 Acquisition unit, 405 Output unit (GUI), 406 Control unit; 500 Entity terminal; 600 Customer terminal; 700 Shared server, 701 Acquisition unit, 702 Explanatory variable extraction unit, 703 Storage unit, 704 Evaluation prediction unit, 705 Output unit (GUI), 706 Control unit; N1 Private network of entity, N2 Accessible network of user; 800 Manipulable factor prediction device, 801 Predicted deterioration information acquisition unit, 802 Deterioration degree computation unit, 803 Storage unit, 804 Simplified association model generation unit, 805 Influence degree acquisition unit, 806 Output unit; 900 Entity server serving as evaluation result and manipulable factor prediction device, 901 Acquisition unit, 902 Explanatory variable extraction unit, 903 Storage unit, 904 Evaluation prediction unit, 905 Output unit (transmission unit), 906 Control unit, 907 Learning processing unit, 908 Deterioration degree computation unit, 909 Simplified association model generation unit

## Claims

1. An evaluation result prediction device that predicts at least one evaluation result selected from a voltage retention rate after a test of a storage battery, a capacity maintenance rate after the test, time to reach the end of life, or a cycle number to reach the end of life being measured by a predetermined life evaluation test, the evaluation result prediction device comprising:
an acquisition unit that acquires at least one piece of test condition data selected from a temperature, a current value, a voltage, or a charge-discharge pause time of the storage battery, and charge-discharge data on the storage battery based on an evaluation charge-discharge protocol including performing measurement of energy density and power density during the life evaluation test;
an explanatory variable extraction unit that extracts a plurality of explanatory variables including one or a plurality of test condition parameters selected from the test condition data, and an electrochemical parameter that is computed from the charge-discharge data and includes the energy density and the power density;
a storage unit that stores a learned model being learned in such a way as to output a predicted evaluation result including the evaluation result measured by the life evaluation test when the plurality of explanatory variables are input;
an evaluation prediction unit that acquires the predicted evaluation result by inputting the plurality of explanatory variables to the learned model, and computes prediction accuracy of the predicted evaluation result; and
an output unit that outputs information including the predicted evaluation result and the prediction accuracy.

2. The evaluation result prediction device according to claim 1, wherein
the predetermined life evaluation test includes
a deterioration step of storing a storage battery at a predetermined temperature for a fixed period (X), or repeating a fixed number (Y) of charge-discharge cycles at a predetermined temperature, and
an evaluation step including (i) measuring a voltage retention rate and/or a capacity maintenance rate of the storage battery after an end of the deterioration step, or (ii) measuring time to reach the end of life or a cycle number to reach the end of life until a voltage retention rate or a capacity maintenance rate of the storage battery falls below a preset reference value, or the storage battery reaches a preset upper limit temperature.

3. The evaluation result prediction device according to claim 2, wherein
the evaluation charge-discharge protocol includes performing measurement of the energy density and the power density by a single charge-discharge process,
the single charge-discharge process includes
measuring energy density by discharging the storage battery at the predetermined temperature and a predetermined current value, and
measuring power density at a target charge rate by causing a maximum current value Iₘₐₓ to be temporarily output when a charge rate reaches the target charge rate in a process of the discharging, and subsequently returning the current value to the predetermined current value again, which are performed each time the one or the plurality of target charge rates are reached, thereby performing measurement of the energy density and the power density by a single discharge process,
the learned model is further learned in such a way as to output a predicted evaluation result including energy density and power density being measured by a predetermined charge-discharge protocol when the plurality of explanatory variables are input,
the evaluation prediction unit acquires the predicted evaluation result including the energy density and the power density being measured by the predetermined charge-discharge protocol by inputting the plurality of explanatory variables to the learned model, and computes prediction accuracy of the predicted evaluation result, and
the output unit outputs information including the predicted evaluation result and the prediction accuracy.

4. The evaluation result prediction device according to claim 3, wherein
the predetermined charge-discharge protocol successively includes
an energy density measurement step of measuring energy density by discharging a storage battery at a first temperature and a first current value, and
one or a plurality of power density measurement steps of adjusting the storage battery to a target charge rate by a charge or discharge process different in temperature, different in charging or discharging, different in current value, or different in two or more of these from the energy density measurement step, and measuring power density at the target charge rate by causing the maximum current value Iₘₐₓ to be output,
the single charge-discharge process includes
measuring energy density by discharging the storage battery at the first temperature and a second current value greater than the first current value, and
measuring power density at the target charge rate by causing the maximum current value Iₘₐₓ to be temporarily output when a charge rate reaches the target charge rate in a process of the discharging, and subsequently returning the current value to the second current value again, which are performed each time the one or the plurality of target charge rates are reached, thereby performing measurement of the energy density and the power density by a single discharge process,
the evaluation charge-discharge protocol includes first to n-th single charge-discharge processes (n is an integer of 2 or more) of performing measurement of energy density and power density by a single charge-discharge process at first to n-th different temperatures, respectively, and the first to n-th single charge-discharge processes are constituted in an order in which the prediction accuracy further increases or temperature adjustment ends in a shorter time,
the evaluation result prediction device is configured to acquire the predicted evaluation result, based on charge-discharge data of the first single charge-discharge process, and compute the prediction accuracy, and
the evaluation result prediction device further comprises a control unit, and the control unit controls the evaluation result prediction device in such a way that the evaluation result prediction device
(i) ends the evaluation charge-discharge protocol when the prediction accuracy is equal to or more than a predetermined threshold value, and
(ii) executes a next single charge-discharge process of the evaluation charge-discharge protocol when the prediction accuracy is less than the threshold value, acquires further charge-discharge data, and performs acquisition of the predicted evaluation result and computation of the prediction accuracy, based on accumulated charge-discharge data, which are repeated until the prediction accuracy is equal to or more than the threshold value or the n-th single charge-discharge process ends.

5. The evaluation result prediction device according to any one of claims 2 to 4, wherein
the evaluation charge-discharge protocol includes a plurality of evaluation charge-discharge protocols including performing measurement of the energy density and the power density by a single charge-discharge process for each fixed period shorter than the X or each fixed number of the charge-discharge cycles smaller than the Y during the life evaluation test,
the evaluation result prediction device is configured to acquire the predicted evaluation result, based on the test condition data and charge-discharge data of the single charge-discharge process, and compute the prediction accuracy, and
the evaluation result prediction device further comprises a control unit, and the control unit controls the evaluation result prediction device in such a way that the evaluation result prediction device
(i) ends the life evaluation test when the prediction accuracy is equal to or more than a predetermined threshold value, and
(ii) continues the life evaluation test and executes a next evaluation charge-discharge protocol when the prediction accuracy is less than the threshold value, acquires further charge-discharge data, and performs acquisition of the predicted evaluation result and computation of the prediction accuracy, based on the test condition data and accumulated charge-discharge data, which are repeated until the prediction accuracy is equal to or more than the threshold value.

6. The evaluation result prediction device according to any one of claims 1 to 4, wherein
the acquisition unit is configured to further acquire at least one piece of material analysis data selected from an X-ray diffraction (XRD) spectrum, a nuclear magnetic resonance (NMR) spectrum, an electron spin resonance (ESR) spectrum, a scanning electron microscope (SEM) image, or an ion chromatography (IC) spectrum of a material constituting the storage battery, and
the plurality of explanatory variables further include one or a plurality of material analysis parameters acquired by mathematically processing the material analysis data in addition to the test condition parameter and the electrochemical parameter.

7. The evaluation result prediction device according to any one of claims 1 to 4, wherein
the plurality of explanatory variables further include one or a plurality of mathematical parameters acquired by mathematically processing a shape of a discharge curve in the single charge-discharge process in addition to the test condition parameter and the electrochemical parameter, and
the plurality of explanatory variables are explanatory variables preselected by eliminating one or a plurality of parameters having multicollinearity with another parameter in such a way as to improve the prediction accuracy of the learned model or improve interpretability for the predicted evaluation result.

8. The evaluation result prediction device according to claim 7, wherein
the mathematical parameter is an explanatory variable preselected from among C coefficients in a matrix W by imposing a mathematical constraint, and then factorizing, into X ≈ W × H (in an equation, the matrix W is a coefficient matrix with 1 row and C columns, and a matrix H is a basis matrix with C rows and B columns), a matrix X with 1 row and B columns acquired by arranging, as elements, values of a voltage (V) corresponding to values of B (B ≥ 2) different charge rates (SOCs) in a column direction for discharge curve data in the single charge-discharge process.

9. The evaluation result prediction device according to any one of claims 1 to 4, wherein
the predicted evaluation result further includes predicted deterioration information on a storage battery when the end of life is reached.

10. The evaluation result prediction device according to any one of claims 1 to 4, wherein
the output unit is configured to output information including the predicted evaluation result and the prediction accuracy to a virtual environment accessible from a user terminal, and
the evaluation result prediction device is further configured to end the evaluation charge-discharge protocol when the evaluation result prediction device receives a command for ending the evaluation charge-discharge protocol from the virtual environment.

11. An evaluation result prediction system for predicting at least one evaluation result selected from a voltage retention rate after a test of a storage battery, a capacity maintenance rate after the test, time to reach the end of life, or a cycle number to reach the end of life being measured by a predetermined life evaluation test, the evaluation result prediction system comprising:
an acquisition device that acquires at least one piece of test condition data selected from a temperature, a current value, a voltage, or a charge-discharge pause time of the storage battery, and charge-discharge data on the storage battery based on an evaluation charge-discharge protocol including performing measurement of energy density and power density during the life evaluation test;
an explanatory variable extraction device that extracts a plurality of explanatory variables including one or a plurality of test condition parameters selected from the test condition data, and an electrochemical parameter that is computed from the charge-discharge data and includes the energy density and the power density;
a storage device that stores a learned model being learned in such a way as to output a predicted evaluation result including the evaluation result measured by the life evaluation test when the plurality of explanatory variables are input;
an evaluation prediction device that acquires the predicted evaluation result by inputting the plurality of explanatory variables to the learned model, and computes prediction accuracy of the predicted evaluation result; and
an output device that outputs information including the predicted evaluation result and the prediction accuracy.

12. The evaluation result prediction system according to claim 11, wherein
the predetermined life evaluation test includes
a deterioration step of storing a storage battery at a predetermined temperature for a fixed period (X), or repeating a fixed number (Y) of charge-discharge cycles at a predetermined temperature, and
an evaluation step including (i) measuring a voltage retention rate and/or a capacity maintenance rate of the storage battery after an end of the deterioration step, or (ii) measuring time to reach the end of life or a cycle number to reach the end of life until a voltage retention rate or a capacity maintenance rate of the storage battery falls below a preset reference value, or the storage battery reaches a preset upper limit temperature.

13. The evaluation result prediction system according to claim 12, wherein
the evaluation charge-discharge protocol includes performing measurement of the energy density and the power density by a single charge-discharge process,
the single charge-discharge process includes
measuring energy density by discharging the storage battery at the predetermined temperature and a predetermined current value, and
measuring power density at a target charge rate by causing a maximum current value Iₘₐₓ to be temporarily output when a charge rate reaches the target charge rate in a process of the discharging, and subsequently returning the current value to the predetermined current value again, which are performed each time the one or the plurality of target charge rates are reached, thereby performing measurement of the energy density and the power density by a single discharge process,
the learned model is further learned in such a way as to output a predicted evaluation result including energy density and power density being measured by a predetermined charge-discharge protocol when the plurality of explanatory variables are input,
the evaluation prediction device acquires the predicted evaluation result including the energy density and the power density being measured by the predetermined charge-discharge protocol by inputting the plurality of explanatory variables to the learned model, and computes prediction accuracy of the predicted evaluation result, and
the output device outputs information including the predicted evaluation result and the prediction accuracy.

14. An evaluation result prediction method for predicting at least one evaluation result selected from a voltage retention rate after a test of a storage battery, a capacity maintenance rate after the test, time to reach the end of life, or a cycle number to reach the end of life being measured by a predetermined life evaluation test, the evaluation result prediction method comprising:
acquiring at least one piece of test condition data selected from a temperature, a current value, a voltage, or a charge-discharge pause time of the storage battery, and charge-discharge data on the storage battery based on an evaluation charge-discharge protocol including performing measurement of energy density and power density during the life evaluation test;
extracting a plurality of explanatory variables including one or a plurality of test condition parameters selected from the test condition data, and an electrochemical parameter that is computed from the charge-discharge data and includes the energy density and the power density;
acquiring a predicted evaluation result including the evaluation result measured by the life evaluation test by inputting the plurality of explanatory variables to a learned model being learned in such a way as to output the predicted evaluation result when the plurality of explanatory variables are input;
computing prediction accuracy of the predicted evaluation result; and
then outputting information including the predicted evaluation result and the prediction accuracy.

15. The evaluation result prediction method according to claim 14, wherein
the predetermined life evaluation test includes
a deterioration step of storing a storage battery at a predetermined temperature for a fixed period (X), or repeating a fixed number (Y) of charge-discharge cycles at a predetermined temperature, and
an evaluation step including (i) measuring a voltage retention rate and/or a capacity maintenance rate of the storage battery after an end of the deterioration step, or (ii) measuring time to reach the end of life or a cycle number to reach the end of life until a voltage retention rate or a capacity maintenance rate of the storage battery falls below a preset reference value, or the storage battery reaches a preset upper limit temperature.

16. The evaluation result prediction method according to claim 15, wherein
the evaluation charge-discharge protocol includes performing measurement of the energy density and the power density by a single charge-discharge process,
the single charge-discharge process includes
measuring energy density by discharging the storage battery at the predetermined temperature and a predetermined current value, and
measuring power density at a target charge rate by causing a maximum current value Iₘₐₓ to be temporarily output when a charge rate reaches the target charge rate in a process of the discharging, and subsequently returning the current value to the predetermined current value again, which are performed each time the one or the plurality of target charge rates are reached, thereby performing measurement of the energy density and the power density by a single discharge process, and
the method further comprises,
by inputting the plurality of explanatory variables to the learned model being further learned in such a way as to output a predicted evaluation result including energy density and power density being measured by a predetermined charge-discharge protocol when the plurality of explanatory variables are input, acquiring the predicted evaluation result including the energy density and the power density being measured by the predetermined charge-discharge protocol, and computing prediction accuracy of the predicted evaluation result, and
then outputting information including the predicted evaluation result and the prediction accuracy.

17. An evaluation result prediction program that predicts at least one evaluation result selected from a voltage retention rate after a test of a storage battery, a capacity maintenance rate after the test, time to reach the end of life, or a cycle number to reach the end of life being measured by a predetermined life evaluation test, the evaluation result prediction program causing a computer to execute:
acquiring at least one piece of test condition data selected from a temperature, a current value, a voltage, or a charge-discharge pause time of the storage battery, and charge-discharge data on the storage battery based on an evaluation charge-discharge protocol including performing measurement of energy density and power density during the life evaluation test;
extracting a plurality of explanatory variables including one or a plurality of test condition parameters selected from the test condition data, and an electrochemical parameter that is computed from the charge-discharge data and includes the energy density and the power density;
acquiring a predicted evaluation result including the evaluation result measured by the life evaluation test by inputting the plurality of explanatory variables to a learned model being learned in such a way as to output the predicted evaluation result when the plurality of explanatory variables are input;
computing prediction accuracy of the predicted evaluation result; and
then outputting information including the predicted evaluation result and the prediction accuracy.

18. The evaluation result prediction program according to claim 17, wherein
the predetermined life evaluation test includes
a deterioration step of storing a storage battery at a predetermined temperature for a fixed period (X), or repeating a fixed number (Y) of charge-discharge cycles at a predetermined temperature, and
an evaluation step including (i) measuring a voltage retention rate and/or a capacity maintenance rate of the storage battery after an end of the deterioration step, or (ii) measuring time to reach the end of life or a cycle number to reach the end of life until a voltage retention rate or a capacity maintenance rate of the storage battery falls below a preset reference value, or the storage battery reaches a preset upper limit temperature.

19. The evaluation result prediction program according to claim 18, wherein
the evaluation charge-discharge protocol includes performing measurement of the energy density and the power density by a single charge-discharge process,
the single charge-discharge process includes
measuring energy density by discharging the storage battery at the predetermined temperature and a predetermined current value, and
measuring power density at a target charge rate by causing a maximum current value Iₘₐₓ to be temporarily output when a charge rate reaches the target charge rate in a process of the discharging, and subsequently returning the current value to the predetermined current value again, which are performed each time the one or the plurality of target charge rates are reached, thereby performing measurement of the energy density and the power density by a single discharge process, and
the evaluation result prediction program further causes a computer to execute,
by inputting the plurality of explanatory variables to the learned model being further learned in such a way as to output a predicted evaluation result including energy density and power density being measured by a predetermined charge-discharge protocol when the plurality of explanatory variables are input, acquiring the predicted evaluation result including the energy density and the power density being measured by the predetermined charge-discharge protocol, and computing prediction accuracy of the predicted evaluation result, and
then outputting information including the predicted evaluation result and the prediction accuracy.

20. A manipulable factor prediction method for predicting a manipulable factor that influences life of a storage battery, the method comprising:
a step of computing, from at least one piece of predicted deterioration information selected from a group consisting of a predicted charge-discharge characteristic, predicted electrochemical analysis data, and predicted material analysis data after deterioration of the storage battery, a plurality of degrees of deterioration representing an extent of deterioration and each corresponding to a life determination event being a reference for life determination of the storage battery, and a plurality of deterioration events directly or indirectly having a causal relationship with the life determination event;
a step of simplifying an association model in which a causal relationship among the life determination event, the plurality of deterioration events, and a plurality of manipulable factor candidates is associated in advance by eliminating the one or the plurality of deterioration events having the degree of deterioration lower than a threshold value from the association model, and, as a result, when there are the deterioration event and the manipulable factor candidate losing a causal relationship with the life determination event, also eliminating the deterioration event and the manipulable factor candidate; and
a step of outputting, as a manipulable factor that influences life of the storage battery, the one or the plurality of manipulable factor candidates directly or indirectly having a causal relationship with the life determination event in the simplified association model.

21. The manipulable factor prediction method according to claim 20, further comprising:
acquiring a degree of influence corresponding to each of one or more of the plurality of deterioration events by inputting a degree of deterioration of the life determination event and degrees of deterioration of the plurality of deterioration events to a learned model being learned in such a way as to output the degree of influence representing an improvement effect with respect to the degree of deterioration of the life determination event when one or more of the plurality of deterioration events are each improved in a case where the degree of deterioration of the life determination event and the degrees of deterioration of the plurality of deterioration events are input; and
then outputting, as a manipulable factor that influences life of the storage battery, the one or the plurality of manipulable factor candidates directly or indirectly having a causal relationship with the one or the plurality of deterioration events having the degree of influence equal to or more than a threshold value in the simplified association model.

22. The manipulable factor prediction method according to claim 21, further comprising:
associating the manipulable factor with an input and/or output of the learned model by using a theoretical calculation equation representing a relationship between the manipulable factor and degrees of deterioration and/or degrees of influence of the plurality of deterioration events in the simplified association model, then predicting a change in life of the storage battery when each output manipulable factor is changed by performing forward analysis and/or inverse analysis on the learned model from a specific manipulable factor, and outputting a prediction result; and
constructing a simulation model that simulates a change in life of the storage battery when each output manipulable factor is changed by using a theoretical calculation equation representing a relationship among the output manipulable factor, degrees of deterioration of the plurality of deterioration events, and a degree of deterioration of a life determination event and using the learned model in the simplified association model, then simulating a change in life of the storage battery when each output manipulable factor is changed by the simulation model, and outputting a simulation result.

23. The manipulable factor prediction method according to any one of claims 20 to 22, wherein
the predicted deterioration information includes a predicted charge-discharge characteristic, predicted electrochemical analysis data, and predicted material analysis data when the end of life of the storage battery is reached,
the predicted charge-discharge characteristic includes at least one selected from a group consisting of energy density, power density, a capacity, and charge-discharge efficiency of the storage battery when the end of life is reached,
the predicted electrochemical analysis data include at least one selected from a group consisting of charge curve analysis (CCA), discharge curve analysis, a galvanostatic intermittent titration technique (GITT), and electrochemical impedance spectroscopy (EIS) of the storage battery when the end of life is reached,
the predicted material analysis data include at least one selected from a group consisting of nuclear magnetic resonance (NMR) data, ion chromatography (IC) data, scanning electron microscope (SEM) observation data, X-ray diffraction (XRD) data, electron spin resonance (ESR) data, X-ray CT image data, and air permeability measurement data of a material constituting the storage battery when the end of life is reached, and
the manipulable factor candidate is at least one selected from a group consisting of density, a thickness, volume resistance, interface resistance, peel strength, porosity, and a basis weight of a negative electrode active material layer, a negative electrode active material type, a particle structure, a particle diameter, a specific surface area, a crystalline structure, crystallinity, the amount of impurities, and content of a negative electrode active material, negative electrode binder type and content, content of silicon oxide (SiOx),
density, a thickness, volume resistance, interface resistance, peel strength, porosity, and a basis weight of a positive electrode active material layer, a positive electrode active material type, a particle structure, a particle diameter, a specific surface area, a crystalline structure, crystallinity, the amount of impurities, and content of a positive electrode active material, positive electrode binder type and content, material type and content of a conductive auxiliary, electrolyte salt type and content in an electrolyte solution, solvent type and content in an electrolyte solution, additive type and content in an electrolyte solution, a thickness, a hole diameter, a porosity rate, tortuosity, and strength of a separator, a thickness of a coating layer of a separator, a filler type of a coating layer, particle diameter and content of a filler of a coating layer, binder type and content of a coating layer, and a coating position of a coating layer (single-sided coating on a positive electrode side, single-sided coating on a negative electrode side, or double-sided coating).

24. A manipulable factor prediction device that predicts a manipulable factor that influences life of a storage battery, the device comprising:
an acquisition unit that acquires at least one piece of predicted deterioration information selected from a group consisting of a predicted charge-discharge characteristic, predicted electrochemical analysis data, and predicted material analysis data after deterioration of the storage battery;
a deterioration degree computation unit that computes a plurality of degrees of deterioration representing an extent of deterioration and each corresponding to a life determination event being a reference for life determination of the storage battery, and a plurality of deterioration events directly or indirectly having a causal relationship with the life determination event;
a storage unit that stores an association model in which a causal relationship among the life determination event, the plurality of deterioration events, and a plurality of manipulable factor candidates is associated in advance;
a simplified association model generation unit that simplifies the association model by eliminating the one or the plurality of deterioration events having the degree of deterioration lower than a threshold value from the association model, and, as a result, when there are the deterioration event and the manipulable factor candidate losing a causal relationship with the life determination event, also eliminating the deterioration event and the manipulable factor candidate; and
an output unit that outputs, as a manipulable factor that influences life of the storage battery, the one or the plurality of manipulable factor candidates directly or indirectly having a causal relationship with the life determination event in the simplified association model.

25. A manipulable factor prediction system for predicting a manipulable factor that influences life of a storage battery, the system comprising:
an acquisition device that acquires at least one piece of predicted deterioration information selected from a group consisting of a predicted charge-discharge characteristic, predicted electrochemical analysis data, and predicted material analysis data after deterioration of the storage battery;
a deterioration degree computation device that computes a plurality of degrees of deterioration representing an extent of deterioration and each corresponding to a life determination event being a reference for life determination of the storage battery, and a plurality of deterioration events directly or indirectly having a causal relationship with the life determination event;
a storage device that stores an association model in which a causal relationship among the life determination event, the plurality of deterioration events, and a plurality of manipulable factor candidates is associated in advance;
a simplified association model generation device that simplifies the association model by eliminating the one or the plurality of deterioration events having the degree of deterioration lower than a threshold value from the association model, and, as a result, when there are the deterioration event and the manipulable factor candidate losing a causal relationship with the life determination event, also eliminating the deterioration event and the manipulable factor candidate; and
an output device that outputs, as a manipulable factor that influences life of the storage battery, the one or the plurality of manipulable factor candidates directly or indirectly having a causal relationship with the life determination event in the simplified association model.

26. A manipulable factor prediction program that predicts a manipulable factor that influences life of a storage battery, the program causing a computer to execute:
computing, from at least one piece of predicted deterioration information selected from a group consisting of a predicted charge-discharge characteristic, predicted electrochemical analysis data, and predicted material analysis data after deterioration of the storage battery, a plurality of degrees of deterioration representing an extent of deterioration and each corresponding to a life determination event being a reference for life determination of the storage battery, and a plurality of deterioration events directly or indirectly having a causal relationship with the life determination event;
simplifying an association model in which a causal relationship among the life determination event, the plurality of deterioration events, and a plurality of manipulable factor candidates is associated in advance by eliminating the one or the plurality of deterioration events having the degree of deterioration lower than a threshold value from the association model, and, as a result, when there are the deterioration event and the manipulable factor candidate losing a causal relationship with the life determination event, also eliminating the deterioration event and the manipulable factor candidate; and
outputting, as a manipulable factor that influences life of the storage battery, the one or the plurality of manipulable factor candidates directly or indirectly having a causal relationship with the life determination event in the simplified association model.
